(19) Europäisches Patentamt
European Patent Office
Office européen des brevets

(11) EP 3 859 808 B1

(12) **EUROPEAN PATENT SPECIFICATION**

(45) Date of publication and mention of the grant of the patent:
**24.12.2025 Bulletin 2025/52**

(21) Application number: **20154082.0**

(22) Date of filing: **28.01.2020**

(51) International Patent Classification (IPC):
***H10K 50/155*** *(2023.01)* ***H10K 50/17*** *(2023.01)*
***H10K 85/30*** *(2023.01)*

(52) Cooperative Patent Classification (CPC):
**H10K 85/30; H10K 50/155; H10K 50/17; H10K 85/371;** Y02E 10/549

(54) **AN ORGANIC ELECTRONIC DEVICE COMPRISING A HOLE INJECTION LAYER THAT COMPRISES A HOLE TRANSPORT COMPOUND**

ORGANISCHE ELEKTRONISCHE VORRICHTUNG MIT EINER LOCHINJEKTIONSSCHICHT, DIE EINE LOCHTRANSPORTVERBINDUNG UMFASST

DISPOSITIF ÉLECTRONIQUE ORGANIQUE COMPRENANT UNE COUCHE D’INJECTION DE TROUS INCLUANT UN COMPOSÉ DE TRANSPORT DE TROUS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.08.2021 Bulletin 2021/31**

(73) Proprietor: **Novaled GmbH**
**01099 Dresden (DE)**

(72) Inventors:
- **ROSENOW, Thomas**
  **01099 Dresden (DE)**
- **JANKUS, Vygintas**
  **01099 Dresden (DE)**
- **HUMMERT, Markus**
  **01099 Dresden (DE)**
- **PARK, Moo Jin**
  **01099 Dresden (DE)**
- **UVAROV, Vladimir**
  **01099 Dresden (DE)**
- **STEUDEL, Annette**
  **01099 Dresden (DE)**

(74) Representative: **Michalski Hüttermann & Partner Patentanwälte mbB**
**Kaistraße 16A**
**40221 Düsseldorf (DE)**

(56) References cited:
**WO-A1-2008/154914**
**WO-A1-2017/029370**
**WO-A1-2017/178473**
**DE-A1- 102006 054 524**
**DE-A1- 102008 051 737**
**US-A1- 2018 240 995**
**US-A1- 2019 006 589**
**US-A1- 2019 135 797**

- **CHAO CAI ET AL: "High-efficiency red, green and blue phosphorescent homojunction organic light-emitting diodes based on bipolar host materials", ORGANIC ELECTRONICS, vol. 12, no. 5, 1 May 2011 (2011-05-01), pages 843 - 850, XP055055146, ISSN: 1566-1199, DOI: 10.1016/j.orgel.2011.01.021**
- **"Introduction to Organic Electronic and Optoelectronic Materials and Devices", 1 January 2017, CRC PRESS, article MENG XIANLE ET AL: "Major Classes of Organic Small Molecules for Electronics and Optoelectronics", pages: 166 - 169, XP093205522**
- **YASUHIKO SHIROTA AND HIROSHI KAGEYAMA: "Charge Carrier Transporting Molecular Materials and Their Applications in Devices", CHEMICAL REVIEWS, AMERICAN CHEMICAL SOCIETY, US, vol. 107, no. 4, 1 April 2007 (2007-04-01), pages 953 - 1010, XP009141446, ISSN: 0009-2665, [retrieved on 20070411], DOI: 10.1021/CR050143+**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 859 808 B1

## Description

## Technical Field

The present invention relates to an organic electronic device containing an anode layer, a cathode layer and a hole injection layer, wherein the hole injection layer comprises a hole transport compound.

## Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

US 2018240995 A1 refers to a hole injection layer for an OLED comprising a triarylamine compound doped with a charge neutral metal amide compound, wherein the hole injection layer has a thickness of at least ≥ 20 nm to ≤ 1000 nm.

CHAO CAI ET AL: "High-efficiency red, green and blue phosphorescent homojunction organic light-emitting diodes based on bipolar host materials" ORGANIC ELECTRONICS, vol. 12, no. 5, 1 May 2011 (2011-05-01 ), pages 843-850, XP055055146, ISSN: 1566-1199.

WO 2017178473 A1 refers to an organic electronic component comprising a first (S1) and a second organic functional layer stack and a charge carrier generation layer arranged in between.

WO 2017/029370 A1 refers to metal amides and for their use as hole injection layer (HIL) for an Organic light-emitting diode (OLED), and a method of manufacturing Organic light-emitting diode (OLED) comprising an hole injection layer containing a metal amide.

YASUHIKO SHIROTA AND HIROSHI KAGEYAMA: "Charge Carrier Transporting Molecular Materials and Their Applications in Devices", CHEMICAL REVIEWS, AMERICAN CHEMICAL SOCIETY, US, vol. 107, no. 4, 1April2007 (2007-04-01), pages 953-1010, XP009141446, ISSN: 0009-2665, DOI: 10.1021 /CR050143+ [retrieved on 2007-04-11].

DE 10 2008 051737 A1 refers to square planar transition metal complex.

DE 10 2006 054524 A1 refers to the use of dithiolene transition metal complexes and selenium-analogous compounds as dopant for doping an organic semiconducting matrix material, as a charge injection layer, as an electrode material, as a matrix material itself or as a storage material in electronic or optoelectronic components.

WO 2008154914 A1 refers to the use of a dirhodium metal complex as a p-dopant for an organic semiconducting matrix material, an organic semiconductor material and an organic light-emitting diode.

Meng Xianle ET AL: "Major Classes of Organic Small Molecules for Electronics and Optoelectronics", In: "Introduction to Organic Electronic and Optoelectronic Materials and Devices", 1 January 2017 (2017-01-01 ), CRC Press, XP093205522, pages 166-169.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the hole injection layer, and among them, may be affected by characteristics of the hole transport compound and the metal complexes which are contained in the hole injection layer.

WO2017029370 relates to metal amides of general Formula Ia and for their use as hole injection layer (HIL) for an Organic light-emitting diode (OLED), and a method of manufacturing Organic light-emitting diode (OLED) comprising an hole injection layer containing a metal amide of general Formula Ia. In WO2017029370 is disclosed hole transport layer which may comprises in addition a triarylamine compound having the Formula VIIa:

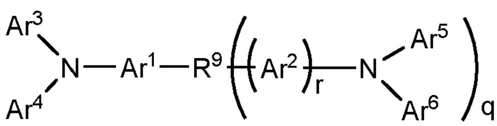
(VIIa).

WO2017029366 relates to a hole injection layer for an OLED comprising a triarylamine compound doped with a charge neutral metal amide compound, characterized in that the hole injection layer has a thickness of at least ≥ 20 nm to ≤ 1000 nm and the charge neutral metal amide compound has the Formula Ia. In WO2017029366 is disclosed a hole injection layer (HIL) comprises a triarylamine compound having the Formula VIIa:

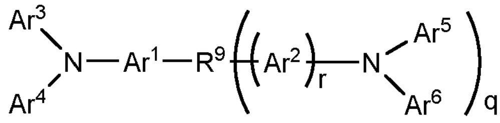
(VIIa).

WO2017102861 relates to an organic electronic component (10) comprising at least one organic layer (3), which has a fluorinated sulphonamide metal salt of the following formula 1: (1) wherein M is either a bivalent or higher-order metal having an atomic mass of greater than 26 g/mol or a monovalent metal having an atomic mass of greater than or equal to 39 g/mol, wherein $1 \leq n \leq 7$, and wherein R1, R2 are selected independently of each other and from a group comprising a fluoride-substituted aryl radical, a fluoride-substituted alkyl radical, and a fluoride-substituted aryl-alkyl radical. The matrix material is a hole-transport material.

There remains a need to improve performance of organic electronic devices by providing hole injection layers with improved performance, in particular to achieve improved operating voltage through improving the characteristics of the hole injection layer and the organic electronic device.

Further there remains a need to provide hole injection layers which enable injection into adjacent layers comprising compounds with a HOMO level further away from vacuum level.

It is a further objective to provide a hole injection layer comprising compounds which can be deposited through vacuum thermal evaporation under conditions suitable for mass production.

## DISCLOSURE

An aspect of the present invention provides an organic electronic device in accordance with claim 1 comprising an anode layer, a cathode layer and a hole injection layer, wherein the hole injection layer is arranged between the anode layer and the cathode layer and wherein the hole injection layer comprises a hole transport compound and a metal complex, wherein

- the hole transport compound has the formula (I):

$$(Ar^1)_k\text{-}(Ar^2)_m\text{-}Ar^3\text{-}(Ar^4)_p\text{-}(Ar^5)_q\text{-}(Ar^6)_r \qquad (I),$$

wherein

k, m, q, r are independently from each other 0, 1 or 2,
p is 1, 2 or 3,

wherein

$$2 \leq k+m+q+r+p \leq 11,$$

$Ar^1$ to $Ar^6$ are independently selected from a substituted or unsubstituted unsaturated 5- to 7-member ring of a heterocycle, a substituted or unsubstituted $C_6$ to $C_{30}$ aryl, a substituted or unsubstituted $C_3$ to $C_{30}$ heteroaryl, a substituted or unsubstituted fluorene, or a fused ring system comprising 2 to 6 substituted or unsubstituted 5-to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents are selected from the group H, D, $C_1$ to $C_{12}$ alkyl, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; and

- the metal complex has the formula (II):

$$M^{n\oplus} (L^{\ominus})_n \qquad (II),$$

wherein

M is a metal ion,
n is the valency of M,
L is a ligand comprising at least two carbon atoms,
n is an integer from 1 to 4;

wherein the hole injection layer is arranged in direct contact to the anode layer; and wherein the hole injection layer comprises a first sub-layer consisting of the metal complex of formula (II) and a second sub-layer consisting of the hole transport compound of formula (I), the first sub-layer being arranged directly adjacent to the anode layer and the second sub-layer being arranged directly adjacent to the first sub-layer;
wherein the organic electronic device further comprises a hole transport layer, wherein the hole transport layer is arranged between the hole injection layer and the at least one photoactive layer or at least one emission layer.

Further embodiments are claimed in the subclaims 2 to 20.
Examples 1 to 13 are not examples of the invention.
The term "HOMO level" is understood to mean the highest occupied molecular orbital and is determined in eV (electron volt).
The term "HOMO level further away from vacuum level" is understood to mean that the absolute value of the HOMO level is higher than the absolute value of the HOMO level of the reference compound. For example, the term "further away from vacuum level than the HOMO level of N4,N4‴-di(naphthalen-1-yl)-N4,N4‴-diphenyl-[1,1':4',1": 4",1‴-quaterphenyl]-4,4‴-diamine" is understood to mean that the absolute value of the HOMO level of the organic matrix compound (OMC) is higher than the HOMO level of N4,N4"'-di(naphthalen-1-yl)-N4,N4‴-diphenyl-[1,1':4',1":4",1‴-quaterphenyl]-4,4‴-diamine.
The term "absolute value" is understood to mean the value without the "-" symbol. According to one embodiment of the present invention, the HOMO level of the hole transport compound may be calculated by quantum mechanical methods.
If the HOMO level of the hole transport compound is calculated by this method, the HOMO level of the hole transport compound is less than the HOMO level of N4,N4‴-di(naphthalen-1-yl)-N4,N4‴-diphenyl-[1,1':4',1":4",1‴-quaterphenyl]-4,4‴-diamine.
If the HOMO level of the hole transport compound is calculated by this method, the absolute value of the HOMO level of the hole transport compound is higher than the absolute value of the HOMO level of N4,N4‴-di(naphthalen-1-yl)-N4,N4‴-diphenyl-[1,1 ':4',1":4",1‴-quaterphenyl]-4,4"'-diamine.
According to one embodiment of the present invention, the HOMO level of the hole transport compound is calculated with the program package TURBOMOLE V6.5, available from TURBOMOLE GmbH, Litzenhardtstrasse 19, 76135 Karlsruhe, Germany.
If calculated by this method, the HOMO level of N4,N4‴-di(naphthalen-1-yl)-N4,N4‴-diphenyl-[1,1':4',1":4",1‴-quaterphenyl]-4,4‴-diamine is -4.85 eV.
If the HOMO level is calculated by this method, hole transport compounds in the prior art have the following HOMO levels. For comparison, HOMO levels calculated from redox potential are also provided.

| Name | Structure | HOMO level based on redox potential (eV) disclosed in WO2017029370 | HOMO level calculated with TURBOMOLE V6.5 (eV) |
|---|---|---|---|
| N,N,N',N'-Tetrakis(4-methylphenyl)-benzidine (T-1) | 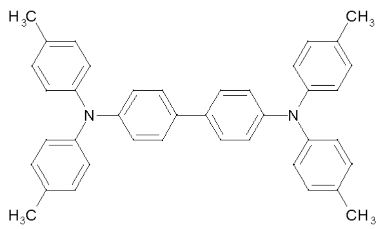 | -4.99 | - |

(continued)

| Name | Structure | HOMO level based on redox potential (eV) disclosed in WO2017029370 | HOMO level calculated with TURBOMOLE V6.5 (eV) |
|---|---|---|---|
| N4,N4,N4',N4'-tetra(biphenyl-4-yl)biphenyl-4,4'-diamine (T-2) | 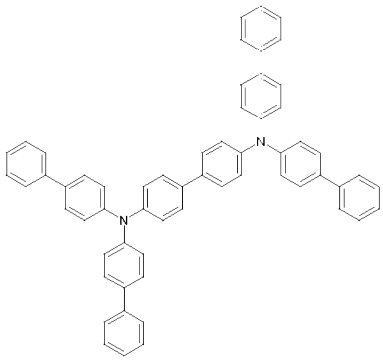 | -5.08 | -4.73 |
| Biphenyl-4-yl(9,9-diphenyl-9H-fluoren-2-yl)-[4-(9-phenyl-9H-carbazol-3-yl)phenyl]-amine (T-3) | 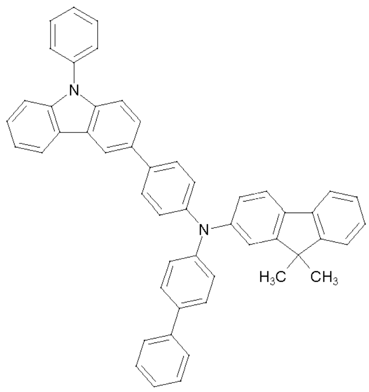 | -5.10 | -4.69 |
| N,N'-Bis(naphthalen-1-yl)-N,N'-bis(phenyl)-benzidine (T-4) | 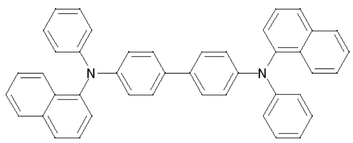 | -5.11 | -4.72 |
| N1,N3-di([1,1'-biphenyl]-4-yl)-5-(9,9-dimethyl-9H-fluoren-2-yl)-N1,N3-bis(3,5-dimethylphenyl)benzene -1,3-diamine (T-5) | 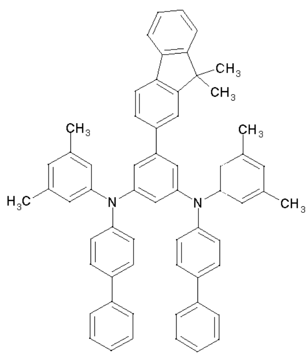 | -5.18 | -4.79 |

(continued)

| Name | Structure | HOMO level based on redox potential (eV) disclosed in WO2017029370 | HOMO level calculated with TURBOMOLE V6.5 (eV) |
|---|---|---|---|
| N1,N3-di([1,1'-biphenyl]-4-yl)-5-(9,9-dimethyl-9H-fluoren-2-yl)-N1,N3-dimesitylbenzene-1,3-diamine (T-6) | 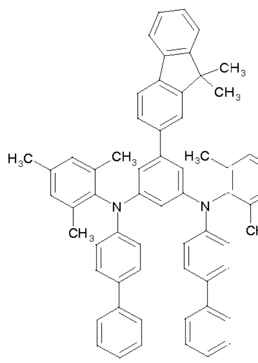 | -5.22 | -4.68 |
| N,N'-((9H-fluorene-9,9-diyl) bis(4,1-phenylene))bis(N-([1,1'-biphenyl]-4-yl)-[1,1'-biphenyl]-4-amine) (T-7) | 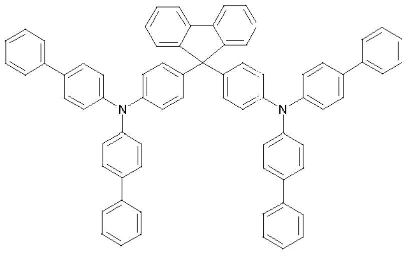 | -5.24 | -4.86 |
| N4,N4"-di(naphthalen-1-yl)-N4,N4"-diphenyl-[1,1':4',1"-terphenyl]-4,4"-diamine (CAS 139255-16-6) (T-8) | 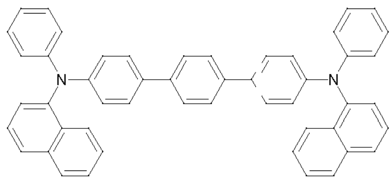 | -5.25 | -4.81 |
| 4,4'-Bis-(N-(1-naphthyl)-N-phenyl-amino)-quaterphenyl (CAS 650609-47-5) (T-9) | 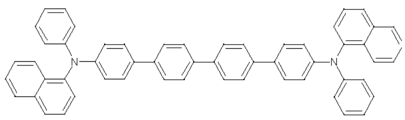 | -5.33 | -4.85 |
| 4,4',4"-Tris(carbazol-9-yl)-triphenylamine (T-10) | 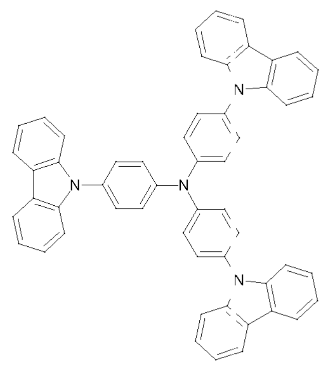 | -5.7 | -5.09 |

If the HOMO level is far away from vacuum level, accurate measurement of the redox potential may no longer be viable. Therefore, in the specification the HOMO level is determined by quantum mechanical methods, unless stated otherwise.

It should be noted that the ligand L have a negative charge. According to one embodiment the negative charge of the Ligand L may correspond to the valency of the metal ion M.

An aspect is an organic electronic device, which is not according to the invention, comprising an anode layer, a cathode layer and a hole injection layer, wherein the hole injection layer is arranged between the anode layer and the cathode layer and wherein the hole injection layer comprises a hole transport compound and a metal complex, wherein

- the hole transport compound has the formula (I):

$$(Ar^1)_k\text{-}(Ar^2)_m\text{-}Ar^3\text{-}(Ar^4)_p\text{-}(Ar^5)_q\text{-}(Ar^6)_r \qquad \text{(I)},$$

wherein

k, m, q, r are independently selected from each other 0, 1 or 2,
p is 1, 2 or 3,

wherein

$$2 \leq k+m+q+r+p \leq 11,$$

$Ar^1$ to $Ar^6$ are independently selected from a substituted or unsubstituted unsaturated 5- to 7-member ring of a heterocycle, a substituted or unsubstituted $C_6$ to $C_{30}$ aryl, a substituted or unsubstituted $C_3$ to $C_{30}$ heteroaryl, a substituted or unsubstituted fluorene, or a fused ring system comprising 2 to 6 substituted or unsubstituted 5-to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle; preferably independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings,
wherein the substituents are selected from the group H, D, $C_1$ to $C_{12}$ alkyl, unsubstituted $C_6$ to $C_{18}$ aryl,unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; and

- the metal complex has the formula (II):

$$M^{n\oplus} (L^{\ominus})_n \qquad \text{(II)},$$

wherein

M is a metal ion,
n is the valency of M,
L is a ligand comprising at least two carbon atoms,
n is an integer from 1 to 4; and
wherein the hole injection layer is arranged adjacent to the anode layer.

According to an embodiment not according to the invention the organic electronic device comprising an anode layer, a cathode layer and a hole injection layer, wherein the hole injection layer is arranged between the anode layer and the cathode layer and wherein the hole injection layer comprises a hole transport compound and a metal complex, wherein

- the hole transport compound has the formula (I):

$$(Ar^1)_k\text{-}(Ar^2)_m\text{-}Ar^3\text{-}(Ar^4)_p\text{-}(Ar^5)_q\text{-}(Ar^6)_r \qquad (I),$$

wherein

k, m, q, r are independently selected from each other 0, 1 or 2,
p is 1, 2 or 3,

wherein

$$2 \leq k+m+q+r+p \leq 11,$$

$Ar^1$ to $Ar^6$ may be independently selected from a substituted or unsubstituted unsaturated 5-to 7-member ring of a heterocycle, a substituted or unsubstituted $C_6$ to $C_{30}$ aryl, a substituted or unsubstituted $C_3$ to $C_{30}$ heteroaryl, a substituted or unsubstituted fluorene, or a fused ring system comprising 2 to 6 substituted or unsubstituted 5-to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents are selected from the group H, D, $C_1$ to $C_{12}$ alkyl, unsubstituted $C_6$ to $C_{18}$ aryl,unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; and

- the metal complex has the formula (II):

$$M^{n\oplus} (L^{\ominus})_n \qquad (II),$$

wherein

M is a metal ion,
n is the valency of M,
L is a ligand comprising at least two carbon atoms,
n is an integer from 1 to 4; and
wherein the hole injection layer is arranged adjacent to the anode layer.

According to another aspect, the hole transport compound according to formula (I) can be a covalent hole transport compound.
According to one embodiment, wherein n may be an integer from 1 to 4, preferably 1 to 3, also preferred 2 or 3.
It should be noted that k, m, q, r represents the number of substituents to the neighbor Ar moiety. For example, compound F7 according to formula (I):

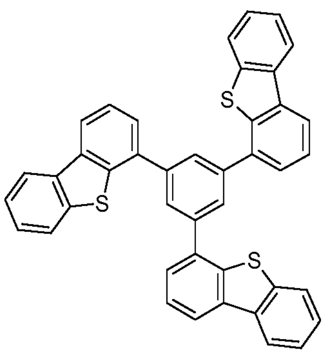
(F7),

is represented by $Ar^3$ = phenylene, k, m, q and r = 0 and p is 3, wherein

$Ar^4 =$ 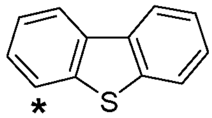 (D8).

According to one embodiment the hole injection layer is non-emissive.

According to one embodiment of the present invention the hole injection layer and/or the hole transport compound of formula (I) and/or the metal complex of formula (II) are non-emissive.

In the context of the present specification the term "essentially non-emissive" or "non-emissive" means that the contribution of the hole transport compound, metal complex and/or layer, such as hole injection layer, to the visible emission spectrum from an organic electronic device, such as OLED or display device, is less than 10 %, preferably less than 5 % relative to the visible emission spectrum. The visible emission spectrum is an emission spectrum with a wavelength of ≥ 380 nm to ≤ 780 nm.

It should be noted that throughout the application and the claims any $Ar^1$ to $Ar^6$ etc. always refer to the same moieties, unless otherwise noted.

In the present specification, when a definition is not otherwise provided, "substituted" refers to one substituted with a H, deuterium, $C_1$ to $C_{12}$ alkyl, unsubstituted $C_6$ to $C_{18}$ aryl, and unsubstituted $C_3$ to $C_{18}$ heteroaryl.

In the present specification, when a definition is not otherwise provided, an aryl group with at least 6 C-ring atoms can be substituted with 1, 2, 3, 4 or 5 substituents. For example a substituted $C_6$ aryl group may have 1, 2, 3, 4 or 5 phenyl substituents. Below is an example for a substituted $C_6$ aryl group with 4 phenyl groups:

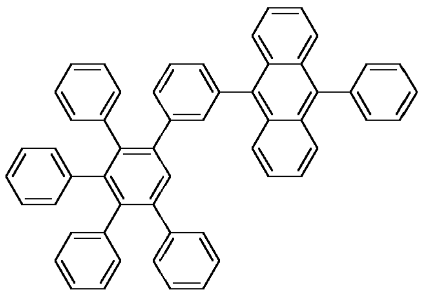

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a sec-butyl group, a tert-butyl group, a pentyl group, a branched pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methyl cyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

Comparative examples of the hole transport compounds, which can be covalent hole transport compounds, are organic compounds, consisting predominantly from covalently bound C, H, O, N, S, which may optionally comprise also covalently bound B, P or Si. In one embodiment, the hole transport compounds, which can be a covalent compound, is free of metal atoms and majority of its skeletal atoms may be selected from C, O, S, N. Alternatively, the covalent compound is free of metal atoms and majority of its skeletal atoms may be selected from C and N.

In the present specification, "aryl group" and "aromatic rings" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or

aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under "heteroaryl" and "heteroaromatic", it is especially where suitable understood a group derived by formal abstraction of one ring hydrogen from a heterocyclic aromatic ring in a compound comprising at least one such ring.

The term "non-heterocycle" is understood to mean a ring or ring-system comprising no hetero-atom as a ring member.

The term "heterocycle" is understood to mean that the heterocycle comprises at least one ring comprising one or more hetero-atoms. A heterocycle comprising more than one ring means that all rings comprising a hetero-atom or at least one ring comprising a hetero atom and at least one ring comprising C-atoms only and no hetero atom.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms.

The term "fused ring system" is understood to mean a ring system wherein two or more rings share at least two atoms.

The term"5-, 6- or 7-member ring" is understood to mean a ring comprising 5, 6 or 7 atoms. The atoms may be selected from C and one or more hetero-atoms.

In the present specification, the single bond refers to a direct bond.

In the context of the present invention, "different" means that the compounds do not have an identical chemical structure.

The term "free of", "does not contain", "does not comprise" does not exclude impurities which may be present in the hole transport compounds prior to deposition. Impurities have no technical effect with respect to the object achieved by the present invention.

The term "adjacent to" is understood to mean that distance between layers may be less than 2 nm or that the adjacent arranged layers contact each other. The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The terms cathode, cathode layer and cathode electrode are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

## Advantageous Effects

Surprisingly, it was found that the organic electronic device according to the invention solves the problem underlying the present invention by enabling organic electronic devices, such as organic light-emitting diodes, in various aspects superior over the organic electronic devices known in the art, in particular with respect to operating voltage.

Additionally, it was found that the problem underlying the present invention can be solved by providing compounds which may be suitable for deposition through vacuum thermal evaporation under conditions suitable for mass production. In particular, the rate onset temperature of the hole transport compound and the metal complex of the present invention may be in a range suitable for mass production.

According to one embodiment the HOMO level of the hole transport compound of formula (I) is further away from vacuum level than the HOMO level of N4,N4"'-di(naphthalen-1-yl)-N4,N4‴-diphenyl-[1,1':4',1":4",1‴-quaterphenyl]-4,4‴-diamine (-4.85 eV calculated by the method described in the present specification) when determined under the same

conditions.

Preferably the HOMO level of the hole transport compound of formula (I) is further away from vacuum level than the HOMO level of N,N'-((9H-fluorene-9,9-diyl)bis(4,1-phenylene))bis(N-([1,1'-biphenyl]-4-yl)-[1,1'-biphenyl]-4-amine) (-4.86 eV calculated by the method described in the present specification); alternatively the HOMO level of the hole transport compound of formula (I) is the same or further away from vacuum level than the HOMO level of 9-phenyl-10-(3',4',5'-triphenyl-[1,1':2',1"-terphenyl]-3-yl)anthracene (-5.04 eV calculated by the method described in the present specification); alternatively, the HOMO level of the hole transport compound of formula (I) is the same or further away from vacuum level than the HOMO level of tris(4-(9H-carbazol-9-yl)phenyl)amine(-5.09 eV calculated by the method described in the present specification).

According to one embodiment the HOMO level of the hole transport compound of formula (I) is further away from vacuum level than the HOMO level of N4,N4'''-di(naphthalen-1-yl)-N4,N4'''-diphenyl-[1,1':4',1":4",1'''-quaterphenyl]-4,4'''-diamine and the same or closer to vacuum level than 4,4',4"-(1,3,5-Benzenetriyl)tris[dibenzothiophene] when determined under the same conditions; preferably the HOMO level of the hole transport compound of formula (I) is further away from vacuum level than the HOMO level of N,N'-((9H-fluorene-9,9-diyl)bis(4,1-phenylene))bis(N-([1,1'-biphenyl]-4-yl)-[1,1'-biphenyl]-4-amine) and the same or closer to vacuum level than 4,4',4"-(1,3,5-Benzenetriyl)tris[dibenzothiophene]; alternatively the HOMO level of the hole transport compound of formula (I) is the same or further away from vacuum level than the HOMO level of 9-phenyl-10-(3',4',5'-triphenyl-[1,1':2',1"-terphenyl]-3-yl)anthracene and the same or closer to vacuum level than 4,4',4"-(1,3,5-Benzenetriyl)tris[dibenzothiophene]; alternatively, the HOMO level of the hole transport compound of formula (I) is further away from vacuum level than the HOMO level of tris(4-(9H-carbazol-9-yl)phenyl)amine and the same or closer to vacuum level than 4,4',4"-(1,3,5-Benzenetriyl)tris[dibenzothiophene] (-5.67 eV calculated by the method described in the present specification).

The term "HOMO level closer to vacuum level" is understood to mean that the absolute value of the HOMO level is lower than the absolute value of the HOMO level of the reference compound. For example, the term "closer to vacuum level than the HOMO level of 4,4',4"-(1,3,5-Benzenetriyl)tris[dibenzothiophene]" is understood to mean that the absolute value of the HOMO level of the organic matrix compound (OMC) is lower than the HOMO level of 4,4',4"-(1,3,5-Benzenetriyl)tris[dibenzothiophene].

According to one embodiment the HOMO level of the hole transport compound of formula (I) is further away from vacuum level than the HOMO level of N4,N4'''-di(naphthalen-1-y1)-N4,N4'''-diphenyl-[1,1':4',1":4"1'''-quaterphenyl]-4,4'''-diamine when determined under the same conditions; wherein the HOMO level of N4,N4'''-di(naphthalen-1-yl)-N4,N4'''-diphenyl-[1,1':4',1":4",1'''-quaterphenyl]-4,4'''-diamine is -4.85 eV; preferably the HOMO level of the hole transport compound of formula (I) is further away from vacuum level than the HOMO level of N,N'-((9H-fluorene-9,9-diyl)bis(4,1-phenylene))bis(N-([1,1'-biphenyl]-4-yl)-[1,1'-biphenyl]-4-amine) when determined under the same conditions; wherein the HOMO level of N,N'-((9H-fluorene-9,9-diyl)bis(4,1-phenylene))bis(N-([1,1'-biphenyl]-4-yl)-[1,1'-biphenyl]-4-amine) is - 4.86 eV; alternatively the HOMO level of the hole transport compound of formula (I) is the same or further away from vacuum level than the HOMO level of 9-phenyl-10-(3',4',5'-triphenyl-[1,1':2',1"-terphenyl]-3-yl)anthracene, wherein the HOMO level of 9-phenyl-10-(3',4',5'-triphenyl-[1,1':2',1"-terphenyl]-3-yl)anthracene is -5.04 eV; alternatively, the HOMO level of the hole transport compound of formula (I) is the same or further away from vacuum level than the HOMO level of tris(4-(9H-carbazol-9-yl)phenyl)amine , wherein the HOMO level of tris(4-(9H-carbazol-9-yl)phenyl)amine is -5.09 eV.

The hole transport compound that can be suitable used, for example as a matrix material in a hole injection layer of an organic electronic device, has the formula (I):

$$(Ar^1)_k(Ar^2)_m\text{-}Ar^3\text{-}(Ar^4)_p\text{-}(Ar^5)_q\text{-}(Ar^6)_r \qquad (I),$$

wherein

k, m, q, r are independently selected from each other 0, 1 or 2,
p is 1, 2 or 3,

wherein

$$2 \leq k+m+q+r+p \leq 11,$$

$Ar^1$ to $Ar^6$ may be independently selected from a substituted or unsubstituted unsaturated 5-to 7-member ring of a heterocycle, a substituted or unsubstituted $C_6$ to $C_{30}$ aryl, a substituted or unsubstituted $C_3$ to $C_{30}$ heteroaryl, a substituted or unsubstituted fluorene, or a fused ring system comprising 2 to 6 substituted or unsubstituted 5-to 7-member rings and the rings are selected from the group comprising (i) unsaturated 5-

to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents are selected from the group H, D, $C_1$ to $C_{12}$ alkyl, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment $Ar^1$ to $Ar^6$ may be independently selected from substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings,
wherein the substituents are selected from the group H, D, $C_1$ to $C_{12}$ alkyl, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle.

According to one embodiment the hole transport compound according of formula (I) may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to one embodiment, the HOMO level of the hole transport compound of formula (I) may be less than -4.85 eV, preferably less than -4.86 eV, preferably less than -4.9 eV, alternatively less than -4.95 eV, alternatively less than -5 eV, alternatively less than -5.05 eV, alternatively less than -5.09 eV.

According to one embodiment, the HOMO level of the hole transport compound of formula (I) may be less than -4.85 eV and more than -7 eV, preferably less than -4.86 eV and more than -7 eV, more preferred less than -4.9 eV and more than -7 eV, alternatively less than-4.95 eV and more than -7 eV, alternatively less than -5 eV and more than -7 eV, alternatively less than -5.05 eV and more than -7 eV, alternatively less than -5.09 eV and more than -7 eV.

According to one embodiment, the HOMO level of the hole transport compound of formula (I) may be less than -4.85 eV and more than -6.5 eV, preferably less than -4.86 eV and more than -6.5 eV, more preferred less than -4.9 eV and more than -6.5 eV, alternatively less than -4.95 eV and more than - 6.5 eV, alternatively less than -5 eV and more than -6.5 eV, alternatively less than -5.05 eV and more than -6.5 eV, alternatively less than -5.09 eV and more than -6.5 eV.

According to one embodiment, the HOMO level of the hole transport compound of formula (I) may be less than -4.85 eV and more than -6 eV, preferably less than -4.86 eV and more than -6.5 eV, more preferred less than -4.9 eV and more than -6 eV, alternatively less than-4.95 eV and more than -6 eV, alternatively less than -5 eV and more than -6 eV, alternatively less than -5.05 eV and more than -6 eV, alternatively less than -5.09 eV and more than -6 eV.

According to one embodiment the hole transport compound of formula (I) may comprises at least ≥ 1 to ≤ 6 substituted or unsubstituted aromatic fused ring systems comprising heteroaromatic rings.

According to one embodiment the hole transport compound of formula (I) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the hole transport compound of formula (I) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the hole transport compound of formula (I) may comprises at least ≥ 1 to ≤ 6

substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems.

According to one embodiment the hole transport compound of formula (I) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings.

According to one embodiment the hole transport compound of formula (I) may comprises at least ≥ 1 to ≤ 3 or 2 substituted or unsubstituted unsaturated 5- to 7-member ring of a heterocycle.

According to one embodiment the hole transport compound of formula (I) may comprises at least ≥ 1 to ≤ 3 or 2 substituted or unsubstituted unsaturated 7-member ring of a heterocycle.

According to one embodiment substituted or unsubstituted aromatic fused ring systems of the hole transport compound or the hole transport compound of formula (I) may comprises at least ≥ 1 to ≤ 3 or 2 substituted or unsubstituted unsaturated 5- to 7-member ring of a heterocycle.

According to one embodiment the substituted or unsubstituted aromatic fused ring systems of the hole transport compound or the hole transport compound of formula (I) may comprises at least ≥ 1 to ≤ 3 or 2 substituted or unsubstituted unsaturated 7-member ring of a heterocycle.

According to one embodiment the hole transport compound of formula (I) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises substituted or unsubstituted unsaturated 5- to 7-member ring of a heterocycle.

According to one embodiment the hole transport compound of formula (I) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises substituted or unsubstituted unsaturated 5- to 7-member ring of a heterocycle.

According to one embodiment the hole transport compound of formula (I) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, and wherein the aromatic fused ring system comprises at least ≥ 1 to ≤ 3 or 2 substituted or unsubstituted unsaturated 5- to 7-member ring of a heterocycle.

According to one embodiment the hole transport compound of formula (I) may comprises at least ≥ 1 to ≤ 6 substituted or unsubstituted aromatic fused ring systems, preferably ≥ 2 to ≤ 5 substituted or unsubstituted aromatic fused ring systems, and further preferred 3 or 4 substituted or unsubstituted aromatic fused ring systems, which comprises substituted or unsubstituted heteroaromatic rings, and wherein the aromatic fused ring system comprises at least ≥ 1 to ≤ 3 or 2 substituted or unsubstituted unsaturated 5- to 7-member ring of a heterocycle.

According to one embodiment the hole transport compound of formula (I) may comprises:

- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment the hole transport compound or the hole transport compound of formula (I) may comprises at least at least ≥ 1 to ≤ 6, preferably ≥ 2 to ≤ 5, or further preferred 3 or 4 of the substituted or unsubstituted aromatic fused ring systems with:

- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

According to one embodiment the hole transport compound or the hole transport compound of formula (I) may

comprises at least at least ≥ 1 to ≤ 6, preferably ≥ 2 to ≤ 5, or further preferred 3 or 4 of the substituted or unsubstituted aromatic fused ring systems with:

- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;

wherein the substituted or unsubstituted aromatic fused ring system comprises at least ≥ 1 to ≤ 3 or 2 substituted or unsubstituted unsaturated 5- to 7-member ring of a heterocycle.

According to one embodiment the hole transport compound of formula (I) may comprises

- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic $C_6$ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom

    at least ≥ 4 to ≤ 11, preferably ≥ 5 to ≤ 10, further preferred ≥ 6 to ≤ 9 or in addition preferred 7 or 8 are non-hetero aromatic rings, and
    at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or

- at least ≥ 6 to ≤ 12, preferably ≥ 7 to ≤ 11, further preferred ≥ 8 to ≤ 10 or 9 aromatic rings, wherein therefrom

    at least ≥ 4 to ≤ 11, preferably ≥ 5 to ≤ 10, further preferred ≥ 6 to ≤ 9 or in addition preferred 7 or 8 are non-hetero aromatic rings, and
    at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and

        the hole transport compound according to formula I comprises at least ≥ 1 to ≤ 4, preferably 2 or 3 aromatic 5-member-rings, preferably hetero aromatic 5-member-rings, and/or
        the hole transport compound according to formula (I) comprises at least 1 or 2 unsaturated 5- to 7-member-ring of a heterocycle, preferably at least 1 or 2 unsaturated 7-member-ring of a heterocycle.

According to one embodiment the the hole transport compound of formula (I) may comprises a hetero-atom, which may be selected from the group comprising O, S, N, B or P, preferably the hetero-atom may be selected from the group comprising O, S or N.

According to one embodiment the the hole transport compound of formula (I) may comprises at least at least ≥ 1 to ≤ 6, preferably ≥ 2 to ≤ 5, or further preferred 3 or 4 of the substituted or unsubstituted aromatic fused ring systems with:

- at least one aromatic 5-member ring, and/or
- at least one aromatic 6-member ring, and/or
- at least one aromatic 7-member ring; wherein preferably at least one aromatic 5- and/or at least one aromatic 7-member ring comprises at least 1 to 3, preferably 1 hetero-atom;

wherein the substituted or unsubstituted aromatic fused ring system optional comprises at least ≥ 1 to ≤ 3 or 2 substituted or unsubstituted unsaturated 5- to 7-member ring of a heterocycle; and wherein the substituted or unsubstituted aromatic fused ring system comprises a hetero-atom, which may be selected from the group comprising O, S, N, B, P or Si, preferably the hetero-atom may be selected from the group comprising O, S or N.

According to one embodiment the the hole transport compound of formula (I) may be free of hetero-atoms which are not part of an aromatic ring and/or part of an unsaturated 7-member-ring, preferably the the hole transport compound according to formula (I) may be free on N-atoms except N-atoms which are part of an aromatic ring or are part of an unsaturated 7-member-ring.

According to one embodiment, the hole transport compound comprises two carbazole groups, at least one dibenzofurane group, at least one dibenzothiophene group and/or at least one anthracene group.

According to one embodiment, the hole transport compound comprises two carbazole groups, one to three dibenzofurane groups, one to three dibenzothiophene groups and/or one to two anthracene groups.

According to one embodiment, wherein for the hole transport compound according to formula (I):

- $Ar^3$ may be selected from D1 to D17, preferably D1 to D6 and D16:

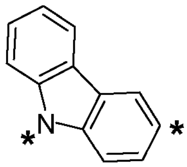 (D1), 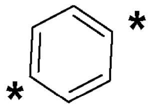 (D2), 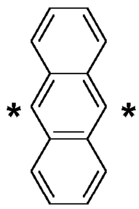 (D3), 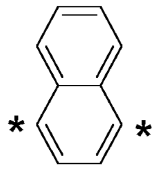 (D4), 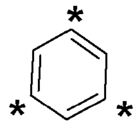 (D5), 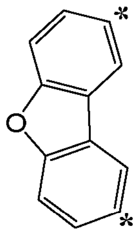 (D6);

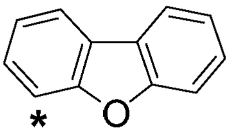 (D7), 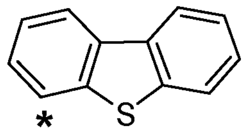 (D8), 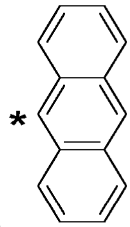 (D9), 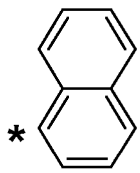 (D10);

- 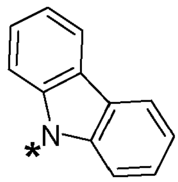 (D11), 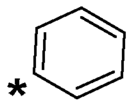 (D12), 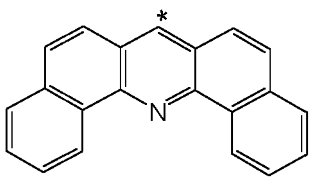 (D13), 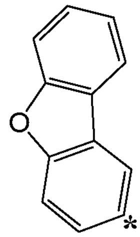 (D14)

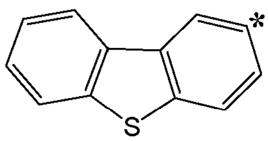 (D15), 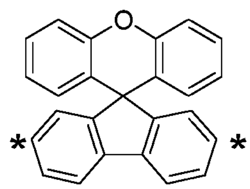 (D16), 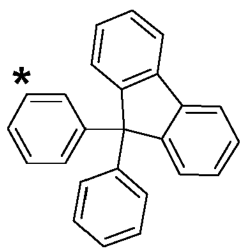 (D17).

According to one embodiment, wherein $Ar^1$ may be selected from D7 to D15 and D17. $Ar^2$ may selected from D1 to D6, or D7 to D15 and D17. $Ar^4$ may be selected from D1 to D6, or D7 to D15 and D17. $Ar^5$ may be selected from D1 to D6, or D7 to D15 and D17. $Ar^6$ may be selected from D7 to D15 and D17.

According to one embodiment, wherein for the hole transport compound according to formula (I):

- $Ar^3$ may be selected from D1 to D17, preferably D1 to D6 and D16:

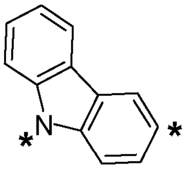 (D1), 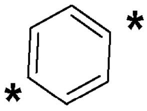 (D2), 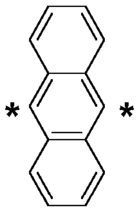 (D3), 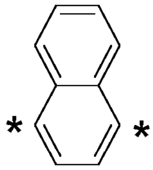 (D4), 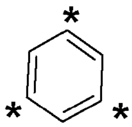 (D5), 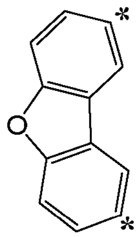 (D6);

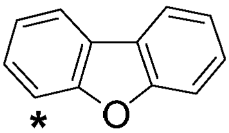 (D7), 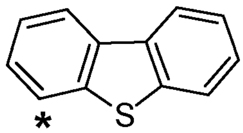 (D8), 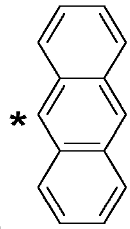 (D9), 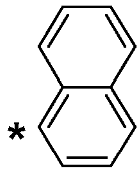 (D10);

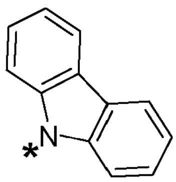 (D11), 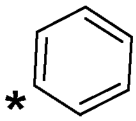 (D12), 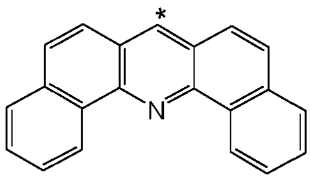 (D13), 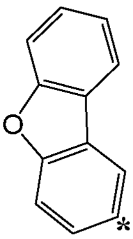 (D14)

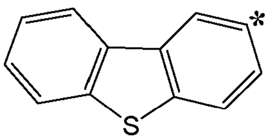 (D15), 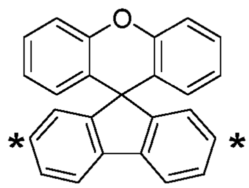 (D16), 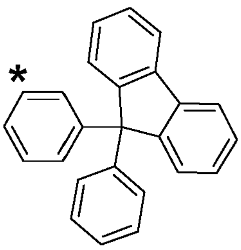 (D17);

$Ar^1$ is selected from D7 to D15 and D17, if m > 0 and k > 0, or is selected from D7 to D15 and D17, if k > 0 and m = 0, or is selected from D1 to D6, if k > 1;

$Ar^2$ is selected from D1 to D6, if m > 0 and k > 0; or is selected from D7 to D15 and D17, if m > 0 and k = 0;

$Ar^4$ is selected from D1 to D6, if q > 0, or is selected from D1 to D6, if q = 0 and r > 0; or is selected from D7 to D15 and D17, if q and r = 0;

$Ar^5$ is selected from D1 to D6, if q > 0 and r > 0, or is selected from D7 to D15 and D17, if q > 0 and r = 0;

$Ar^6$ is selected from D7 to D15 and D17, if r > 0, q > 0, or is selected from D7 to D15 and D17, if r > 0, q = 0, or is selected from D1 to D6, if r > 1.

According to one embodiment, wherein in Formula (I) the $Ar^3$ group is selected from anthracene, carbazole, dibenzothiophene and/or dibenzofurane.

According to one embodiment, wherein in Formula (I) the $Ar^3$ group is selected anthracene.

According to one embodiment, wherein in Formula (I) the $Ar^3$ group is selected from carbazole, dibenzothiophene and/or dibenzofurane.

According to one embodiment, wherein the hole transport compound according to formula (I) may be selected from F1 to F13:

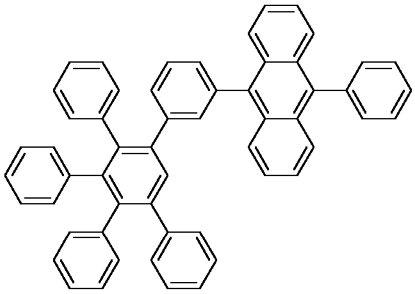 (F1), 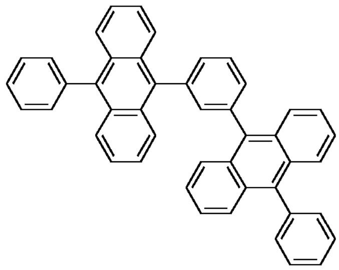 (F2),

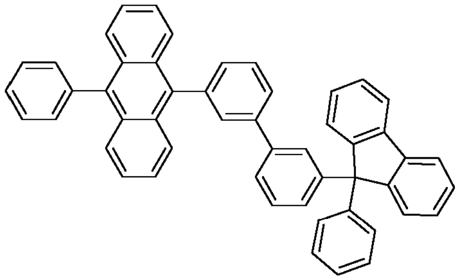 (F3), 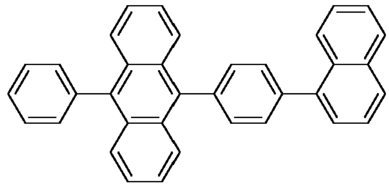 (F4),

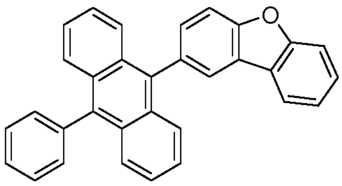 (F5), 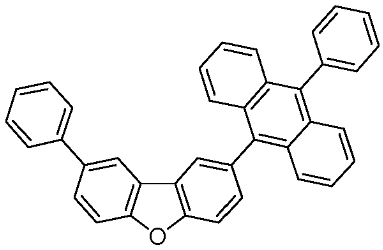 (F6),

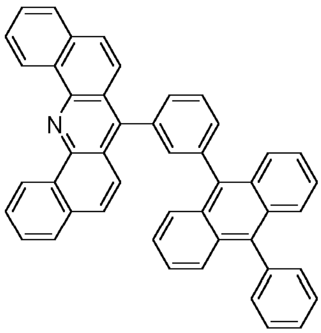 (F7), 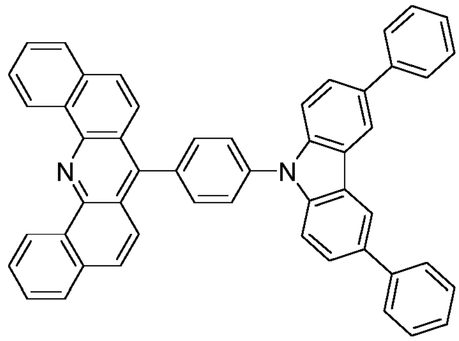 (F8),

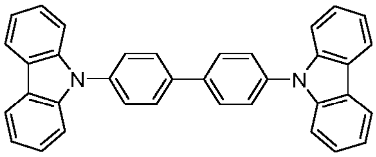 (F9), 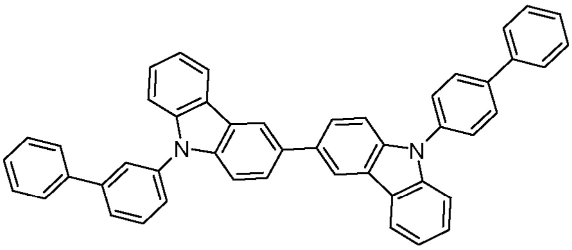 (F10),

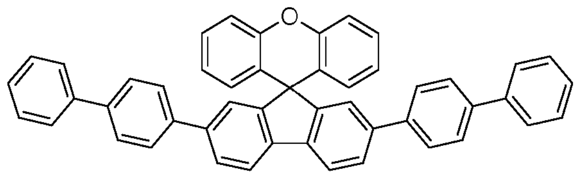

(F11),

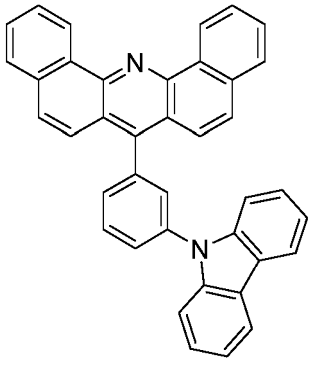

(F12),

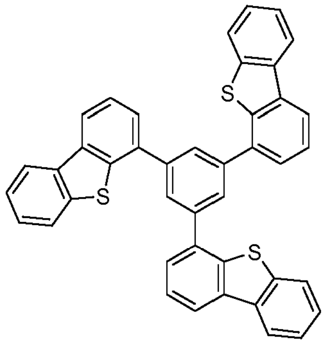

(F13).

Preferably, the hole transport compound is free of metals and/or ionic bonds.

The hole injection layer and/or hole transport compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The hole injection layer and/or hole transport compound may be free of N,N'-Bis(naphthalen-1-yl)-N,N'-bis(phenyl)-9,9-dimethyl-fluorene, N,N'-Bis(3-methylphenyl)-N,N'-bis(phenyl)-9,9-dimethyl-fluorene, N,N'-Bis(naphthalen-1-yl)-N,N'-bis(phenyl)-9,9-dimethyl-fluorene, N,N'-Bis(naphthalen-1-yl)-N,N'-bis(phenyl)-2,2-dimethylbenzidine, N,N'-Bis(3-methylphenyl)-N,N'-bis(phenyl)-9,9-spirobifluorene, 2,2',7,7'-Tetrakis(N,N-diphenylamino)-9,9'-spirobifluorene, N,N'-Bis(naphthalen-1-yl)-N,N'-bis(phenyl)-benzidine, N,N'-Bis(naphthalen-2-yl)-N,N'-bis(phenyl)-benzidine, N,N'-Bis(3-methylphenyl)-N,N'-bis(phenyl)-benzidine, N,N'-Bis(3-methylphenyl)-N,N'-bis(phenyl)-9,9-dimethyl-fluorene, N,N'-Bis(naphthalen-1-yl)-N,N'-bis(phenyl)-9,9-spirobifluorene, Di-[4-(N,N-ditolyl-amino)-phenyl]cyclohexane, 2,2',7,7'-tetra(N,N-di-tolyl)amino-spiro-bifluorene, 9,9-Bis[4-(N,N-bis-biphenyl-4-yl-amino)phenyl]-9H-fluorene, 2,2',7,7'-Tetrakis(N,N-naphthalenyl(phenyl)-amino]-9,9'-spirobifluorene, 2,7-Bis(N,N-bis(9,9-spiro-bifluorene-2-yl)-amino]-9,9'-spirobifluorene, 2,2'-Bis(N,N-bis(biphenyl-4-yl)amino]-9,9'-spirobifluorene, N,N'-bis(phenanthren-9-yl)-N,N'-bis(phenyl)-benzidine, N,N,N',N'-tetra-naphthalen-2-yl)-benzidine, 2,2'-Bis(N,N-di-phenyl-amino)-9,9-spirobifluorene, 9,9-Bis[4-(N,N-bis-naphthalen-2-yl-amino)phenyl]-9H-fluorene, 9,9-Bis[4-(N,N'-bis-naphthalen-2-yl-N,N'-bis-phenyl-amino)-phenyl]-9H-fluorene, Titanium oxide phthalocyanine, Copper phthalocyanine, 2,3,5,6 Tetrafluoro 7,7,8,8, tetracyano-quinodimethane, 4,4'4''-Tris(N-3-methylphenyl-N-phenyl-amino)triphenylamine, 4,4',4''-Tris(N-(2-naphthyl)-N-phenyl-amino)triphenylamine, 4,4',4''-Tris(N-(1-naphthyl)-N-phenyl-amino)triphenylamine, 4,4',4''-Tris(N,N-diphenyl-amino)triphenylamine, Pyrazino[2,3-f][1,10]phenanthroline-2,3-dicarbonitrile, N,N,N',N'-Tetrakis(4-methoxyphenyl)benzidine, HTM014, HTM081, HTM163, HTM222, EL-301, HTM226, HTM355, HTM133, HTM334, HTM604 and EL-22T. The abbreviations denote the manufacturers' names, for example, of Merck or Lumtec.

Metal complex of formula (II)

The metal complex according to formula (II) is non-emissive. In the context of the present specification the term "essentially non-emissive" or "non-emissive" means that the contribution of the metal complex according to formula (II) to the visible emission spectrum from an organic electronic device, such as OLED or display device, is less than 10 %, preferably less than 5 % relative to the visible emission spectrum. The visible emission spectrum is an emission spectrum with a wavelength of ≥ 380 nm to ≤ 780 nm.

According to one embodiment the metal ion M of formula (II) may be selected from a metal ion wherein the corresponding metal has an electronegativity value according to Allen of less than 2.4, preferably M may be selected from an alkali, alkaline earth, rare earth or transition metal, further preferred M may be selected from a metal with an atomic mass ≥ 24 Da, in addition preferred M may be selected from a metal with an atomic mass ≥ 24 Da and M has an oxidation number ≥ 2.

The term "electronegativity value according to Allen" especially refers to Allen, Leland C. (1989). "Electronegativity is the average one-electron energy of the valence-shell electrons in ground-state free atoms". Journal of the American Chemical Society 111 (25): 9003-9014.

According to one embodiment of the present invention, the valency n of M is 1 or 2.

According to one embodiment of the present invention, M is selected from a metal ion wherein the corresponding metal has an electronegativity value according to Allen of less than 2.4, preferably less than 2, more preferred less than 1.9, and the valency n of M is 1 or 2.

According to one embodiment of the present invention, M is selected from an alkali, alkaline earth, rare earth or transition metal, alternatively M is selected from alkali, alkaline earth, transition or a period 4 or 5 main group metal.

According to one embodiment of the present invention, M is selected from Li, Na, K, Cs, Mg, Mn, Cu, Zn, Ag, Bi and Mo; preferably M is selected from Na, K, Cs, Mg, Mn, Cu, Zn and Ag; also preferred M is selected from Na, K, Mg, Mn, Cu, Zn and Ag, wherein if M is Cu, n is 2.

According to one embodiment of the present invention, M is not Li.

According to one embodiment of the present invention, M is not Ag.

According to one embodiment of the present invention, M is not Cu.

According to another embodiment the metal complex according to formula (II) may have a has a molecular weight Mw of $\geq$ 287 and $\leq$ 2000 g/mol, preferably a molecular weight Mw of $\geq$ 400 and $\leq$ 1500 g/mol, further preferred a molecular weight Mw of $\geq$ 580 and $\leq$ 1500 g/mol, in addition preferred a molecular weight Mw of $\geq$ 580 and $\leq$ 1400 g/mol.

According to another embodiment the ligand L of formula (II), also named L, may be selected from a group comprising:

- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted $C_1$ to $C_6$ alkyl, substituted or unsubstituted $C_1$ to $C_6$ alkoxy, alternatively two or more groups selected from halogen, F, CN, substituted or unsubstituted $C_1$ to $C_6$ alkyl, substituted or unsubstituted $C_1$ to $C_6$ alkoxy, at least one or more groups selected from halogen, F, CN, substituted $C_1$ to $C_6$ alkyl, substituted $C_1$ to $C_6$ alkoxy, alternatively two or more groups selected from halogen, F, CN, perfluorinated $C_1$ to $C_6$ alkyl, perfluorinated $C_1$ to $C_6$ alkoxy, one or more groups selected from substituted or unsubstituted $C_1$ to $C_6$ alkyl, substituted or unsubstituted $C_6$ to $C_{12}$ aryl, and/or substituted or unsubstituted $C_3$ to $C_{12}$ heteroaryl,

  wherein the substituents are selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^6$, $COOR^6$, halogen, F or CN;

  wherein $R^6$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

According to another embodiment the ligand L of formula (II) may be selected from a group comprising at least two carbon atoms, alternatively at least three carbon atoms, at least one oxygen atom, at least two oxygen atoms, at least one oxygen and/or nitrogen atom, one nitrogen atom and at least two oxygen atoms, at least two carbon atoms and at least one oxygen atom, at least two carbon atoms and two oxygen atoms or one oxygen and one nitrogen atom, at least one or more groups selected from halogen, F, CN, substituted or unsubstituted $C_1$ to $C_6$ alkyl, substituted or unsubstituted $C_1$ to $C_6$ alkoxy, alternatively two or more groups selected from halogen, F, CN, substituted or unsubstituted $C_1$ to $C_6$ alkyl, substituted or unsubstituted $C_1$ to $C_6$ alkoxy, at least one or more groups selected from halogen, F, CN, substituted $C_1$ to $C_6$ alkyl, substituted $C_1$ to $C_6$ alkoxy, alternatively two or more groups selected from halogen, F, CN, perfluorinated $C_1$ to $C_6$ alkyl, perfluorinated $C_1$ to $C_6$ alkoxy, one or more groups selected from substituted or unsubstituted $C_1$ to $C_6$ alkyl, substituted or unsubstituted $C_6$ to $C_{12}$ aryl, and/or substituted or unsubstituted $C_3$ to $C_{12}$ heteroaryl,

wherein the substituents are selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^6$, $COOR^6$, halogen, F or CN;

wherein $R^6$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

According to another embodiment the ligand L of formula (II) may be selected from a group comprising F, CN, perfluorinated $C_1$ to $C_6$ alkyl, substituted or unsubstituted $C_1$ to $C_6$ alkyl, substituted or unsubstituted $C_1$ to $C_6$ alkoxy.

The substituents may be selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$

alkoxy, $COR^6$, $COOR^6$, halogen, F or CN,
wherein $R^6$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

According to another embodiment the, wherein the ligand L of formula (II) may be independently selected from G1 to G62:

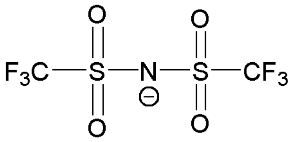 , 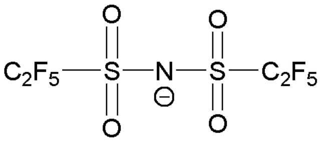 , 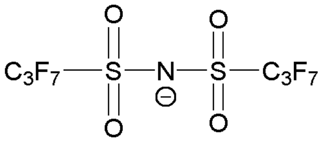 ,

(G1) (G2) (G3)

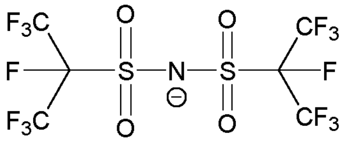 , 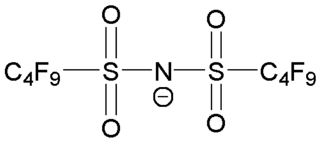 , 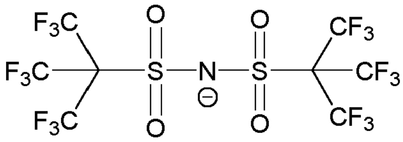 ,

(G4) (G5) (G6)

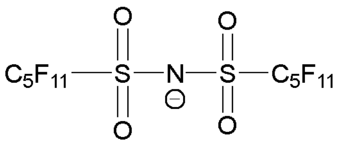 , 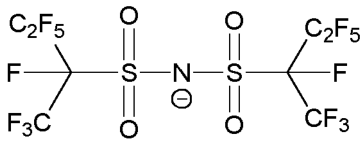 , 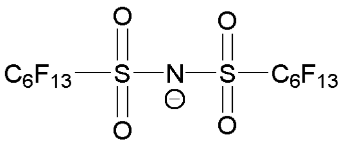 ,

(G7) (G8) (G9)

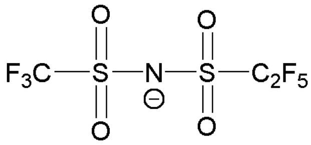 , 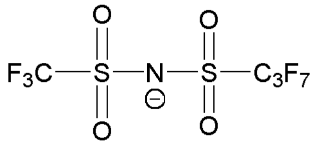 , 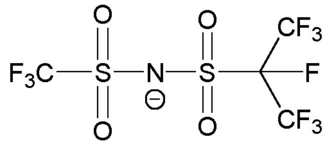 ,

(G10) (G11) (G12)

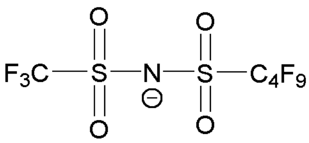 , 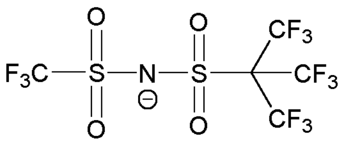 , 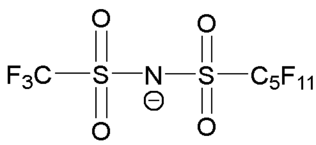 ,

(G13) (G14) (G15)

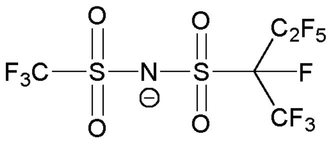 , 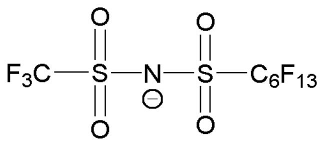 ,

(G16) (G17)

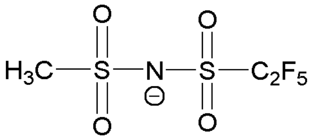,
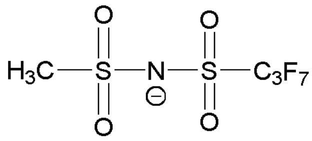,
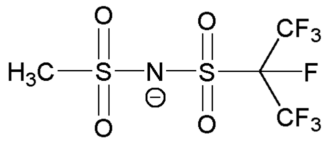,

(G18) (G19) (G20)

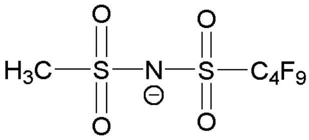,
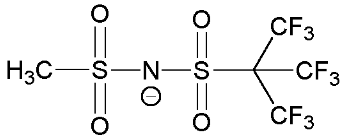,
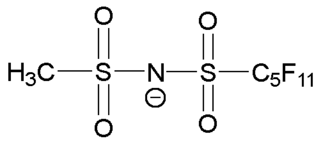,

(G21) (G22) (G23)

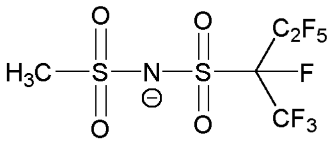,
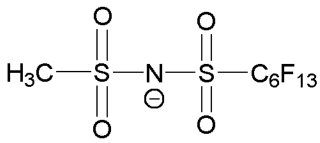,

(G24) (G25)

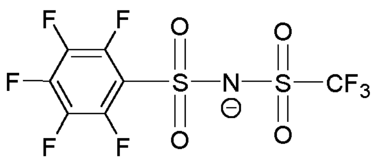,
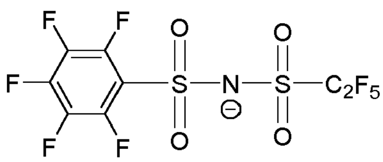,

(G26) (G27)

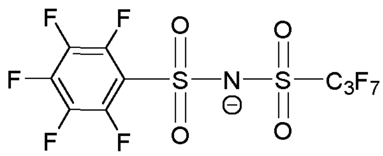,

(G28)

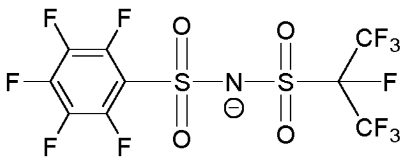,
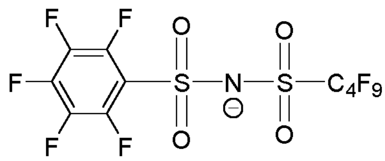,

(G29) (G30)

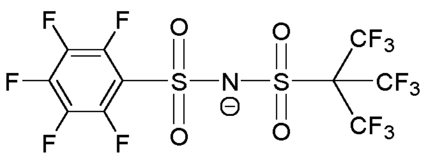,
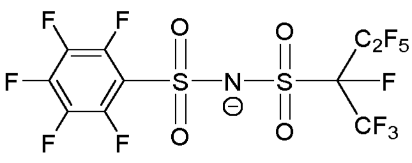,

(G31) (G32)

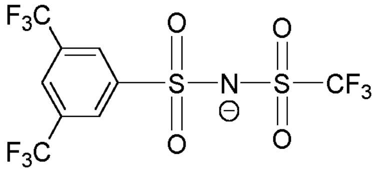,
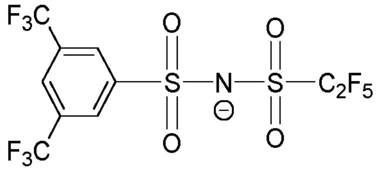,
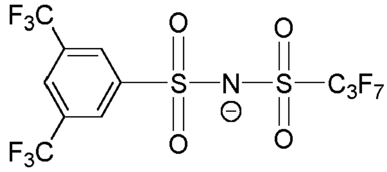,

(G33) (G34) (G35)

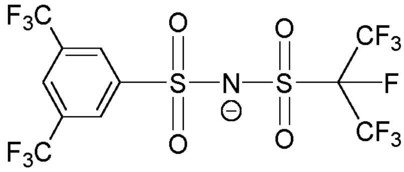,
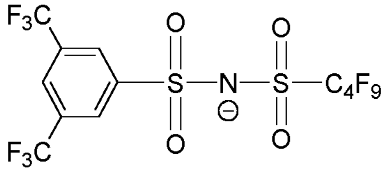,

(G36) (G37)

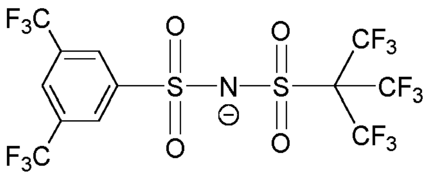,

(G38)

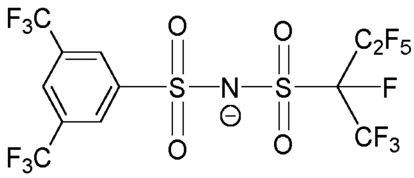,
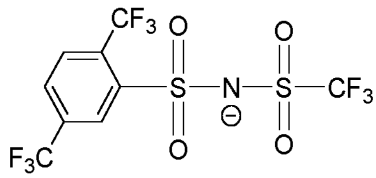,

(G39) (G40)

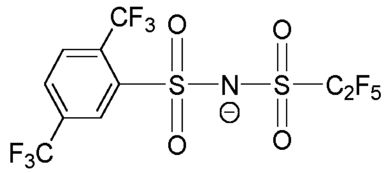,

(G41)

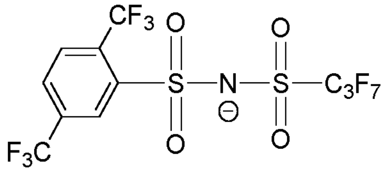,
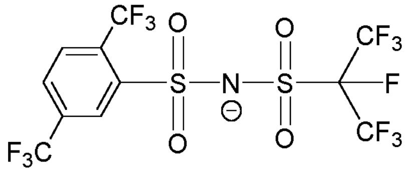,

(G42) (G43)

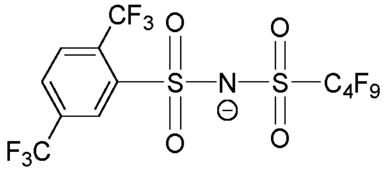
,
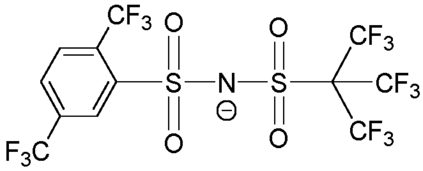

(G44) (G45)

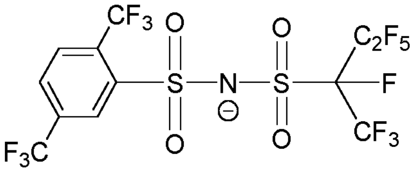
,
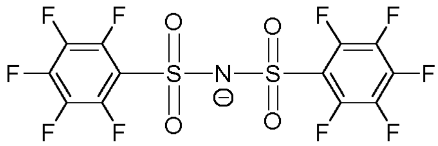

(G46) (G47)

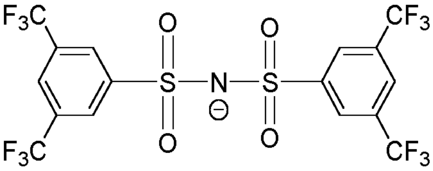
,
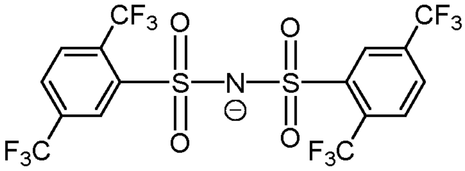

(G48) (G49)

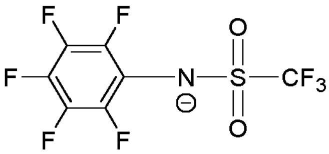
,
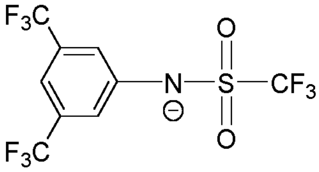
,
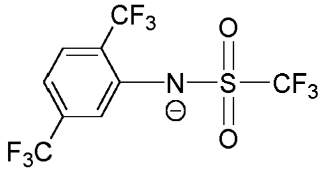
,

(G50) (G51) (G52)

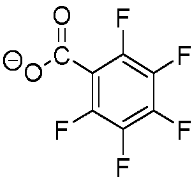
,
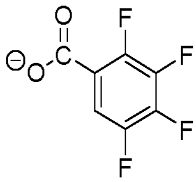
,
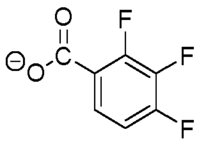
,
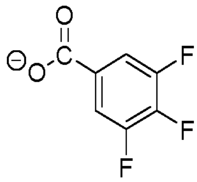
,

(G53) (G54) (G55) (G56)

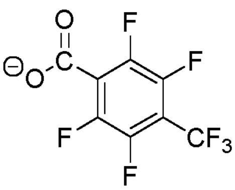

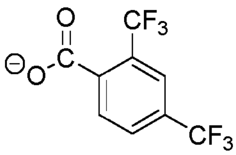
,
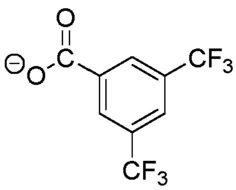
,

(G57) (G58) (G59)

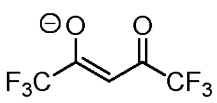, 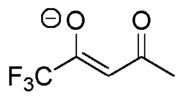, 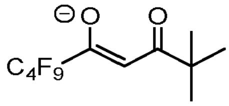

(G60) (G61) (G62).

Preferably, L is selected from (G2) to (G59), alternatively L is selected from (G2) to (G52).

The negative charge in metal complexes of formula (II) may be delocalised partially or fully over the ligand L.

Metal complex of formulas (IIa) to (IId)

According to one embodiment the metal complex may be selected from the following formulas (IIa) to (IId):

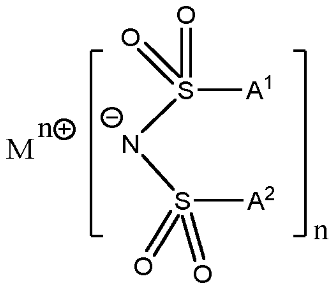 (IIa), 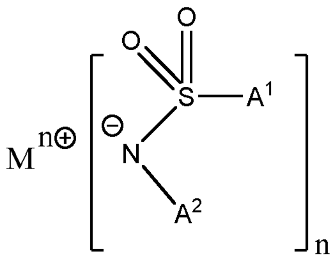 (IIb),

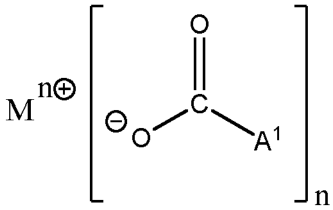 (IIc), 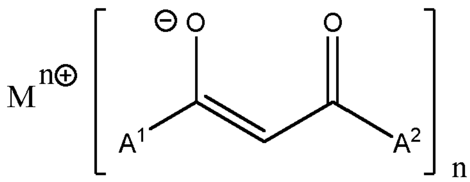 (IId),

wherein

| | |
|---|---|
| M | is a metal ion; |
| n | is the valency of M; |
| $A^1$ and $A^2$ | may be independently selected from substituted or unsubstituted $C_1$ to $C_{12}$ alkyl, substituted or unsubstituted $C_6$ to $C_{12}$ aryl, substituted or unsubstituted $C_3$ to $C_{12}$ heteroaryl; |

wherein

the substituents of $A^1$and $A^2$ may be independently selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^1$, $COOR^1$, halogen, F or CN, wherein

$R^1$ may be selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

The negative charge in metal complexes of formula (IIa), (IIb), (IIc) and/or (IId) may be delocalised partially or fully over the carbon and hetero atoms and $A^1$ and/or $A^2$.

According to one embodiment wherein at least one of $A^1$ and $A^2$ may comprise a substituent, wherein at least one of the substituents of $A^1$ and $A^2$ may be independently selected from $C_3$ to $C_9$ heteroaryl, $C_1$ to $C_6$ alkoxy, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkoxy, $COR^1$, $COOR^1$, halogen, F or CN; preferably at least one of $A^1$ and $A^2$ comprises at least two substituents, wherein

the substituents on $A^1$ and $A^2$ may be independently selected from $C_3$ to $C_9$ heteroaryl, $C_1$ to $C_6$ alkoxy, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkoxy, $COR^1$, $COOR^1$, halogen, F or CN; and further preferred $A^1$ and $A^2$ may comprise at least

one substituent independently selected from halogen, F, $CF_3$, $C_2F_5$, $C_3F_7$, $C_4F_9$, $OCF_3$, $OC_2F_5$, or CN; and in addition preferred $A^1$and $A^2$ may comprise at least two substituents independently selected from halogen, F, $CF_3$, $C_2F_5$, $C_3F_7$, $C_4F_9$, $OCF_3$, $OC_2F_5$ or CN.

According to one embodiment of the present invention, $A^1$ and $A^2$ may be independently selected from $CF_3$, $C_2F_5$, $C_3F_7$, $C_4F_9$, $C_5F_{11}$, $C_6F_{13}$ and/or phenyl substituted with two to five groups independently selected from F or $CF_3$, alternatively $C_2F_5$, $C_3F_7$, $C_4F_9$, $C_5F_{11}$, $C_6F_{13}$ and/or phenyl substituted with two to five groups independently selected from F or $CF_3$, alternatively $CF_3$, $C_2F_5$, $C_3F_7$, $C_4F_9$, $C_5F_{11}$, $C_6F_{13}$ or phenyl substituted with zero to two $CF_3$ groups and/or zero to five F atoms.

According to one embodiment of the present invention, the metal complex may be selected from

- Formula (IIa), wherein M is selected from an alkali, alkaline earth, transition or rare earth metal; and/or
- Formula (IIb), wherein M is selected from alkali, alkaline earth, transition or rare earth metal; and/or
- Formula (IIc), wherein M is selected from alkali, alkaline earth or main group metal.

According to one embodiment of the present invention, the metal complex may be selected from Formula (IIa) or (IIb),
wherein M is selected from a metal ion wherein the corresponding metal has an electronegativity value according to Allen of less than 2.4, preferably M is selected from an alkali, alkaline earth, rare earth or transition metal, further preferred M is selected from a metal with an atomic mass ≥ 24 Da, in addition preferred M is selected from a metal with an atomic mass ≥ 24 Da and M has an oxidation number ≥ 2; and/or Formula(IIc), wherein M is selected from Bi.

Metal complexes of the following formulas may be particularly preferred:

Li TFSI
K TFSI
Cs TFSI
Ag TFSI
Mg $(TFSI)_2$
Mn $(TFSI)_2$
Sc $(TFSI)_3$
Mg $[N(SO_2{}^iC_3F_7)_2]_2$
Zn $[N(SO_2{}^iC_3F_7)_2]_2$
Ag $[N(SO_2{}^iC_3F_7)_2]$
Ag $[N(SO_2C_3F_7)_2]$
Ag $[N(SO_2C_4F_9)_2]$
Ag $[N(SO_2CF_3)(SO_2C_4F_9)]$
Cu $[N(SO_2{}^iC_3F_7)_2]_2$
Cu $[N(SO_2C_3F_7)_2]_2$
Cu $[N(SO_2CF_3)(SO_2C_4F_9)]_2$
Mg $[N(SO_2CF_3)(SO_2CaF_9)]_2$
Mn $[N(SO_2CF_3)(SO_2C_4F_9)]_2$
Cu $[N(SO_2CH_3) (SO_2C_4F_9)]_2$
Ag $[N(SO_2CH_3) (SO_2C_4F_9)]$

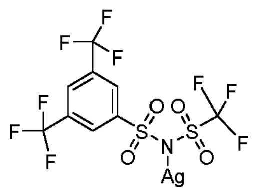

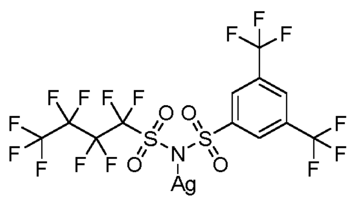

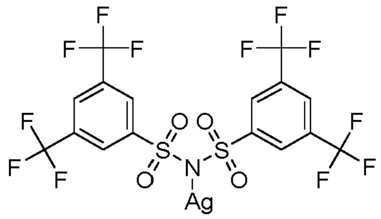

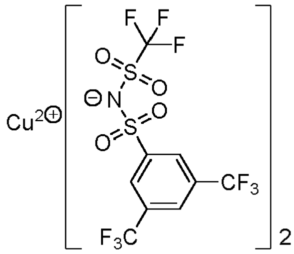

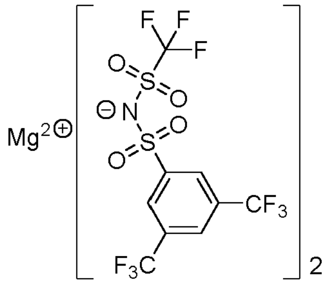

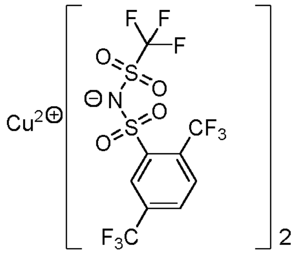

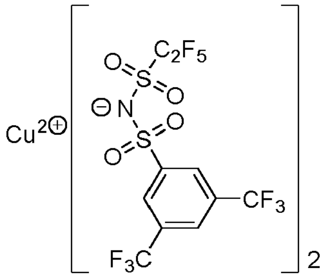

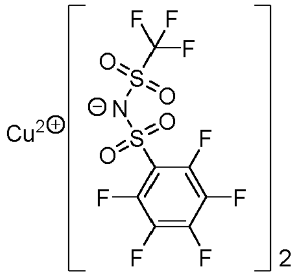

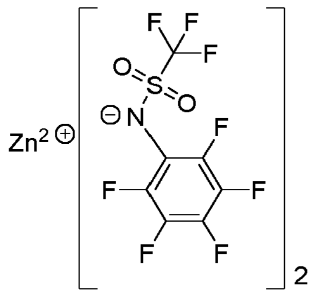

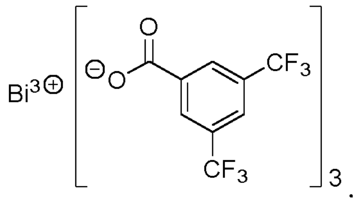

Hole injection layer

According to another embodiment the hole injection layer may comprises a hole transport compound and a metal complex:

- wherein the hole transport compound has the formula (I):

$$(Ar^1)_k\text{-}(Ar^2)_m\text{-}Ar^3\text{-}(Ar^4)_p\text{-}(Ar^5)_q\text{-}(Ar^6)_r \quad (I),$$

wherein

k, m, q, r are independently selected from each other 0, 1 or 2,
p is 1, 2 or 3,
wherein

$$2 \leq k+m+q+r+p \leq 11,$$

$Ar^1$ to $Ar^6$ may be independently selected from substituted or unsubstituted unsaturated 5- to 7- member ring of a heterocycle, substituted or unsubstituted $C_6$ to $C_{30}$ aryl, substituted or unsubstituted $C_3$ to $C_{30}$ heteroaryl, a substituted or unsubstituted fluorene, or a fused ring system comprising 2 to 6 substituted or unsubstituted 5-to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
$Ar^2$ if k=1, $Ar^3$, $Ar^4$ if q = 1, $Ar^5$ if r = 1:
may be independently selected from substituted or unsubstituted unsaturated 5- to 7- member ring of a heterocycle, substituted or unsubstituted $C_6$ to $C_{30}$ arylene, substituted or unsubstituted $C_3$ to $C_{30}$ heteroarylene, substituted or unsubstituted biphenylene, substituted or unsubstituted fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted or unsubstituted azepine, substituted or unsubstituted dibenzo[b,f]azepine, 9,9'-spirobi[fluorene], substituted or unsubstituted spiro[fluorene-9,9'-xanthene], substituted or unsubstituted 9,14-dihydrodibenzo[2,3:6,7]azepino[4,5-b]indole, or a substituted or unsubstituted aromatic fused ring system comprising at least three, preferably three to six, substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings;
$Ar^2$ if k=0, $Ar^3$ if m=0 and k=0, $Ar^4$ if q and r = 0, $Ar^5$ if r = 0:
may be independently selected from substituted or unsubstituted unsaturated 5- to 7- member ring of a

heterocycle, substituted or unsubstituted $C_6$ to $C_{30}$ aryl, substituted or unsubstituted $C_3$ to $C_{30}$ heteroaryl, substituted or unsubstituted biphenyl, substituted or unsubstituted fluorenyl, substituted or unsubstituted naphthalenyl, substituted or unsubstituted anthracenyl, substituted or unsubstituted phenanthrenyl, substituted or unsubstituted pyrenyl, substituted or unsubstituted perylenyl, substituted or unsubstituted triphenylenyl, substituted or unsubstituted tetracenyl, substituted or unsubstituted tetraphenyl, substituted or unsubstituted dibenzofuranyl, substituted or unsubstituted dibenzothiophenyl, substituted or unsubstituted xanthenyl, substituted or unsubstituted carbazole, substituted or unsubstituted azepine, substituted or unsubstituted dibenzo [b,f]azepine, 9,9'-spirobi[fluorenyl], substituted or unsubstituted spiro[fluorenyl-9,9'-xanthene], substituted or unsubstituted 9,14-dihydrodibenzo[2,3:6,7]azepino[4,5-b]indole, or a substituted or unsubstituted aromatic fused ring system comprising at least three preferably three to six, substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings;
wherein the substituents are selected from the group H, D, $C_1$ to $C_{12}$ alkyl, unsubstituted $C_6$ to $C_{18}$ aryl, or unsubstituted $C_3$ to $C_{18}$ heteroaryl;

- wherein the metal complex has the formula (II):

$$M^{n\oplus} (L^{\ominus})_n \qquad (II),$$

wherein

M is a metal ion,
n is the valency of M,
L is a ligand comprising at least two carbon atoms,

n is an integer from 1 to 4.

Preferably, the hole injection layer is free of ionic liquids, metal phthalocyanine, CuPc, HAT-CN, Pyrazino[2,3-f][1,10]phenanthroline-2,3-dicarbonitrile, $F_4$TCNQ, metal fluoride and/or metal oxides, wherein the metal in the metal oxide is selected from Re and/or Mo. Thereby, the hole injection layer can be deposited under conditions suitable for mass production.

Organic electronic device

The organic electronic device is defined in the appended claims.
In the context of the present specification the term "consisting essentially of " especially means and/or includes a concentration of ≥ 90% (vol/vol) more preferred ≥ 95% (vol/vol) and most preferred ≥ 99% (vol/vol).
According to one embodiment of the present invention, wherein the organic electronic device comprises the hole injection layer that comprises a first sub-layer consisting of the metal complex of formula (II) and a second sub-layer consisting of the hole transport compound according to formula (I), wherein the first sub-layer is arranged closer to the anode layer and the second sub-layer is arranged closer to the cathode layer, wherein in formula (II) M is selected from Li, Na, K, Cs, Mg, Mn, Cu, Zn, Ag, Bi and Mo, alternatively Mg, Mn, Cu, Zn, Ag, Bi and Mo, alternatively Cu, Zn, Ag or Bi.
According to another embodiment, wherein the organic electronic device can be a light emitting device, a thin film transistor, a battery, a display device or a photovoltaic cell, and preferably a light emitting device and/or a display device.
The hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions m0ay vary according to the hole transport compound that is used to form the HIL, and the desired structure and thermal properties of the HIL. In general, however, conditions for vacuum deposition may include a deposition temperature of 100° C to 350° C, a pressure of $10^{-8}$ to $10^{-3}$ Torr (1 Torr equals 133.322 Pa), and a deposition rate of 0.1 to 10 nm/sec.
When the HIL is formed using spin coating or printing, coating conditions may vary according to the hole transport compound that is used to form the HIL, and the desired structure and thermal properties of the HIL. For example, the coating conditions may include a coating speed of 2000 rpm to 5000 rpm, and a thermal treatment temperature of 80° C to 200° C. Thermal treatment removes a solvent after the coating is performed.
The thickness of the HIL may be in the range from 1 nm to 15 nm, and for example, from 2 nm to 12 nm, alternatively 3 nm to 10 nm.
When the thickness of the HIL is within this range, the HIL may have excellent hole injecting characteristics,

without a substantial penalty in driving voltage.

According to one non-inventive embodiment of the present invention, the hole injection layer may comprise:

- at least ≥ 5 wt.-% to ≤ 90 wt.-%, preferably ≥ 30 wt.-% to ≤ 80 wt.-%, and more preferred ≥ 40 wt.-% to ≤ 80 wt.-%, also preferred ≥ 50 wt.-% to ≤ 80 wt.-% of a hole transport compound or a hole transport compound of formula (I), and
- at least ≥ 10 wt.-% to ≤ 95 wt.-%, preferably ≥ 20 wt.-% to ≤ 70 wt.-%, and more preferred ≥ 20 wt.-% to ≤ 60 wt.-%, also preferred ≥ 20 wt.-% to ≤ 50 wt.-% of a metal complex of formula (II), (IIa) to (IId); preferably the wt.-% of the metal complex of formula (II), (IIa) to (IId) is lower than the wt.-% of the hole transport compound or hole transport compound according to formula (I); wherein the weight-% of the components are based on the total weight of the hole injection layer.

According to one non-inventive embodiment of the present invention, the hole injection layer may comprise:

- at least ≥ 5 vol.-% to ≤ 90 vol.-%, preferably ≥ 30 vol.-% to ≤ 80 vol.-%, and more preferred ≥ 40 vol.-% to ≤ 80 vol.-%, also preferred ≥ 50 vol.-% to ≤ 80 vol.-% of a hole transport compound or a hole transport compound of formula (I), and
- at least ≥ 10 vol.-% to ≤ 95 vol.-%, preferably ≥ 20 vol.-% to ≤ 70 vol.-%, and more preferred ≥ 20 vol.-% to ≤ 60 vol.-%, also preferred ≥ 20 vol.-% to ≤ 50 vol.-% of a metal complex of formula (II), (IIa) to (IId); preferably the vol.-% of the metal complex of formula (II), (IIa) to (IId) is lower than the vol.-% of the hole transport compound or hole transport compound according to formula (I); wherein the weight-% of the components are based on the total weight of the hole injection layer.

## Further layers

In accordance with the invention, the organic electronic device may comprise, besides the layers already mentioned above, further layers. Exemplary embodiments of respective layers are described in the following:

## Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

## Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

## Hole transport layer

According to one embodiment, the organic electronic device further comprises a hole transport layer, wherein the hole transport layer is arranged between the hole injection layer and the at least one photoactive layer or at least one emission layer.

According to one non-inventive embodiment, wherein the organic electronic device may comprises a hole transport layer, wherein the hole transport layer comprises the hole transport compound according to claim 1 or the hole transport compound of formula (I), preferably the hole transport compound according to the hole transport compound of formula (I) in the hole injection layer and in the hole transport layer may be selected the same.

According to another non-inventive embodiment, wherein the organic electronic device may comprises a hole transport layer, wherein the hole transport layer may comprises the hole transport compound or the hole transport compound of formula (I); wherein the hole transport compound or the hole transport compound of formula (I) in the hole injection layer and hole transport layer are selected the same.

According to one non-inventive embodiment, wherein the hole transport layer may comprises the hole transport compound or the hole transport compound of formula (I); wherein the hole transport compound or the hole transport

compound of formula (I) in the hole injection layer and hole transport layer are selected the same and the hole transport compound or the hole transport compound of formula (I) may be free of hetero-atoms which are not part of an aromatic ring and/or part of an unsaturated 7-member-ring, preferably the hole transport compound or the hole transport compound according to formula (I) may be free on N-atoms except N-atoms which are part of an aromatic ring or are part of an unsaturated 7-member-ring.

According to one non-inventive embodiment, wherein the hole transport layer may comprises the hole transport compound or the hole transport compound of formula (I); wherein the hole transport compound or the hole transport compound of formula (I) in the hole injection layer and hole transport layer are selected the same and the hole transport compound comprises two carbazole groups, at least one dibenzofurane group, at least one dibenzothiophene group and/or at least one anthracene group.

According to one non-inventive embodiment, wherein the hole transport layer may comprises the hole transport compound or the hole transport compound of formula (I); wherein the hole transport compound or the hole transport compound of formula (I) in the hole injection layer and hole transport layer are selected the same and the hole transport compound comprises two carbazole groups, one to three dibenzofurane groups, one to three dibenzothiophene groups and/or one to two anthracene groups.

According to one non-inventive embodiment, wherein the hole transport layer may comprises the hole transport compound or the hole transport compound of formula (I); wherein the hole transport compound or the hole transport compound of formula (I) in the hole injection layer and hole transport layer are selected the same and wherein for the hole transport compound according to formula (I):

- $Ar^3$ may be selected from D1 to D15, preferably D1 to D6:

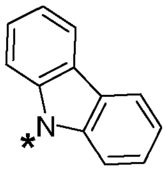 (D1), 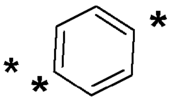 (D2), 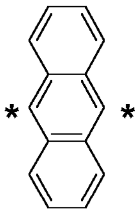 (D3), 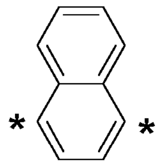 (D4), 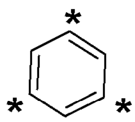 (D5), 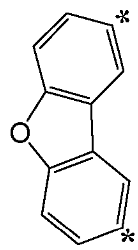 (D6);

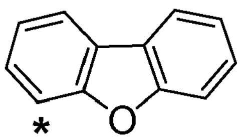 (D7), 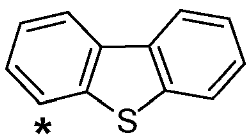 (D8), 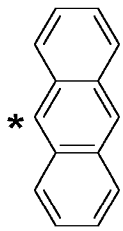 (D9), 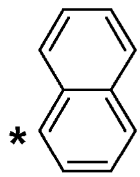 (D10);

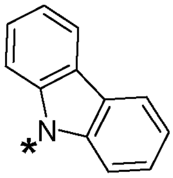 (D11), 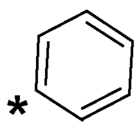 (D12), 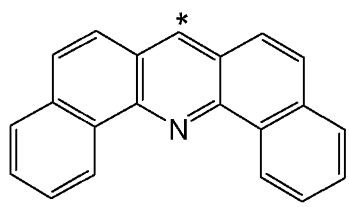 (D13), 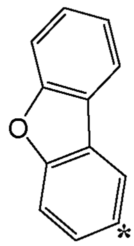 (D14)

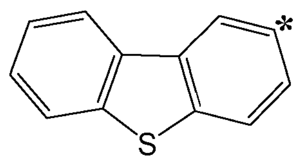 (D15).

According to one embodiment, wherein $Ar^1$ may be selected from D7 to D13. $Ar^2$ may selected from D1 to D6, or D7 to D13. $Ar^4$ may be selected from D1 to D6, or D7 to D13. $Ar^5$ may be selected from D1 to D6, or D7 to D13. $Ar^6$ may be selected from D7 to D13.

According to one non-inventive embodiment, wherein the hole transport layer may comprises the hole transport compound or the hole transport compound of formula (I); wherein the hole transport compound or the hole transport compound of formula (I) in the hole injection layer and hole transport layer are selected the same and wherein for the hole transport compound according to formula (I):

$Ar^3$ may be selected from D1 to D15, preferably D1 to D6:

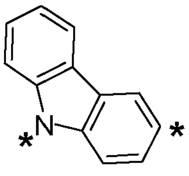
(D1),
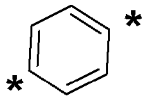
(D2),
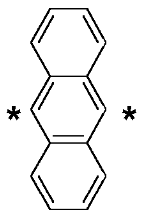
(D3),
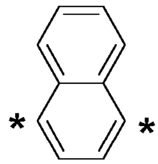
(D4),
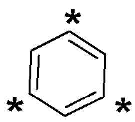
(D5),
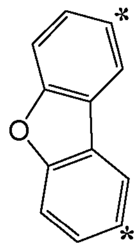
(D6);

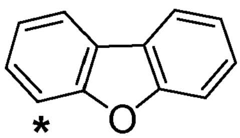
(D7),
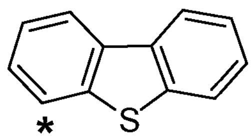
(D8),
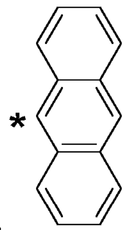
(D9),
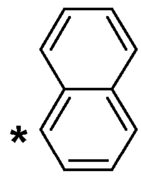
(D10);

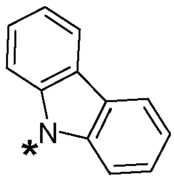
(D11),
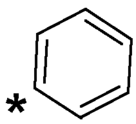
(D12),
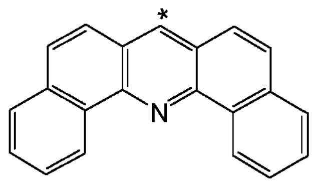
(D13),
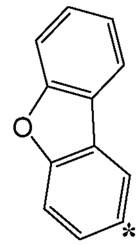
(D14)

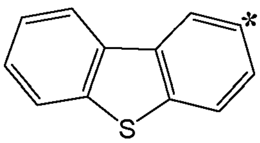
(D15);

$Ar^1$ may be selected from D7 to D15, if m > 0 and k > 0, or may be selected from D7 to D15, if k > 0 and m = 0, or may be selected from D1 to D6, if k > 1;

$Ar^2$ may be selected from D1 to D6, if m > 0 and k > 0; or may be selected from D7 to D15, if m > 0 and k = 0;

$Ar^4$ may be selected from D1 to D6, if q > 0, or may be selected from D1 to D6, if q = 0 and r > 0; or may be selected from D7 to D15, if q and r = 0;

$Ar^5$ may be selected from D1 to D6, if q > 0 and r > 0, or may be selected from D7 to D15, if q > 0 and r = 0;

$Ar^6$ may be selected from D7 to D15, if r > 0, q > 0, or may be selected from D7 to D15, if r > 0, q = 0, or may be selected from D1 to D6, if r > 1.

According to one non-inventive embodiment, wherein the hole transport layer may comprises the hole transport compound or the hole transport compound of formula (I); wherein the hole transport compound or the hole transport compound of formula (I) in the hole injection layer and hole transport layer are selected the same and wherein the hole

transport compound according to formula (I) may be selected from F1 to F13:

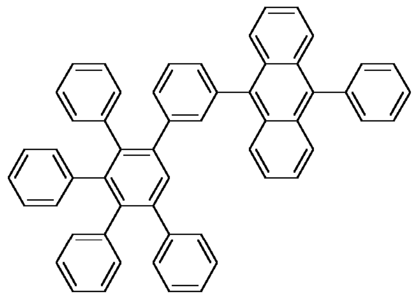 (F1),

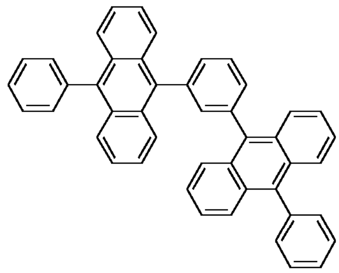 (F2),

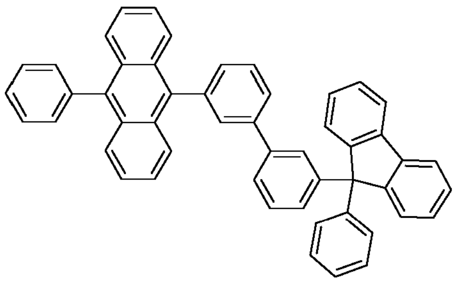 (F3),

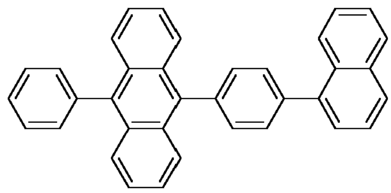 (F4),

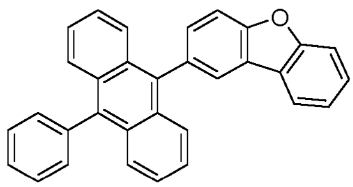 (F5),

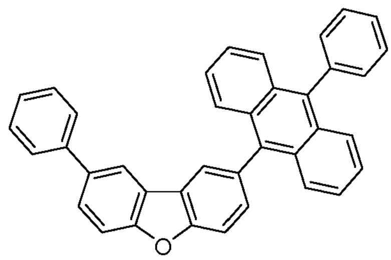 (F6),

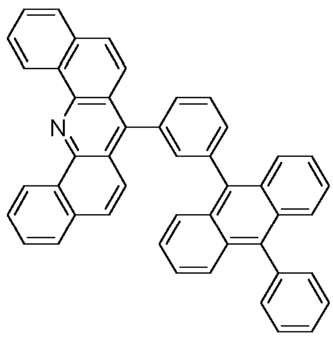 (F7),

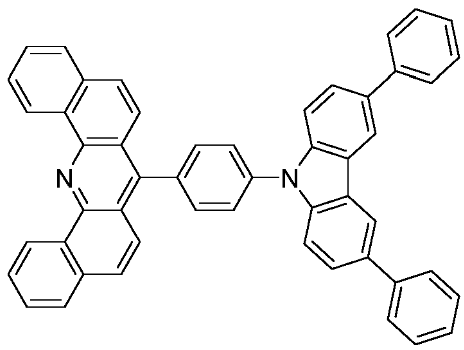 (F8),

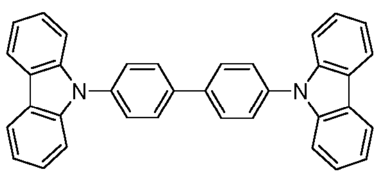 (F9),

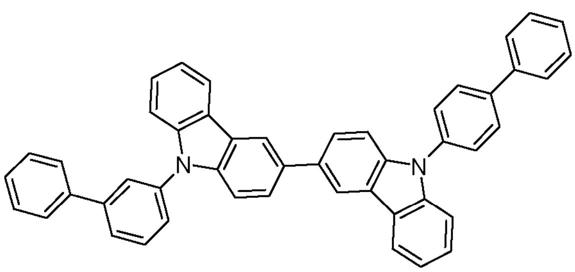 (F10),

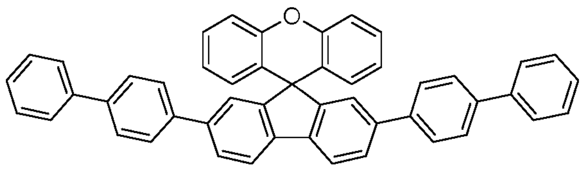

(F11),

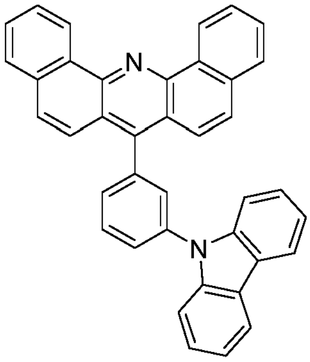

(F12),

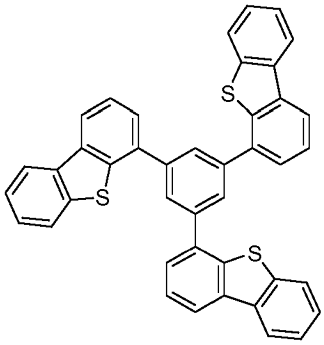

(F13).

The hole transport layer may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The hole transport layer may be free of N,N'-Bis(naphthalen-1-yl)-N,N'-bis(phenyl)-9,9-dimethyl-fluorene, N,N'-Bis(3-methylphenyl)-N,N'-bis(phenyl)-9,9-dimethyl-fluorene, N,N'-Bis(naphthalen-1-yl)-N,N'-bis(phenyl)-9,9-dimethyl-fluorene, N,N'-Bis(naphthalen-1-yl)-N,N'-bis(phenyl)-2,2-dimethylbenzidine, N,N'-Bis(3-methylphenyl)-N,N'-bis(phenyl)-9,9-spirobifluorene, 2,2',7,7'-Tetrakis(N,N-diphenylamino)-9,9'-spirobifluorene, N,N'-Bis(naphthalen-1-yl)-N,N'-bis(phenyl)-benzidine, N,N'-Bis(naphthalen-2-yl)-N,N'-bis(phenyl)-benzidine, N,N'-Bis(3-methylphenyl)-N,N'-bis(phenyl)-benzidine, N,N'-Bis(3-methylphenyl)-N,N'-bis(phenyl)-9,9-dimethyl-fluorene, N,N'-Bis(naphthalen-1-yl)-N,N'-bis(phenyl)-9,9-spirobifluorene, Di-[4-(N,N-ditolyl-amino)-phenyl]cyclohexane, 2,2',7,7'-tetra(N,N-ditolyl)amino-spiro-bifluorene, 9,9-Bis[4-(N,N-bis-biphenyl-4-yl-amino)phenyl]-9H-fluorene, 2,2',7,7'-Tetrakis(N,N-naphthalenyl(phenyl)-amino]-9,9'-spirobifluorene, 2,7-Bis(N,N-bis(9,9-spiro-bifluorene-2-yl)-amino]-9,9'-spirobifluorene, 2,2'-Bis(N,N-bis(biphenyl-4-yl)amino]-9,9'-spirobifluorene, N,N'-bis(phenanthren-9-yl)-N,N'-bis(phenyl)-benzidine, N,N,N',N'-tetra-naphthalen-2-yl)-benzidine, 2,2'-Bis(N,N-di-phenyl-amino)-9,9-spirobifluorene, 9,9-Bis[4-(N,N-bis-naphthalen-2-yl-amino)phenyl]-9H-fluorene, 9,9-Bis[4-(N,N'-bis-naphthalen-2-yl-N,N'-bis-phenyl-amino)-phenyl]-9H-fluorene, Titanium oxide phthalocyanine, Copper phthalocyanine, 2,3,5,6 Tetrafluoro 7,7,8,8, tetracyano-quinodimethane, 4,4'4"-Tris(N-3-methylphenyl-N-phenyl-amino)triphenylamine, 4,4',4"-Tris(N-(2-naphthyl)-N-phenyl-amino)triphenylamine, 4,4',4"-Tris(N-(1-naphthyl)-N-phenyl-amino)triphenylamine, 4,4',4"-Tris(N,N-diphenyl-amino)triphenylamine, Pyrazino[2,3-f][1,10]phenanthroline-2,3-dicarbonitrile, N,N,N',N'-Tetrakis(4-methoxyphenyl)benzidine, HTM014, HTM081, HTM163, HTM222, EL-301, HTM226, HTM355, HTM133, HTM334, HTM604 and EL-22T. The abbreviations denote the manufacturers' names, for example, of Merck or Lumtec.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the hole transport compound that is used to form the HTL.

The thickness of the HTL may be in the range of 5 nm to 250 nm, preferably, 10 nm to 200 nm, further 20 nm to 190 nm, further 40 nm to 180 nm, further 60 nm to 170 nm, further 80 nm to 200 nm, further 100 nm to 180 nm, further 120 nm to 170 nm.

When the thickness of the HTL is within this range, the HTL may have excellent hole transporting characteristics, without a substantial penalty in driving voltage.

Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime may be improved. Typically, the electron blocking layer comprises a triarylamine compound.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer may be selected from triarylamine compounds with a triplet level above the triplet level of the phosphorescent emitter in the adjacent emission layer.
The thickness of the electron blocking layer may be selected between 2 and 20 nm.

Photoactive layer (PAL)

The photoactive layer converts an electrical current into photons or photons into an electrical current.
The PAL may be formed on the HTL by vacuum deposition, spin coating, slot-die coat-ing, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.
It may be provided that the photoactive layer does not comprise the compound of Formula (I).
The photoactive layer may be a light-emitting layer or a light-absorbing layer.

Emission layer (EML)

The EML may be formed on the HTL or EBL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.
It may be provided that the emission layer does not comprise the compound of Formula (I).
The emission layer (EML) may be formed of a combination of a host and an emitter dopant. Example of the host are Alq3, 4,4'-N,N'-dicarbazole-biphenyl (HTC-10), poly(n-vinyl carbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).
The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.
Examples of red emitter dopants are PtOEP, Ir(piq)3, and Btp2lr(acac), but are not limited thereto. These compounds are phosphorescent emitters, however, fluorescent red emitter dopants could also be used.
Examples of phosphorescent green emitter dopants are Ir(ppy)3 (ppy = phenylpyridine), Ir(ppy)2(acac), Ir(mpyp) 3.
Examples of phosphorescent blue emitter dopants are F2Irpic, $(F2ppy)_2Ir(tmd)$ and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.
The amount of the emitter dopant may be in the range from 0.01 to 50 parts by weight, based on 100 parts by weight of the host. Alternatively, the emission layer may consist of a light-emitting polymer. The EML may have a thickness of 10 nm to 100 nm, for example, from 20 nm to 60 nm. When the thickness of the EML is within this range, the EML may have excellent light emission, without a substantial penalty in driving voltage.

Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent emitter dopant, the HBL may have also a triplet exciton blocking function.
The HBL may also be named auxiliary ETL or a-ETL.
When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.
The HBL may have a thickness in the range from 5 nm to 100 nm, for example, from 10 nm to 30 nm. When the thickness of the HBL is within this range, the HBL may have excellent hole-blocking properties, without a substantial penalty in driving voltage.

Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ

The thickness of the ETL may be in the range from 15 nm to 50 nm, for example, in the range from 20 nm to 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from 0.1 nm to 10 nm, for example, in the range from 0.5 nm to 9 nm. When the thickness of the EIL is within this range, the EIL may have satisfactory electron-injecting properties, without a substantial penalty in driving voltage.

Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from 5 nm to 1000 nm, for example, in the range from 10 nm to 100 nm. When the thickness of the cathode layer is in the range from 5 nm to 50 nm, the cathode layer may be transparent or semitransparent even if formed from a metal or metal alloy.

It is to be understood that the cathode layer is not part of an electron injection layer or the electron transport layer.

Organic light-emitting diode (OLED)

The organic electronic device according to the invention may be an organic light-emitting device.

For example, the OLED not according to the invention and as shown in Fig. 2 may be formed by a process, wherein on a substrate (110), an anode layer (120), a hole injection layer (130) comprising a hole transport compound of formula (I) and metal complex of formula (II), a hole transport layer (140), an electron blocking layer (145), an emission layer (150), a hole blocking layer (155), an electron transport layer (160), an electron injection layer (180) and the cathode layer (190) are subsequently formed in that order.

Method of manufacturing

According to another aspect of the present invention, there is provided a method of manufacturing an organic electronic device, the method using:

- at least one deposition source, preferably two deposition sources and more preferred at least three deposition sources.

The methods for deposition that can be suitable comprise:

- deposition via vacuum thermal evaporation;

- deposition via solution processing, preferably the processing may be selected from spin-coating, printing, casting; and/or
- slot-die coating.

According to various embodiments of the present invention, there is provided a method using:

- a first deposition source to release the hole transport compound of Formula (I) according to the invention, and
- a second deposition source to release the metal complex of formula (II).

The method comprising the steps of forming the hole injection layer; whereby for an organic light-emitting diode (OLED):

- the hole injection layer is formed by releasing the hole transport compound of Formula (I) according to the invention from the first deposition source and the metal complex of formula (II) from the second deposition source.

According to various embodiments of the present invention, the method may further include forming on the hole injection layer, at least one layer selected from the group consisting of forming a hole blocking layer, forming an emission layer, forming a hole blocking layer forming an electron transporting layer and/or forming an electron injection layer and/ or forming a cathode layer.

According to various embodiments of the present invention, a non-inventive embodiment, the method may further include the steps for forming an organic light-emitting diode (OLED), wherein

- on a substrate an anode layer is formed,
- on the anode layer a hole injection layer, which comprises a hole transport compound of formula (I) and a metal complex of formula (II) is formed,
- on the hole injection layer, which comprises a hole transport compound of formula (I) and a metal complex of formula (II), a hole transport layer is formed,
- on the hole transport layer an emission layer is formed,
- on the emission layer an electron transport layer is formed, optionally a hole blocking layer is formed on the emission layer,
- and finally a cathode layer is formed,
- optional a hole blocking layer is formed in that order between the hole injection layer and the emission layer,
- optional an electron injection layer is formed between the electron transport layer and the cathode layer.

According to one embodiment, the organic electronic device of the present invention is formed by deposition of the hole injection layer and cathode layer in vacuum.

According to another aspect, it is provided an electronic device comprising at least one organic light emitting device according to any embodiment described throughout this application, preferably, the electronic device comprises the organic light emitting diode in one of embodiments described throughout this application. More preferably, the organic electronic device is a display device.

Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

FIG. 1 is a schematic sectional view of an organic electronic device, which is not according to the present invention;
FIG. 2 is a schematic sectional view of an organic light-emitting diode (OLED), according to an exemplary embodiment

of the present invention;

FIG. 3 is a schematic sectional view of an OLED, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, not according to an exemplary embodiment of the present invention. The organic electronic device 100 includes a substrate 110, an anode layer 120 and a hole injection layer (HIL) (130). The HIL 130 is disposed on the anode layer 120. Onto the HIL 130, a photoactive layer (PAL) 170 and a cathode layer 190 are disposed.

The hole injection layer (HIL) 130 comprises a first and a second sub-layer wherein the first sub-layer is disposed on the anode and the second sub-layer is disposed on the first sub-layer. The photoactive layer (PAL) 170 is disposed on the second-sub-layer.

FIG. 2 is a schematic sectional view of an organic light-emitting diode (OLED) 100, according to an exemplary embodiment of the present invention. The OLED 100 includes a substrate 110, an anode layer 120 and a hole injection layer (HIL) 130, The HIL 130 is disposed on the anode layer 120. Onto the HIL 130, a hole transport layer (HTL) 140, an emission layer (EML) 150, an electron transport layer (ETL) 160, an electron injection layer (EIL) 180 and a cathode layer 190 are disposed. Instead of a single electron transport layer 160, optionally an electron transport layer stack (ETL) can be used.

The hole injection layer (HIL) 130 comprises a first and a second sub-layer wherein the first sub-layer is disposed on the anode and the second sub-layer is disposed on the first sub-layer. The hole transport layer (HTL) 140 is disposed on the second-sub-layer.

Fig. 3 is a schematic sectional view of an OLED 100, according to another exemplary embodiment of the present invention. Fig. 2 differs from Fig. 1 in that the OLED 100 of Fig. 2 comprises an electron blocking layer (EBL) 145 and a hole blocking layer (HBL) 155.

Referring to Fig. 3, the OLED 100 includes a substrate 110, an anode layer 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode layer 190.

While not shown in Fig. 1, Fig. 2 and Fig. 3, a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

**Detailed description**

The invention is furthermore illustrated by the following examples which are illustrative only and non-binding.

Hole transport compounds and hole transport compound of formula (I) and metal complexes of formula (II) may be prepared as described in the literature.

Rate onset temperature

The rate onset temperature ($T_{RO}$) is determined by loading 100 mg hole transport compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than $10^{-5}$ mbar and the temperature inside the source measured with a thermocouple. Evaporation of the hole transport compound is detected with a QCM detector which detects deposition of the hole transport compound on the quartz crystal of the detector. The deposition rate on the quartz crystal is measured in Ångstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of a metal complex of formula (II), the rate onset temperature may be in the range of ≥ 110 °C to ≤ 300 °C, preferably ≥ 115 °C to ≤ 290 °C. If the rate onset temperature is too low the evaporation may be too rapid and therefore difficult to control. If the rate onset temperature is too high the evaporation rate may be too low which may result in low tact time and/or decomposition of the metal complex of formula (II) in VTE source may occur due to prolonged exposure to elevated temperatures.

To achieve good control over the evaporation rate of the hole transport compound of the present invention, the rate onset temperature may be in the range of 120 °C to 300 °C. If the rate onset temperature is too low the evaporation may be too rapid and therefore difficult to control. If the rate onset temperature is too high the evaporation rate may be too low which may result in low tact time.
The rate onset temperature is an indirect measure of the volatility of a compound. The higher the rate onset temperature the lower is the volatility of a compound.

HOMO and LUMO

The HOMO level and LUMO level are calculated with the program package TURBOMOLE V6.5 (TURBOMOLE GmbH, Litzenhardtstrasse 19, 76135 Karlsruhe, Germany). The optimized geometries and the HOMO level and LUMO levels of the molecular structures are determined by applying the hybrid functional B3LYP with a 6-31G* basis set in the gas phase. If more than one conformation is viable, the conformation with the lowest total energy may be selected. The HOMO and LUMO levels are recorded in electron volt (eV).

General procedure for fabrication of non-inventive OLEDs comprising a hole injection layer and an emission layer comprising a fluorescent blue emitter

For OLEDs, see Examples 1 to 11 and comparative examples 1 to 3 in Table 3 and 4, a 15Ω /cm$^2$ glass substrate with 90 nm ITO (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes, to prepare the anode layer.
Then, 70 vol.-% hole transport compound and 30 vol.-% metal complex were co-deposited in vacuum on the anode layer, to form a hole injection layer (HIL) having a thickness of 10 nm. The composition of the hole injection layer can be seen in Table 3 and 4. In comparative examples 1 to 3, 70 vol.-% hole transport compound and 30 vol.-% HAT-CN were co-deposited in vacuum on the anode layer to form a HIL having a thickness of 10 nm.
Then, the hole transport compound was vacuum deposited on the HIL, to form a HTL having a thickness of 128 nm. The hole transport compound in the HTL is selected the same as the hole transport compound in the HIL. The hole transport compound can be seen in Table 3 and 4.
Then N,N-bis(4-(dibenzo[b,d]furan-4-yl)phenyl)-[1,1':4',1"-terphenyl]-4-amine (CAS 1198399-61-9) was vacuum deposited on the HTL, to form an electron blocking layer (EBL) having a thickness of 5 nm.
Then 97 vol.-% HTC-6 as EML host and 3 vol.-% BD200 (Sun Fine Chemicals, Korea) as fluorescent blue emitter dopant were deposited on the EBL, to form a blue-emitting EML with a thickness of 20 nm.
Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.
Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ
Then Al was evaporated at a rate of 0.01 to 1 Å/s at $10^{-7}$ mbar to form a cathode layer with a thickness of 100 nm on the electron transporting layer.
The OLED stack was protected from ambient conditions by encapsulation of the device with a glass slide. Thereby, a cavity is formed, which includes a getter material for further protection.

General procedure for fabrication of non-inventive OLEDs comprising a hole injection layer and an emission layer comprising a phosphorescent green emitter

For OLEDs, see Examples 12 and 13 and comparative examples 4 and 5 in Table 5, a 15Ω /cm$^2$ glass substrate with 90 nm ITO (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes, to prepare the anode layer.
Then, 70 vol.-% hole transport compound and 30 vol.-% metal complex were co-deposited in vacuum on the anode layer, to form a hole injection layer (HIL) having a thickness of 10 nm. The composition of the hole injection layer can be seen in Table 5. In comparative examples 4 and 5, 70 vol.-% hole transport compound and 30 vol.-% HAT-CN were deposited on the anode layer to form a HIL having a thickness of 10 nm.
Then, the hole transport compound was vacuum deposited on the HIL, to form a HTL having a thickness of 165 nm. The hole transport compound in the HTL is selected the same as the hole transport compound in the HIL. The hole transport compound can be seen in Table 5.
Then, 90 vol.-% GH-1 as EML host and 10 vol.-% GD-1 as phosphorescent green emitter dopant were co-deposited in vacuum on the HTL, to form a green-emitting EML with a thickness of 40 nm. The formulas of GH-1 and GD-1 are shown below:

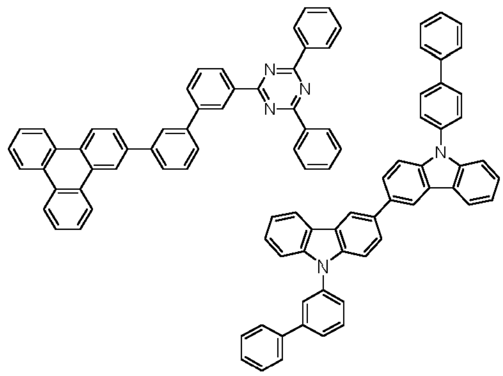

(GH-1)

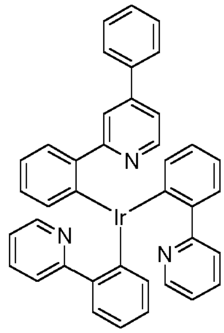

(GD-1)

Then a hole blocking layer was formed with a thickness of 25 nm by depositing 2,4-diphenyl-6-(3'-(triphenylen-2-yl)-[1,1'-biphenyl]-3-yl)-1,3,5-triazine on the emission layer EML.

Then the electron transporting layer having a thickness of 10 nm was formed on the hole blocking layer by depositing 99 vol.-% 3-Phenyl-3H-benzo[b]dinaphtho[2,1-d:1',2'-f]phosphepine-3-oxide and 1 vol.-% Yb.

Then Al was evaporated at a rate of 0.01 to 1 Å/s at $10^{-7}$ mbar to form a cathode layer with a thickness of 100 nm on the electron transporting layer.

The OLED stack is protected from ambient conditions by encapsulation of the device with a glass slide. Thereby, a cavity is formed, which includes a getter material for further protection.

General procedure for fabrication of OLEDs comprising a hole injection layer comprising a first and second sub-layer

For OLEDs, see Examples 14 to 28 and comparative examples 6 to 11 in Table 6, a $15\Omega/cm^2$ glass substrate with 90 nm ITO (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes, to prepare the anode layer.

Then, the hole injection layer comprising a first and a second sub-layer was vacuum deposited on the anode layer. First, a metal complex was vacuum deposited on the anode layer to form a first sub-layer with a thickness of 3 or 5 nm, see Table 6. In comparative examples 6 to 11, HAT-CN is deposited on the anode layer to form a first sub-layer with a thickness of 3 or 5 nm, see Table 6.

Then, the hole transport compound was vacuum deposited on the first sub-layer to form a second sub-layer with a thickness of 7 or 5 nm, see Table 6.

Then, the hole transport compound was vacuum deposited on the hole injection layer to form a HTL. The hole transport compound in the HTL is selected the same as the hole transport compound in the HIL, see Table 6. The thickness is selected in such a way, that the thickness of the second sub-layer and the thickness of the HTL add up to 128 nm in total.

Then N,N-bis(4-(dibenzo[b,d]furan-4-yl)phenyl)-[1,1':4',1"-terphenyl]-4-amine (CAS 1198399-61-9) was vacuum deposited on the HTL, to form an electron blocking layer (EBL) having a thickness of 5 nm.

Then 97 vol.-% HTC-6 as EML host and 3 vol.-% BD200 (Sun Fine Chemicals, Korea) as fluorescent blue emitter dopant were deposited on the EBL, to form a blue-emitting EML with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ

Then Al was evaporated at a rate of 0.01 to 1 Å/s at $10^{-7}$ mbar to form a cathode layer with a thickness of 100 nm on the electron transporting layer.

The OLED stack is protected from ambient conditions by encapsulation of the device with a glass slide. Thereby, a cavity is formed, which may include a getter material for further protection.

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between 0V and 10V. To protect the instruments from damage, the measurement was stopped at 10 V.

## ***Technical Effect***

In order to investigate the usefulness of the inventive hole injection layer preferred materials were tested in view of their physical properties, see Tables 1 and 2.

In Table 1 are shown the HOMO levels calculated with program TURBOMOLE V6.5 (TURBOMOLE GmbH, Litzenhardtstrasse 19, 76135 Karlsruhe, Germany) and the rate onset temperatures $T_{RO}$ of hole transport compounds of the present invention.

Table 1: Chemical formulas and physical properties of hole transport compounds of the present invention

| Name | Chemical formula | HOMO level (eV) | TRO (°C) |
|---|---|---|---|
| 9-phenyl-10-(3',4',5'-triphenyl-[1,1':2',1"-terphenyl]-3-yl)anthracene<br><br>HTC-1 | 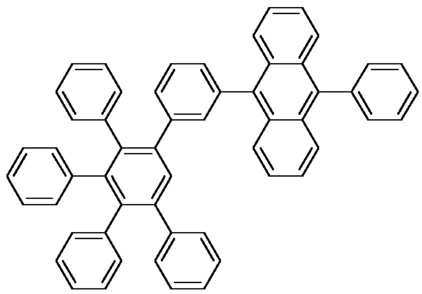 | - 5.04 | 210 |
| 1,3-bis(10-phenylanthracen-9-yl)benzene<br><br>HTC-2 | 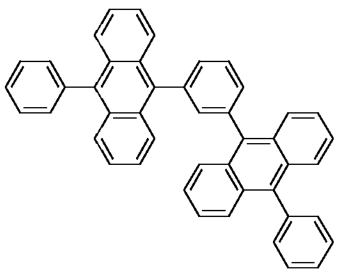 | - 5.08 | 230 |
| 9-phenyl-10-(3'-(9-phenyl-9H-fluoren-9-yl)-[1,1'-biphenyl]-3-yl)anthracene<br><br>HTC-3 | 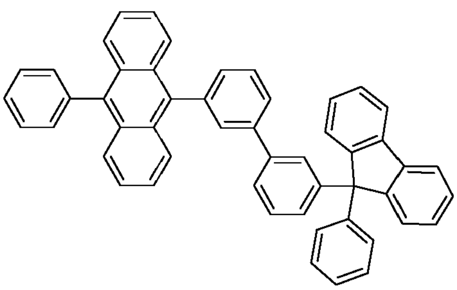 | - 5.08 | 226 |

(continued)

| Name | Chemical formula | HOMO level (eV) | TRO (°C) |
|---|---|---|---|
| 9-([1,1'-biphenyl]-3-yl)-9'-([1,1'-biphenyl]-4-yl)-9H,9'H-3,3'-bicarbazole<br><br>HTC-4 | 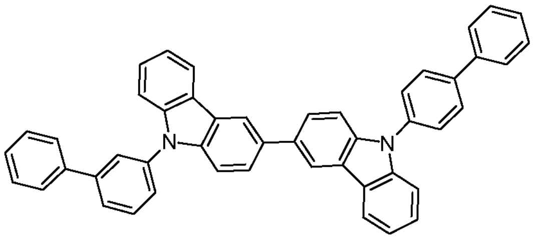 | -5.09 | 265 |
| 9-(4-(naphthalen-1-yl)phenyl)-10-phenylanthracene<br><br>HTC-5 | 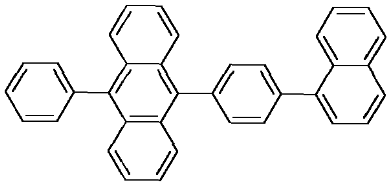 | - 5.1 | approx. 130 |
| 2-(10-phenylanthracen-9-yl)dibenzo [b,d]furan<br><br>HTC-6 | 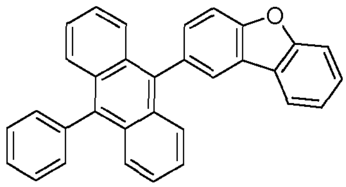 | -5.11 | - |
| 2-phenyl-8-(10-phenylanthracen-9-yl) dibenzo[b,d]furan<br><br>HTC-7 | 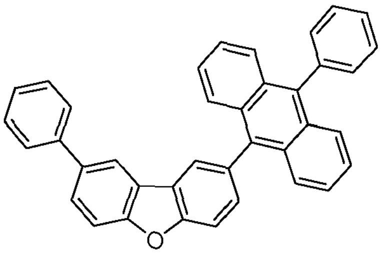 | -5.13 | 216 |
| 7-(3-(10-phenylanthracen-9-yl)phenyl)dibenzo[c,h]acridi ne<br><br>HTC-8 | 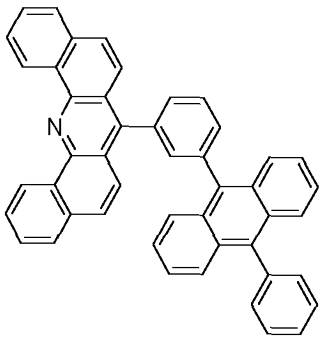 | - 5.17 | 282 |
| 7-(4-(3,6-diphenyl-9H-carbazol-9-yl) phenyl)dibenzo[c,h]acridi ne<br><br>HTC-9 | 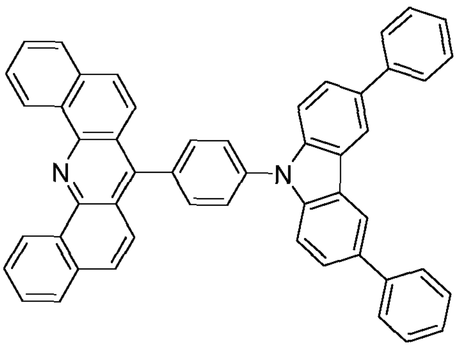 | -5.28 | 291 |

(continued)

| Name | Chemical formula | HOMO level (eV) | TRO (°C) |
|---|---|---|---|
| 4,4'-Bis(carbazol-9-yl)-biphenyl<br><br>HTC-10 | 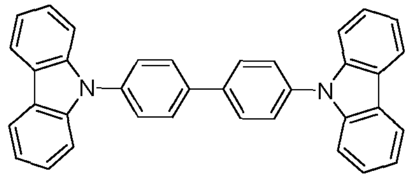 | - 5.3 | appro x. 240 |
| 2,7-di([1,1'-biphenyl]-4-yl)spiro[fluorene-9,9'-xanthene]<br><br>HTC-11 | 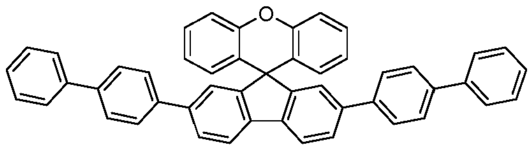 | - 5.38 | 242 |
| 7-(3-(9H-carbazol-9-yl)phenyl)dibenzo[c,h]acridine<br><br>HTC-12 | 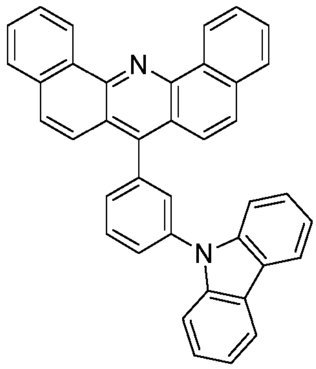 | - 5.42 | 214 |
| 4,4',4"-(1,3,5-Benzenetriyl)tris[dibenzothi ophene]<br><br>HTC-13 | 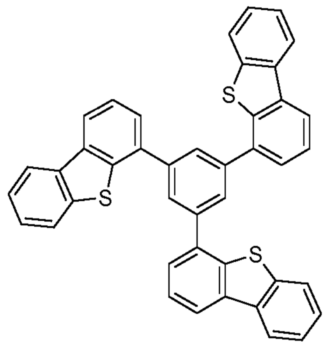 | -5.67 | 272 |

As can be seen in Table 1, the hole transport compounds have rate onset temperatures suitable for mass production of organic electronic devices.

In Table 2 are shown rate onset temperatures $T_{RO}$ for metal complexes of formula (II).

Table 2: Metal complexes of formula (II)

| Name | Chemical formula | $T_{RO}$ (°C) |
|---|---|---|
| MC-1 | Li TFSI | 222 |
| MC-2 | K TFSI | 236 |
| MC-3 | Cs TFSI | 224 |
| MC-4 | Ag TFSI | 258 |
| MC-5 | Mg $(TFSI)_2$ | 243 |
| MC-6 | Mn $(TFSI)_2$ | 229 |
| MC-7 | Sc $(TFSI)_3$ | 258 |

(continued)

| Name | Chemical formula | $T_{RO}$ (°C) |
|---|---|---|
| MC-8 | Mg $[N(SO_2{}^{i}C_3F_7)_2]_2$ | 166 |
| MC-9 | Zn $[N(SO_2{}^{i}C_3F_7)_2]_2$ | 118 |
| MC-10 | Ag $[N(SO_2{}^{i}C_3F_7)_2]$ | 232 |
| MC-11 | Ag $[N(SO_2C_3F_7)_2]$ | 254 |
| MC-12 | Ag $[N(SO_2C_4F_9)_2]$ | 262 |
| MC-13 | Ag $[N(SO_2CF_3)(SO_2C_4F_9)]$ | 230 |
| MC-14 | Cu $[N(SO_2{}^{i}C_3F_7)_2]_2$ | 101 |
| MC-15 | Cu $[N(SO_2C_3F_7)_2]_2$ | 118 |
| MC-16 | Cu $[N(SO_2CF_3)\ (SO_2C_4F_9)]_2$ | 113 |
| MC-17 | Mg $[N(SO_2CF_3)\ (SO_2C_4F_9)]_2$ | 124 |
| MC-18 | Mn $[N(SO_2CF_3)\ (SO_2C_4F_9)]_2$ | 202 |
| MC-19 | Cu $[N(SO_2CH_3)\ (SO_2C_4F_9)]_2$ | 179 |
| MC-20 | Ag $[N(SO_2CH_3)\ (SO_2C_4F_9)]$ | - |
| MC-21 | 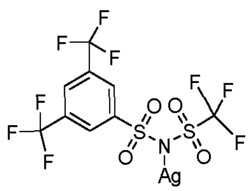 | 254 |
| MC-22 | 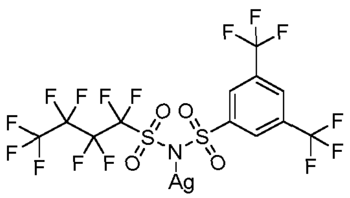 | 238 |
| MC-23 | 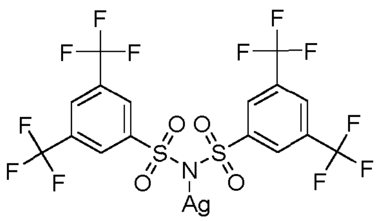 | 262 |
| MC-24 | 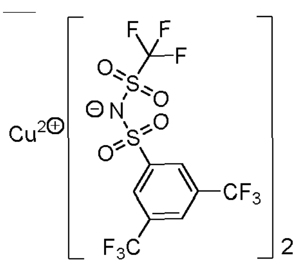 | 180 |

(continued)

| Name | Chemical formula | $T_{RO}$ (°C) |
|---|---|---|
| MC-25 | 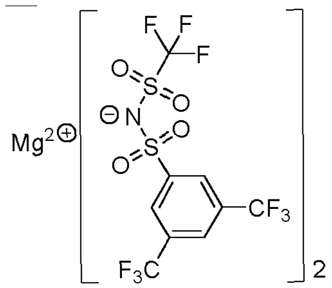 | - |
| MC-26 | 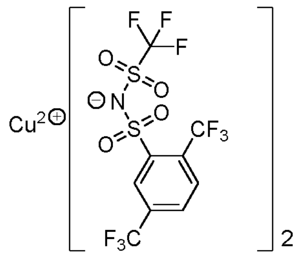 | 167 |
| MC-27 | 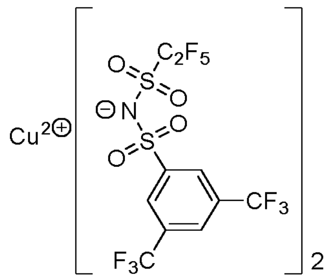 | 282 |
| MC-28 | 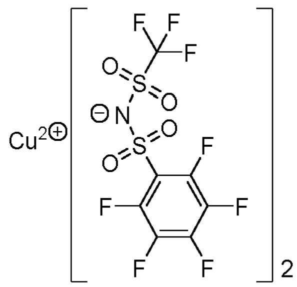 | 263 |
| MC-29 | 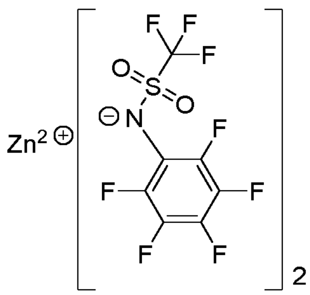 | 194 |
| MC-30 | 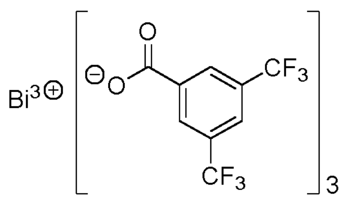 | 190 |

As can be seen in Table 2, the metal complexes of formula (II) have rate onset temperatures suitable for mass production of organic electronic devices.

In Table 3 are shown operating voltages at 10 mA/$cm^2$ in OLEDs comprising a fluorescent blue emitter and a hole injection layer comprising 70 vol.-% HTC-10 and 30 vol.-% metal complex of formula (II). HTC-10 has a HOMO level of -5.30 eV.

Table 3: Performance of OLEDs comprising a fluorescent blue emitter

| | Hole transport compound | Metal complex | U at 10 mA/$cm^2$ [V] |
|---|---|---|---|
| Comparative example 1 | HTC-10 | HAT-CN | > 10 |
| Example 1 | HTC-10 | Cu $(TFSI)_2$ | 6.9 |
| Example 2 | HTC-10 | MC-24 | 6.3 |
| Example 3 | HTC-10 | MC-6 | 5.3 |
| Example 4 | HTC-10 | MC-27 | 5.4 |
| Example 5 | HTC-10 | MC-29 | 5.2 |

Examples 1 to 5 are not part of the invention.

In comparative example 1, HAT-CN, a state of the art material, is used at a concentration of 30 vol.-%. HAT-CN has the formula shown below:

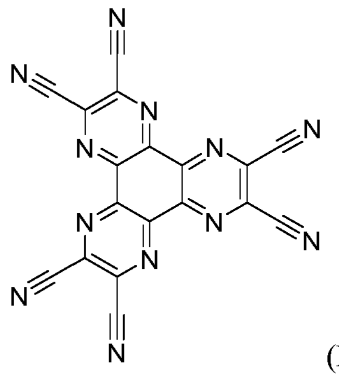

(HAT-CN).

HAT-CN has a HOMO of -8.83 eV. The operating voltage is over 10 V.

In example 1, the hole injection layer comprises $Cu(TFSI)_2$ as metal complex. The operating voltage is substantially improved to 6.9 V.

In example 2, the hole injection layer comprises a different Cu(II) complex, namely MC-24. Compared to example 1, the TFSI ligand has been replaced by an amide ligand comprising one trifluoro methyl and one substituted aryl group. The operating voltage is further improved to 6.3 V.

In example 3, the hole injection layer comprises MC-6. Compared to example 1, the Cu(II) cation has been replaced by a Mn(II) cation. The operating voltage compared to example 1 is improved from 6.9 to 5.3 V.

In example 4, the hole injection layer comprises a Mg complex. Compared to example 2, Cu(II) cation has been replaced by Mg(II) cation. The operating voltage is improved from 6.3 to 5.4 V.

In example 5, the hole injection layer comprises a Zn(II) complex. Compared to example 4, the Mg(II) cation has been replaced by a Zn(II) cation and the amide ligand has been replaced by a ligand comprising an N-aryl group. The operating voltage is still within the range acceptable for mass production.

In Table 4 are shown operating voltages at 10 mA/$cm^2$ in OLEDs comprising a fluorescent blue emitter and a hole injection layer comprising 70 vol.-% hole transport compound and 30 vol.-% metal complex of formula (II).

Table 4: Performance of OLEDs comprising a fluorescent blue emitter

| | Hole transport compound | HOMO level [eV] | Metal complex | U at 10 mA/$cm^2$ [V] |
|---|---|---|---|---|
| Comparative example 2 | HTC-5 | -5.10 | HAT-CN | > 10 |
| Comparative example 3 | HTC-13 | -5.67 | HAT-CN | > 10 |
| Example 6 | HTC-5 | -5.10 | MC-29 | 4.1 |

(continued)

| | Hole transport compound | HOMO level [eV] | Metal complex | U at 10 mA/cm$^2$ [V] |
|---|---|---|---|---|
| Example 7 | HTC-6 | -5.13 | MC-29 | 4.1 |
| Example 8 | HTC-7 | -5.13 | MC-29 | 5.1 |
| Example 9 | HTC-9 | -5.28 | MC-29 | 5.7 |
| Example 10 | HTC-10 | -5.30 | MC-29 | 5.9 |
| Example 11 | HTC-13 | -5.67 | MC-29 | 7.0 |

Examples 6 to 11 are not part of the invention.

In comparative example 2, the hole injection layer comprises hole transport compound HTC-5 and 30 vol.-% HAT-CN. HAT-CN is free of metal complex. HTC-5 comprises an anthracene group. The HOMO level of HTC-5 is -5.10 eV. The operating voltage is over 10 V.

In comparative example 3, the hole injection layer comprises hole transport compound HTC-13 and 30 vol.-% HAT-CN. HTC-13 comprises three dibenzofuranyl groups. The HOMO level is -5.67 eV and is therefore further away from vacuum level compared to comparative example 2. The operating voltage is over 10 V.

In example 6, the hole injection layer comprises HTC-5 and metal complex MC-29. The operating voltage is reduced substantially to 4.1 V.

In example 7, the hole injection layer comprises HTC-6 and metal complex MC-29. HTC-6 comprises an anthracene and a dibenzofuranyl group. The HOMO level is -5.13 eV and is therefore further away from vacuum level compared to comparative example 2. The operating voltage is unchanged at 4.1 V.

In example 8, the hole injection layer comprises HTC-7 and metal complex MC-29. HTC-7 comprises an anthracene and a dibenzofuranyl group. The HOMO level is -5.13 eV and is therefore further away from vacuum level compared to example 6. The operating voltage is a little bit higher than in example 7. However, the operating voltage is substantially reduced compared to comparative example 2.

In example 9, the hole injection layer comprises HTC-9 and metal complex MC-29. HTC-9 comprises a dibenzoacridine and a carbazole group. The HOMO level is -5.28 eV and is therefore further away from vacuum level compared to example 6. The operating voltage is a little bit higher than in example 8. However, the operating voltage is substantially reduced compared to comparative example 2.

In example 10, the hole injection layer comprises HTC-10 and metal complex MC-29. HTC-10 comprises a two carbazole groups. The HOMO level is -5.30 eV and is therefore further away from vacuum level compared to example 9. However, the operating voltage is substantially reduced compared to comparative example 2.

In example 11, the hole injection layer comprises HTC-13 and metal complex MC-29. HTC-13 comprises three dibenzofuranyl groups. The HOMO level is -5.67 eV and is therefore further away from vacuum level compared to example 6. The operating voltage is a little bit higher than in example 10. However, the operating voltage is substantially reduced compared to comparative example 2.

In Table 5 are shown operating voltages at 10 mA/cm$^2$ in OLEDs comprising a phosphorescent green emitter and a hole injection layer comprising a hole transport compound and 30 vol.-% metal complex of formula (II).

Table 5: Performance of OLEDs comprising a phosphorescent green emitter

| | Hole transport compound | HOMO level [eV] | Metal complex | U at 10 mA/cm$^2$ [V] |
|---|---|---|---|---|
| Comparative example 4 | HTC-5 | -5.10 | HAT-CN | > 10 |
| Example 12 | HTC-5 | -5.10 | MC-29 | 4.5 |
| Comparative example 5 | HTC-10 | -5.30 | HAT-CN | > 10 |
| Example 13 | HTC-10 | -5.30 | MC-29 | 6.3 |

Examples 12 and 13 are not part of the invention.

In comparative example 4, the hole injection layer comprises hole transport compound HTC-5 and 30 vol.-% HAT-CN. HTC-5 comprises an anthracene group. The HOMO level of HTC-5 is -5.10 eV. The operating voltage is over 10 V.

In example 12, the hole injection layer comprises HTC-5 and metal complex MC-29. The operating voltage is reduced substantially to 4.1 V.

In comparative example 5, the hole injection layer comprises hole transport compound HTC-10 and 30 vol.-%

HAT-CN. HTC-10 comprises two carbazole groups. The HOMO level of HTC-10 is -5.30 eV. The operating voltage is over 10 V.

In example 13, the hole injection layer comprises HTC-10 and metal complex MC-29. The operating voltage is reduced substantially to 6.3 V.

In Table 6 are shown operating voltages at 10 mA/cm$^2$ in OLEDs comprising a fluorescent blue emitter and a hole injection layer, wherein the hole injection layer comprises a first sub-layer consisting of metal complex of formula (II) and a second sub-layer consisting of hole transport compound.

In comparative example 6, the first sub-layer comprises HAT-CN as a state-of-the-art hole injection material with a thickness of 3 nm. The second sub-layer comprises hole transport compound HTC-6. The operating voltage is over 10 V.

In comparative example 7, the first sub-layer comprises HAT-CN and the second sub-layer comprises hole transport compound HTC-7. The operating voltage is over 10 V.

In comparative example 8, the first sub-layer comprises HAT-CN and the second sub-layer comprises hole transport compound HTC-10. The operating voltage is over 10 V.

In Example 14, the first sub-layer comprises metal complex MC-29 with a thickness of 3 nm. The second sub-layer comprises hole transport compound HTC-6. The operating voltage is 4.0 V and thereby substantially improved over comparative example 6.

In Examples 15 to 17, the first sub-layer is the same as in Example 14. The second sub-layer comprises a range of hole transport compounds with a HOMO level further away from vacuum level than HTC-6. In all examples, the operating voltage is substantially improved over comparative examples 6, 7 and 8.

In Examples 18 to 20, the first sub-layer comprises metal complex MC-27. MC-27 differs from MC-29 in the metal cation and ligand, see Table 2. The second sub-layer comprises a range of hole transport compounds. In all examples, the operating voltage is substantially improved over comparative examples 6, 7 and 8.

In Example 21, the first sub-layer comprises metal complex MC-30. MC-30 differs from MC-29 in the metal cation and ligand, see Table 2. The second sub-layer comprises HTC-7. The operating voltage is 6.6 V and thereby improved over comparative example 7.

In comparative examples 9 to 11, the first sub-layer comprises HAT-CN as a state-of-the-art hole injection material with a thickness of 5 nm. The second sub-layer comprises a range of hole transport compounds. The operating voltage is over 10 V.

In Example 22, the first sub-layer comprises metal complex MC-29 with a thickness of 5 nm. The second sub-layer comprises hole transport compound HTC-6. The operating voltage is 4.0 V and thereby substantially improved over comparative example 9. The performance is comparable to Example 14.

In Examples 23 to 25, the first sub-layer is the same as in Example 22. The second sub-layer comprises various hole transport compounds with a HOMO level further away from vacuum level than HTC-6. In all examples, the operating voltage is substantially improved over comparative examples 9, 10 and 11.

In Examples 26 and 27, the first sub-layer comprises metal complex MC-27. MC-27 differs from MC-29 in the metal cation and ligand, see Table 2. The second sub-layer comprises various hole transport compounds. In all examples, the operating voltage is substantially improved over comparative examples 9, 10 and 11.

In Example 28, the first sub-layer comprises metal complex MC-30. MC-30 differs from MC-29 in the metal cation and ligand, see Table 2. The second sub-layer comprises HTC-7. The operating voltage is 5.4 V and thereby improved over comparative example 10.

In summary, a substantial improvement in operating voltage has been obtained for OLEDs comprising a hole injection layer according to invention.

A reduction in operating voltage may be beneficial for reduced power consumption and improved battery life, in particular in mobile devices.

Table 6: Performance of OLEDs comprising a hole injection layer (HIL), wherein the hole injection layer comprises a first and a second sub-layer

| | Composition of first sub-layer | Thickness of first sub-layer [nm] | Composition of second sub-layer | HOMO level of hole transport compound in second sub-layer [eV] | Thickness of second sub-layer [nm] | Composition of HTL | U at 10 mA/cm$^2$ [V] |
|---|---|---|---|---|---|---|---|
| Comparative example 6 | HAT-CN | 3 | HTC-6 | -5.10 | 7 | HTC-6 | > 10 |

(continued)

| | Composition of first sub-layer | Thickness of first sub-layer [nm] | Composition of second sub-layer | HOMO level of hole transport compound in second sub-layer [eV] | Thickness of second sub-layer [nm] | Composition of HTL | U at 10 mA/cm$^2$ [V] |
|---|---|---|---|---|---|---|---|
| Comparative example 7 | HAT-CN | 3 | HTC-7 | -5.28 | 7 | HTC-7 | > 10 |
| Comparative example 8 | HAT-CN | 3 | HTC-10 | -5.30 | 7 | HTC-10 | > 10 |
| Example 14 | MC-29 | 3 | HTC-6 | -5.10 | 7 | HTC-6 | 4.0 |
| Example 15 | MC-29 | 3 | HTC-5 | -5.13 | 7 | HTC-5 | 4.4 |
| Example 16 | MC-29 | 3 | HTC-7 | -5.28 | 7 | HTC-7 | 4.5 |
| Example 17 | MC-29 | 3 | HTC-10 | -5.30 | 7 | HTC-10 | 4.6 |
| Example 18 | MC-27 | 3 | HTC-6 | -5.10 | 7 | HTC-6 | 4.1 |
| Example 19 | MC-27 | 3 | HTC-5 | -5.13 | 7 | HTC-5 | 4.7 |
| Example 20 | MC-27 | 3 | HTC-7 | -5.28 | 7 | HTC-7 | 4.4 |
| Example 21 | MC-30 | 3 | HTC-7 | -5.28 | 7 | HTC-7 | 6.6 |
| Comparative example 9 | HAT-CN | 5 | HTC-6 | -5.10 | 5 | HTC-6 | > 10 |
| Comparative example 10 | HAT-CN | 5 | HTC-7 | -5.28 | 5 | HTC-7 | > 10 |
| Comparative example 11 | HAT-CN | 5 | HTC-10 | -5.30 | 5 | HTC-10 | > 10 |
| Example 22 | MC-29 | 5 | HTC-6 | -5.10 | 5 | HTC-6 | 4.0 |
| Example 23 | MC-29 | 5 | HTC-5 | -5.13 | 5 | HTC-5 | 4.2 |
| Example 24 | MC-29 | 5 | HTC-7 | -5.28 | 5 | HTC-7 | 4.4 |
| Example 25 | MC-29 | 5 | HTC-10 | -5.30 | 5 | HTC-10 | 4.4 |
| Example 26 | MC-27 | 5 | HTC-5 | -5.13 | 5 | HTC-5 | 4.9 |
| Example 27 | MC-27 | 5 | HTC-7 | -5.28 | 5 | HTC-7 | 4.6 |
| Example 28 | MC-30 | 5 | HTC-7 | -5.28 | 5 | HTC-7 | 5.4 |

## Claims

**1.** An organic electronic device comprising an anode layer, a cathode layer and a hole injection layer, wherein the hole injection layer is arranged between the anode layer and the cathode layer and wherein the hole injection layer comprises a hole transport compound and a metal complex, wherein

- the hole transport compound has the formula (I):

$$(Ar^1)_k\text{-}(Ar^2)_m\text{-}Ar^3\text{-}(Ar^4)_p\text{-}(Ar^5)_q\text{-}(Ar^6)_r \qquad \text{(I)},$$

wherein

k, m, q, r are independently from each other 0, 1 or 2,

p is 1, 2 or 3,

wherein

$$2 \leq k+m+q+r+p \leq 11,$$

$Ar^1$ to $Ar^6$ are independently selected from a substituted or unsubstituted unsaturated 5- to 7-member ring of a heterocycle, a substituted or unsubstituted $C_6$ to $C_{30}$ aryl, a substituted or unsubstituted $C_3$ to $C_{30}$ heteroaryl, a substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents are selected from the group H, D, $C_1$ to $C_{12}$ alkyl, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; and

- the metal complex has the formula (II):

$$M^{n\oplus}(L^{\ominus})_n \qquad (II),$$

wherein

M is a metal ion,
n is the valency of M,
L is a ligand comprising at least two carbon atoms,
n is an integer from 1 to 4;
wherein the hole injection layer is arranged in direct contact to the anode layer; and wherein the hole injection layer comprises a first sub-layer consisting of the metal complex of formula (II) and a second sub-layer consisting of the hole transport compound of formula (I), the first sub-layer being arranged directly adjacent to the anode layer and the second sub-layer being arranged directly adjacent to the first sub-layer;
wherein the organic electronic device further comprises a hole transport layer, wherein the hole transport layer is arranged between the hole injection layer and the at least one photoactive layer or at least one emission layer.

**2.** The organic electronic device according to claim 1, wherein the HOMO level of the hole transport compound is further away from vacuum level than the HOMO level of N4,N4‴-di(naphthalen-1-yl)-N4,N4‴-diphenyl-[1,1':4',1":4",1‴-quaterphenyl]-4,4‴-diamine when determined under the same conditions.

**3.** The organic electronic device according to claims 1 or 2, wherein the hole transport compound according of formula (I) has a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

**4.** The organic electronic device according to any of preceding claims 1 to 3, wherein M is selected from a metal ion wherein the corresponding metal has an electronegativity value according to Allen of less than 2.4, preferably M is selected from an alkali, alkaline earth, rare earth or transition metal, further preferred M is selected from a metal with an atomic mass ≥ 24 Da, in addition preferred M is selected from a metal with an atomic mass ≥ 24 Da and M has an oxidation number ≥ 2.

**5.** The organic electronic device according to any of preceding claims 1 to 4, wherein the metal complex has a molecular weight Mw of ≥ 287 and ≤ 2000 g/mol, preferably a molecular weight Mw of ≥ 400 and ≤ 1500 g/mol, further preferred a molecular weight Mw of ≥ 580 and ≤ 1500 g/mol, in addition preferred a molecular weight Mw of ≥ 580 and ≤ 1400 g/mol.

**6.** The organic electronic device according to any of preceding claims 1 to 5, wherein L is selected from a group

comprising

- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted $C_1$ to $C_6$ alkyl, substituted or unsubstituted $C_1$ to $C_6$ alkoxy, alternatively two or more groups selected from halogen, F, CN, substituted or unsubstituted $C_1$ to $C_6$ alkyl, substituted or unsubstituted $C_1$ to $C_6$ alkoxy, at least one or more groups selected from halogen, F, CN, substituted $C_1$ to $C_6$ alkyl, substituted $C_1$ to $C_6$ alkoxy, alternatively two or more groups selected from halogen, F, CN, perfluorinated $C_1$ to $C_6$ alkyl, perfluorinated $C_1$ to $C_6$ alkoxy, one or more groups selected from substituted or unsubstituted $C_1$ to $C_6$ alkyl, substituted or unsubstituted $C_6$ to $C_{12}$ aryl, and/or substituted or unsubstituted $C_3$ to $C_{12}$ heteroaryl,
wherein the substituents are selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^6$, $COOR^6$, halogen, F or CN;
wherein $R^6$ is selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

**7.** The organic electronic device according any of preceding claims 1 to 6, wherein the metal complex according to formula (II) is non-emissive.

**8.** The organic electronic device according to any of preceding claims 1 to 7, wherein the hole transport compound of formula (I) comprises at least ≥ 1 to ≤ 6 substituted or unsubstituted aromatic fused ring systems comprising heteroaromatic rings and optional at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings and optional at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

**9.** The organic electronic device according to any of preceding claims 1 to 8, wherein

- the hole transport compound of formula (I) comprises a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5- to 7-member ring of a heterocycle; or
- the hole transport compound of formula (I) comprises an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5-to 7-member ring of a heterocycle.

**10.** The organic electronic device according to any of preceding claims 1 to 9, wherein the hole transport compound of formula (I) comprises at least at least ≥ 1 to ≤ 6, preferably ≥ 2 to ≤ 5, or further preferred 3 or 4 of the substituted or unsubstituted aromatic fused ring systems with:

- at least one unsaturated 5-member ring, and/or
- at least one unsaturated 6-member ring, and/or
- at least one unsaturated 7-member ring; wherein preferably at least one unsaturated 5- and/or at least one unsaturated 7-member ring comprises at least 1 to 3, preferably 1 hetero-atom.

**11.** The organic electronic device according to any of preceding claims 1 to 10, wherein the hole transport compound of formula (I) comprises:

- at least ≥ 6 to ≤ 12, preferably ≥ 7 to ≤ 11, further preferred ≥ 8 to ≤ 10 or 9 aromatic rings; and/or
- at least ≥ 4 to ≤ 11, preferably ≥ 5 to ≤ 10, further preferred ≥ 6 to ≤ 9 or in addition preferred 7 or 8 non-hetero aromatic rings, preferably the non-hetero aromatic rings are aromatic $C_6$ rings; and/or
- at least ≥ 1 to ≤ 4, preferably 2 or 3 aromatic 5-member-rings, preferably hetero aromatic 5-member-rings; and/or
- at least 1 or 2 unsaturated 5- to 7-member-ring of a heterocycle, preferably at least 1 or 2 unsaturated 7-member-ring of a heterocycle;
- at least ≥ 6 to ≤ 12, preferably ≥ 7 to ≤ 11, further preferred ≥ 8 to ≤ 10 or 9 aromatic rings, wherein therefrom

  at least ≥ 4 to ≤ 11, preferably ≥ 5 to ≤ 10, further preferred ≥ 6 to ≤ 9 or in addition preferred 7 or 8 are non-hetero aromatic rings, and
  at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and/or

- at least ≥ 6 to ≤ 12, preferably ≥ 7 to ≤ 11, further preferred ≥ 8 to ≤ 10 or 9 aromatic rings, wherein therefrom

  at least ≥ 4 to ≤ 11, preferably ≥ 5 to ≤ 10, further preferred ≥ 6 to ≤ 9 or in addition preferred 7 or 8 are non-hetero aromatic rings, and
  at least ≥ 1 to ≤ 4, preferably 2 or 3 aromatic rings are hetero aromatic rings, wherein the total number of non-hetero aromatic rings and hetero aromatic rings in total does not exceed 12 aromatic rings; and

    the hole transport compound or the hole transport compound according to formula (I) comprises at least ≥ 1 to ≤ 4, preferably 2 or 3 aromatic 5-member-rings, preferably hetero aromatic 5-member-rings, and/or the hole transport compound or the hole transport compound according to formula (I) comprises at least 1 or 2 unsaturated 5- to 7-member-ring of a heterocycle, preferably at least 1 or 2 unsaturated 7-member-ring of a heterocycle.

**12.** The organic electronic device according to any of preceding claims 1 to 11, wherein for formula (I):

- $Ar^3$ is selected from D1 to D17, preferably D1 to D6 and D16:

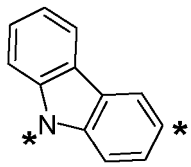
(D1),
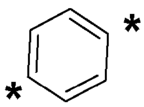
(D2),
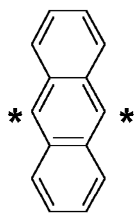
(D3),
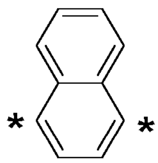
(D4),
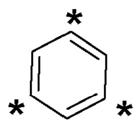
(D5),
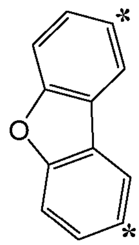
(D6);

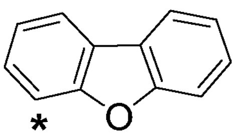
(D7),
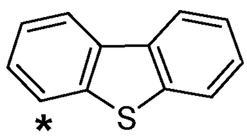
(D8),
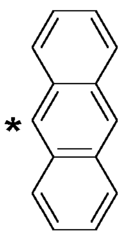
(D9),
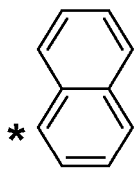
(D10);

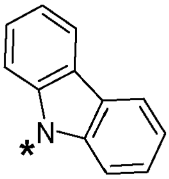 (D11), 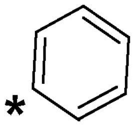 (D12), 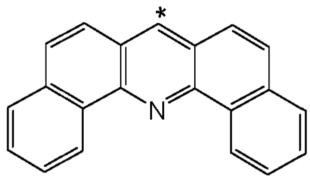 (D13), 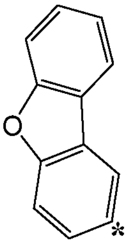 (D14)

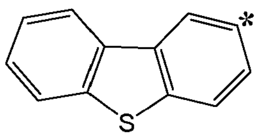 (D15), 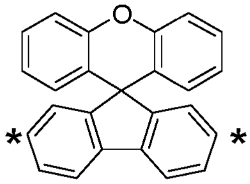 (D16), 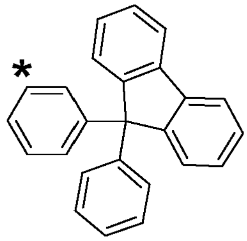 (D17);

$Ar^1$ is selected from D7 to D15 and D17, if m > 0 and k > 0, or is selected from D7 to D15 and D17, if k > 0 and m = 0, or is selected from D1 to D6, if k > 1;
$Ar^2$ is selected from D1 to D6, if m > 0 and k > 0; or is selected from D7 to D15 and D17, if m > 0 and k = 0;
$Ar^4$ is selected from D1 to D6, if q > 0, or is selected from D1 to D6, if q = 0 and r > 0; or is selected from D7 to D15 and D17, if q and r = 0;
$Ar^5$ is selected from D1 to D6, if q > 0 and r > 0, or is selected from D7 to D15 and D17, if q > 0 and r = 0;
$Ar^6$ is selected from D7 to D15 and D17, if r > 0, q > 0, or is selected from D7 to D15 and D17, if r > 0, q = 0, or is selected from D1 to D6, if r > 1.

**13.** The organic electronic device according to any of preceding claims 1 to 12, wherein the hole transport compound according to formula (I) is selected from F1 to F13:

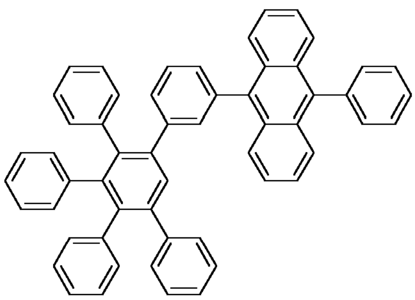 (F1), 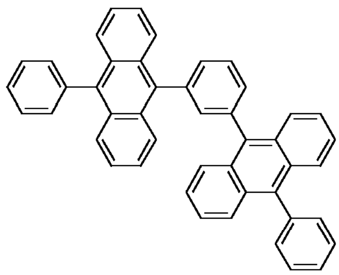 (F2),

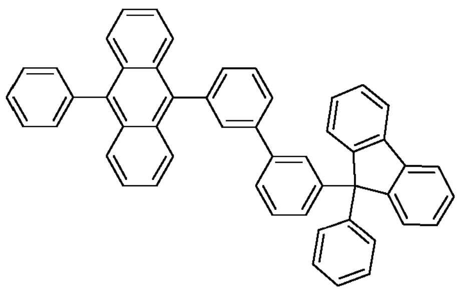 (F3), 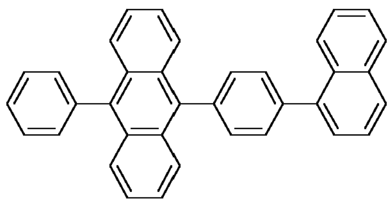 (F4),

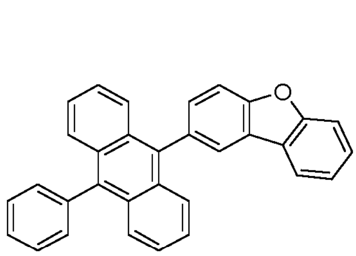 (F5), 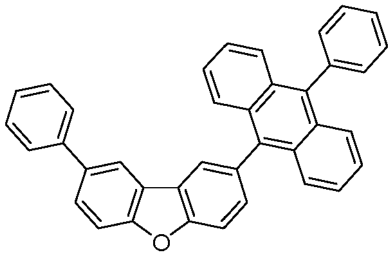 (F6),

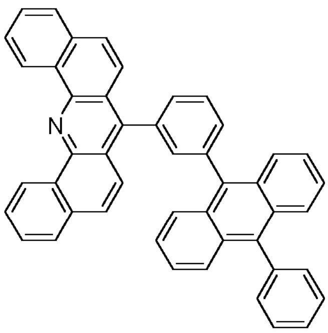 (F7), 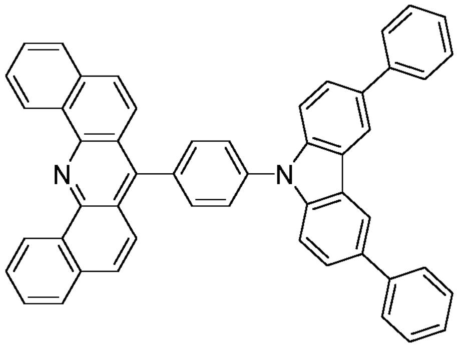 (F8),

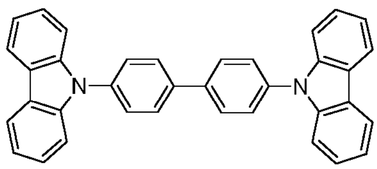 (F9), 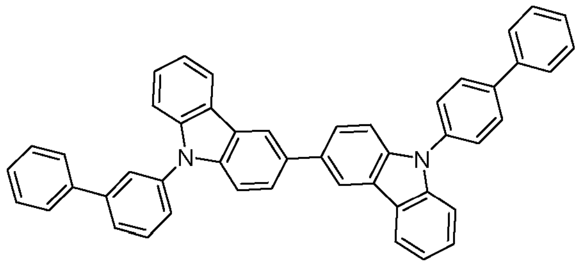 (F10),

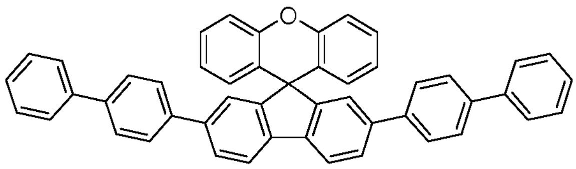 (F11),

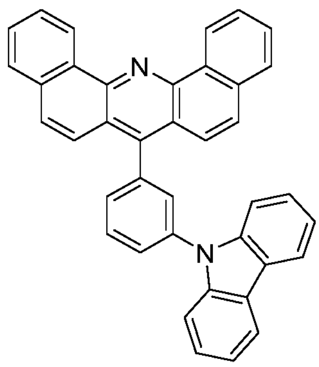 (F12), 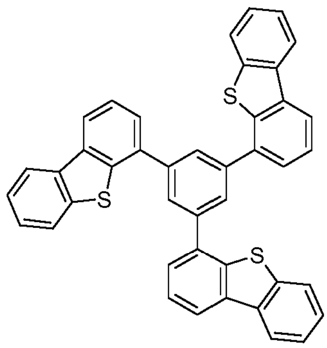 (F13).

**14.** The organic electronic device according to any of preceding claims 1 to 13, wherein n is an integer from 1 to 4, preferably 1 to 3, also preferred 2 or 3.

**15.** The organic electronic device according to any of preceding claims 1 to 14, wherein the metal complex may be selected from the following formulas (IIa) to (IId):

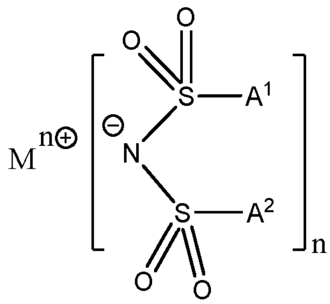 (IIa), 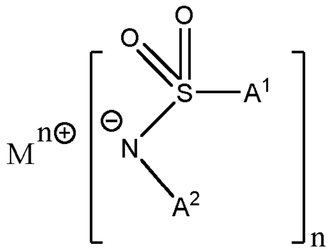 (IIb),

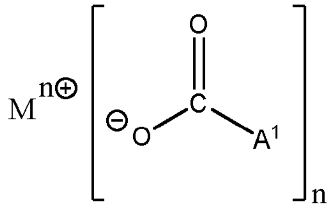 (IIc), 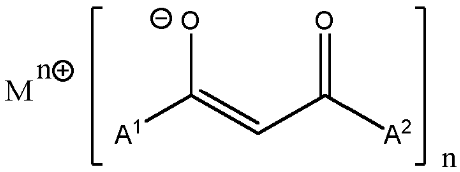 (IId),

wherein

M is a metal ion;
n is the valency of M;
$A^1$ and $A^2$ are independently selected from substituted or unsubstituted $C_1$ to $C_{12}$ alkyl, substituted or unsubstituted $C_6$ to $C_{12}$ aryl, substituted or unsubstituted $C_3$ to $C_{12}$ heteroaryl;
wherein the substituents of $A^1$and $A^2$ are independently selected from D, $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, $COR^1$, $COOR^1$, halogen, F or CN,
wherein $R^1$ is selected from $C_6$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy.

**16.** The organic electronic device according to claim 15, wherein at least one of $A^1$ and $A^2$ comprises a substituent, wherein at least one of the substituents of $A^1$ and $A^2$ is independently selected from $C_3$ to $C_9$ heteroaryl, $C_1$ to $C_6$ alkoxy, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkoxy, $COR^1$, $COOR^1$, halogen, F or CN; preferably at least one of $A^1$ and $A^2$ comprises at least two substituents, wherein the substituents on $A^1$ and $A^2$ are independently selected from $C_3$ to $C_9$ heteroaryl, $C_1$ to $C_6$ alkoxy, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkoxy, $COR^1$, $COOR^1$, halogen, F or CN; and further preferred $A^1$ and $A^2$ comprise at least one substituent independently selected from halogen, F, $CF_3$, $C_2F_5$, $C_3F_7$, $C_4F_9$, $OCF_3$, $OC_2F_5$, or CN; and in addition preferred $A^1$and $A^2$ comprise at least two substituents independently selected from halogen, F, $CF_3$, $C_2F_5$, $C_3F_7$, $C_4F_9$, $OCF_3$, $OC_2F_5$ or CN.

**17.** The organic electronic device according to any of preceding claims 1 to 16, wherein L is independently selected from G1 to G62:

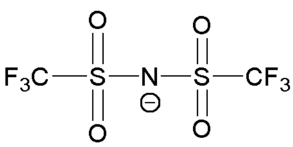 , 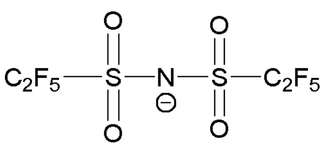 , 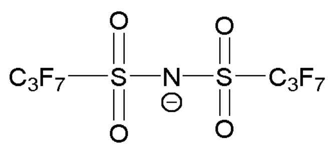 ,

(G1) (G2) (G3)

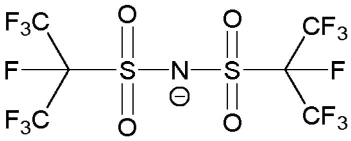,
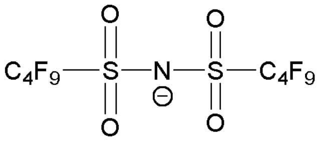,
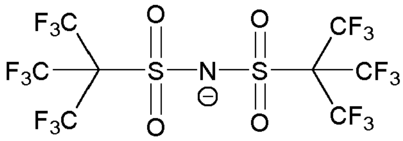,

(G4) (G5) (G6)

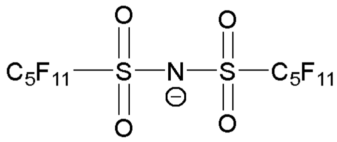,
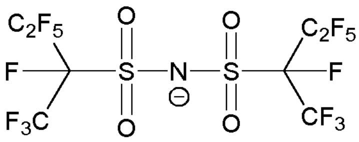,
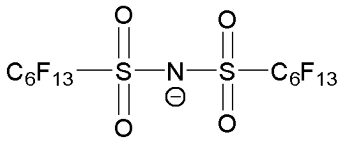,

(G7) (G8) (G9)

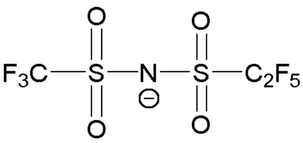,
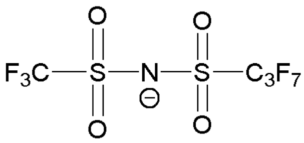,
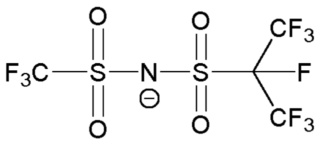,

(G10) (G11) (G12)

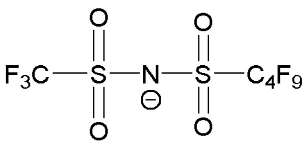,
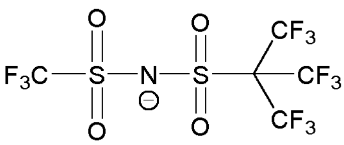,
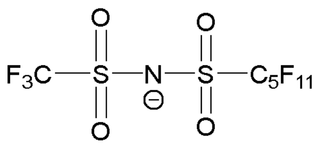,

(G13) (G14) (G15)

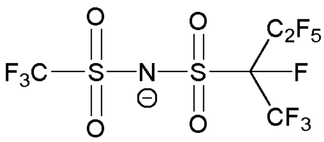,
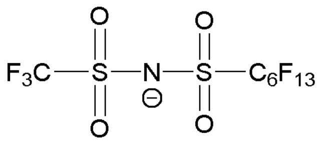,

(G16) (G17)

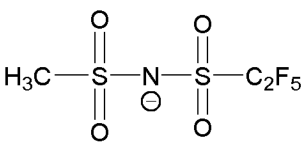,
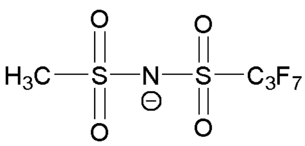,
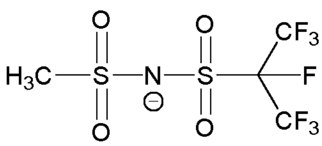,

(G18) (G19) (G20)

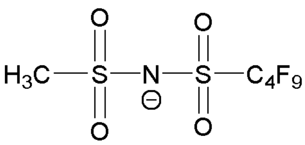,
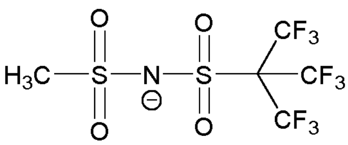,
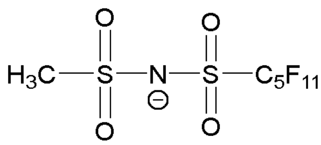,

(G21) (G22) (G23)

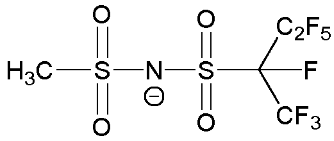,
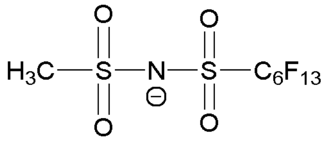,

(G24) (G25)

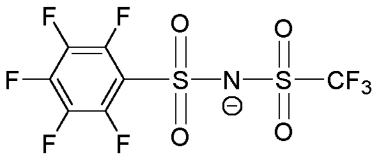,
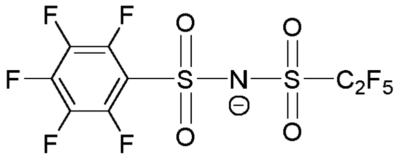,

(G26) (G27)

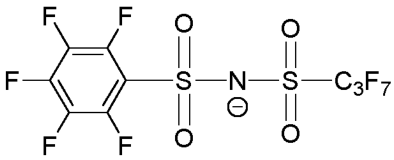,

(G28)

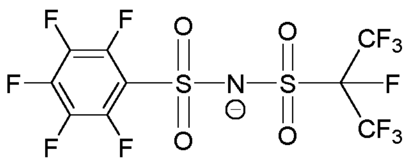,
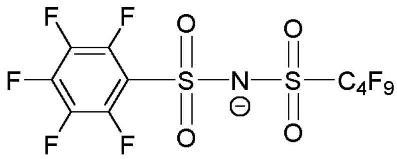,

(G29) (G30)

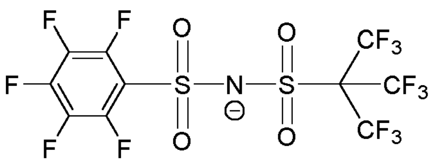,
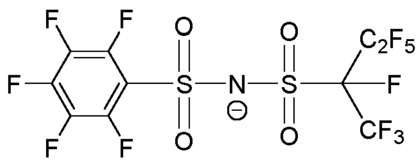,

(G31) (G32)

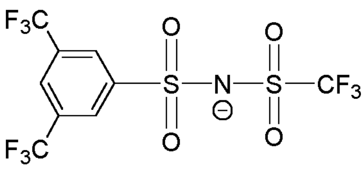,
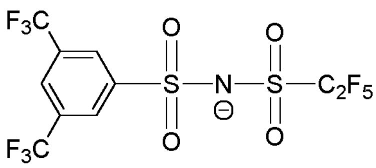,
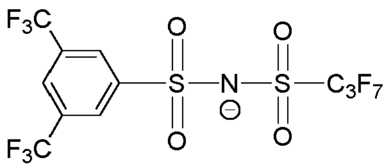,

(G33) (G34) (G35)

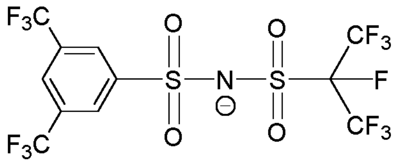,
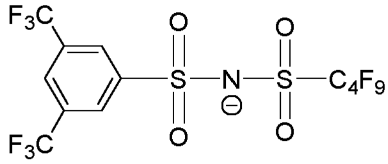,

(G36) (G37)

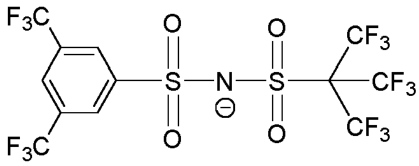,

(G38)

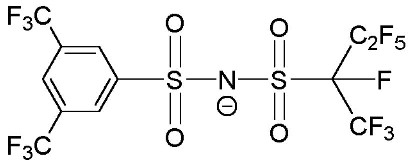,
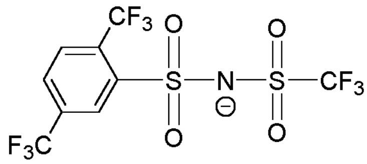,

(G39) (G40)

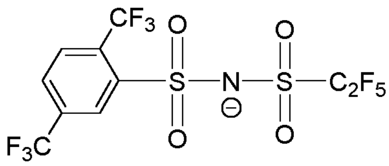,

(G41)

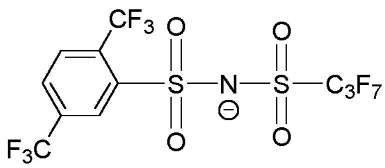,
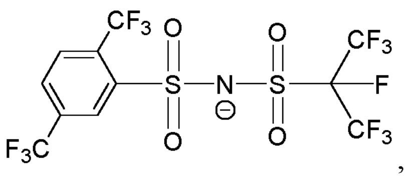,

(G42) (G43)

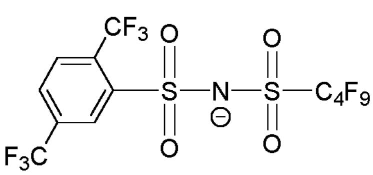,
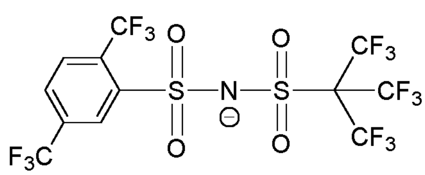

(G44) (G45)

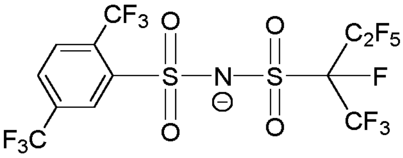,
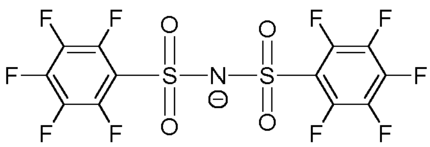

(G46) (G47)

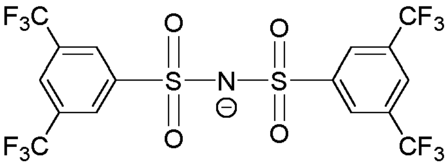,
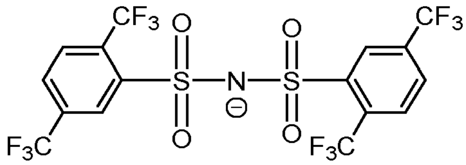

(G48) (G49)

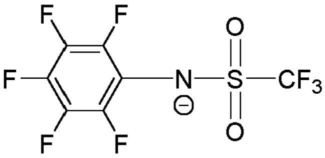,
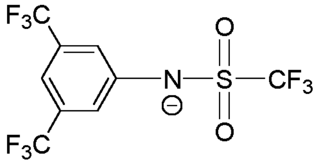,
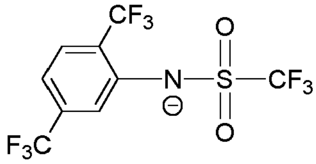,

(G50) (G51) (G52)

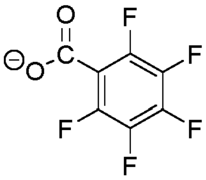,
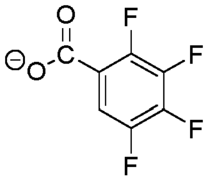,
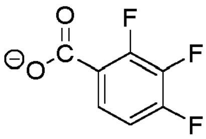,
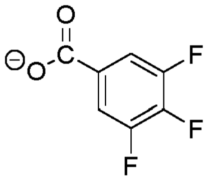,

(G53) (G54) (G55) (G56)

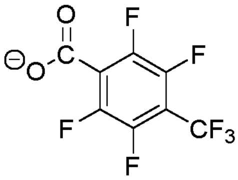
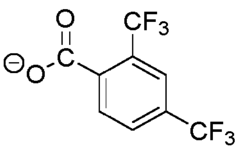,
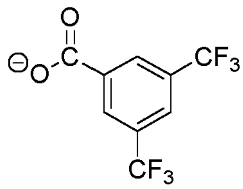,

(G57) (G58) (G59)

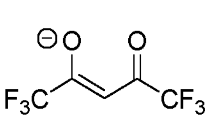,
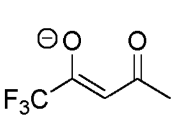,
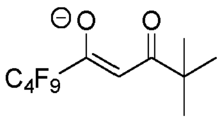

(G60) (G61) (G62).

**18.** The organic electronic device according to any of preceding claims 1 to 17, wherein the organic electronic device further comprises at least one photoactive layer, wherein the photoactive layer is arranged between the hole injection layer and the cathode layer.

**19.** The organic electronic device according to any of preceding claims 1 to 18, wherein the at least one photoactive layer is an emission layer.

20. The organic electronic device according to any of the preceding claims 1 to 19, wherein the electronic device is a light emitting device, thin film transistor, a display device or a photovoltaic cell, and preferably a light emitting device and/or a display device.

## Patentansprüche

1. Organische elektronische Vorrichtung, umfassend eine Anodenschicht, eine Kathodenschicht und eine Lochinjektionsschicht, wobei die Lochinjektionsschicht zwischen der Anodenschicht und der Kathodenschicht angeordnet ist und wobei die Lochinjektionsschicht eine Lochtransportverbindung und einen Metallkomplex umfasst, wobei

   - die Lochtransportverbindung die Formel (I) aufweist:

$$(Ar^1)_k\text{-}(Ar^2)_m\text{-}Ar^3\text{-}(Ar^4)_p\text{-}(Ar^5)_q\text{-}(Ar^6)_r \quad \text{(I)},$$

   wobei

   k, m, q, r unabhängig voneinander für 0, 1 oder 2 stehen,
   p für 1, 2 oder 3 steht,
   wobei

$$2 \leq k+m+q+r+p \leq 11,$$

   $Ar^1$ bis $Ar^6$ unabhängig aus einem substituierten oder unsubstituierten ungesättigten 5- bis 7-gliedrigen Ring eines Heterocyclus, einem substituierten oder unsubstituierten $C_6$- bis $C_{30}$-Aryl, einem substituierten oder unsubstituierten $C_3$- bis $C_{30}$-Heteroaryl, einem substituierten oder unsubstituierten Fluoren oder einem anellierten Ringsystem mit 2 bis 6 substituierten oder unsubstituierten 5- bis 7-gliedrigen Ringen ausgewählt sind und die Ringe aus der Gruppe umfassend (i) einen ungesättigten 5- bis 7-gliedrigen Ring eines Heterocyclus, (ii) 5 bis 6 Glieder eines aromatischen Heterocyclus, (iii) einen ungesättigten 5- bis 7-gliedrigen Ring eines Nichtheterocyclus, (iv) einen 6-gliedrigen Ring eines aromatischen Nichtheterocyclus ausgewählt sind;
   wobei die Substituenten aus der Gruppe von H, D, $C_1$- bis $C_{12}$-Alkyl, unsubstituiertem $C_6$- bis $C_{18}$-Aryl, unsubstituiertem $C_3$- bis $C_{18}$-Heteroaryl, einem anellierten Ringsystem mit 2 bis 6 unsubstituierten 5-bis 7-gliedrigen Ringen ausgewählt sind und die Ringe aus der Gruppe umfassend einen ungesättigten 5- bis 7-gliedrigen Ring eines Heterocyclus, einen 5- bis 6-gliedrigen Ring eines aromatischen Heterocyclus, einen ungesättigten 5- bis 7-gliedrigen Ring eines Nichtheterocyclus und einen 6-gliedrigen Ring eines aromatischen Nichtheterocyclus ausgewählt sind; und

   - der Metallkomplex die Formel (II) aufweist:

$$M^{n\oplus}(L^{\ominus})_n \quad \text{(II)},$$

   wobei

   M für ein Metallion steht,
   n für die Wertigkeit von M steht,
   L für einen Liganden mit mindestens zwei Kohlenstoffatomen steht,
   n für eine ganze Zahl von 1 bis 4 steht;
   wobei die Lochinjektionsschicht in direktem Kontakt mit der Anodenschicht angeordnet ist und wobei die Lochinjektionsschicht eine erste Unterschicht, die aus dem Metallkomplex der Formel (II) besteht, und eine zweite Unterschicht, die aus der Lochtransportverbindung der Formel (I) besteht, umfasst, wobei die erste Unterschicht direkt an die Anodenschicht angrenzend angeordnet ist und die zweite Unterschicht direkt an die erste Unterschicht angrenzend angeordnet ist;
   wobei die organische elektronische Vorrichtung ferner eine Lochtransportschicht umfasst, wobei die Lochtransportschicht zwischen der Lochinjektionsschicht und der mindestens einen photoaktiven Schicht oder mindestens einer Emissionsschicht angeordnet ist.

2. Organische elektronische Vorrichtung nach Anspruch 1, wobei das HOMO-Niveau der Lochtransportverbindung

weiter vom Vakuumniveau entfernt ist als das HOMO-Niveau von N4,N4‴-Di(naphthalin-1-yl)-N4,N4‴-diphenyl-[1,1':4',1":4",1‴-quaterphenyl]-4,4‴-diamin bei Bestimmung unter den gleichen Bedingungen.

**3.** Organische elektronische Vorrichtung nach Anspruch 1 oder 2, wobei die Lochtransportverbindung gemäß Formel (I) ein Molekulargewicht Mw ≥ 400 und ≤ 2000 g/mol, vorzugsweise ein Molekulargewicht Mw ≥ 450 und ≤ 1500 g/mol, weiter bevorzugt ein Molekulargewicht Mw ≥ 500 und ≤ 1000 g/mol, zusätzlich bevorzugt ein Molekulargewicht Mw ≥ 550 und ≤ 900 g/mol, auch bevorzugt ein Molekulargewicht Mw ≥ 600 und ≤ 800 g/mol, aufweist.

**4.** Organische elektronische Vorrichtung nach einem der vorhergehenden Ansprüche 1 bis 3, wobei M aus einem Metallion ausgewählt ist, wobei das entsprechende Metall einen Elektronegativitätswert gemäß Allen von weniger als 2,4 aufweist, vorzugsweise M aus einem Alkali-, Erdalkali-, Seltenerd- oder Übergangsmetall ausgewählt ist, weiter bevorzugt M aus einem Metall mit einer Atommasse ≥ 24 Da ausgewählt ist, zusätzlich bevorzugt M aus einem Metall mit einer Atommasse ≥ 24 Da ausgewählt ist und M eine Oxidationszahl ≥ 2 aufweist.

**5.** Organische elektronische Vorrichtung nach einem der vorhergehenden Ansprüche 1 bis 4, wobei der Metallkomplex ein Molekulargewicht Mw ≥ 287 und ≤ 2000 g/mol, vorzugsweise ein Molekulargewicht Mw ≥ 400 und ≤ 1500 g/mol, weiter bevorzugt ein Molekulargewicht Mw ≥ 580 und ≤ 1500 g/mol, zusätzlich bevorzugt ein Molekulargewicht Mw ≥ 580 und ≤ 1400 g/mol, aufweist.

**6.** Organische elektronische Vorrichtung nach einem der vorhergehenden Ansprüche 1 bis 5, wobei L aus einer Gruppe ausgewählt ist, umfassend

- mindestens drei Kohlenstoffatome, alternativ dazu mindestens vier Kohlenstoffatome, und/oder
- mindestens zwei Sauerstoffatome oder ein Sauerstoff- und ein Stickstoffatom, zwei bis vier Sauerstoffatome, zwei bis vier Sauerstoffatome und null bis zwei Stickstoffatome und/oder
- mindestens eine oder mehrere Gruppe(n), ausgewählt aus Halogen, F, CN, substituiertem oder unsubstituiertem $C_1$- bis $C_6$-Alkyl, substituiertem oder unsubstituiertem $C_1$-bis $C_6$-Alkoxy, alternativ dazu zwei oder mehrere Gruppen, ausgewählt aus Halogen, F, CN, substituiertem oder unsubstituiertem $C_1$- bis $C_6$-Alkyl, substituiertem oder unsubstituiertem $C_1$- bis $C_6$-Alkoxy, mindestens eine oder mehrere Gruppe(n), ausgewählt aus Halogen, F, CN, substituiertem $C_1$- bis $C_6$-Alkyl, substituiertem $C_1$- bis $C_6$-Alkoxy, alternativ dazu zwei oder mehrere Gruppen, ausgewählt aus Halogen, F, CN, perfluoriertem $C_1$- bis $C_6$-Alkyl, perfluoriertem $C_1$- bis $C_6$-Alkoxy, eine oder mehrere Gruppe(n), ausgewählt aus substituiertem oder unsubstituiertem $C_1$- bis $C_6$-Alkyl, substituiertem oder unsubstituiertem $C_6$- bis $C_{12}$-Aryl und/oder substituiertem oder unsubstituiertem $C_3$- bis $C_{12}$-Heteroaryl,

wobei die Substituenten aus D, $C_6$-Aryl, $C_3$- bis $C_9$-Heteroaryl, $C_1$- bis $C_6$-Alkyl, $C_1$- bis $C_6$-Alkoxy, verzweigtem $C_3$- bis $C_6$-Alkyl, cyclischem $C_3$- bis $C_6$-Alkyl, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkyl, teilweise oder perdeuteriertem $C_1$- bis $C_6$-Alkoxy, $COR^6$, $COOR^6$, Halogen, F oder CN ausgewählt sind;

wobei $R^6$ aus $C_6$-Aryl, $C_3$- bis $C_9$-Heteroaryl, $C_1$- bis $C_6$-Alkyl, $C_1$- bis $C_6$-Alkoxy, verzweigtem $C_3$- bis $C_6$-Alkyl, cyclischem $C_3$- bis $C_6$-Alkyl, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkyl, teilweise oder perdeuteriertem $C_1$- bis $C_6$-Alkoxy ausgewählt ist.

**7.** Organische elektronische Vorrichtung nach einem der vorhergehenden Ansprüche 1 bis 6, wobei der Metallkomplex gemäß Formel (II) nichtemissiv ist.

**8.** Organische elektronische Vorrichtung nach einem der vorhergehenden Ansprüche 1 bis 7, wobei die Lochtransportverbindung der Formel (I) mindestens ≥ 1 bis ≤ 6 substituierte oder unsubstituierte aromatische anellierte Ringsysteme mit heteroaromatischen Ringen und gegebenenfalls mindestens ≥ 1 bis ≤ 3 substituierten oder unsubstituierten ungesättigten 5- bis 7-gliedrigen Ringen eines Heterocyclus, vorzugsweise ≥ 2 bis ≤ 5 substituierte oder unsubstituierte aromatische anellierte Ringsysteme mit heteroaromatischen Ringen und gegebenenfalls mindestens ≥ 1 bis ≤ 3 substituierten oder unsubstituierten ungesättigten 5- bis 7-gliedrigen Ringen eines Heterocyclus, weiter bevorzugt 3 oder 4 substituierte oder unsubstituierte aromatische anellierte Ringsysteme mit heteroaromatischen Ringen und gegebenenfalls mindestens ≥ 1 bis ≤ 3 substituierten oder unsubstituierten ungesättigten 5- bis 7-gliedrigen Ringen eines Heterocyclus, und wobei zusätzlich bevorzugt die aromatischen anellierten Ringsysteme mit heteroaromatischen Ringen unsubstituiert sind, und gegebenenfalls mindestens ≥ 1 bis ≤ 3 unsubstituierten ungesättigten 5- bis 7-gliedrigen Ringen eines Heterocyclus umfasst.

**9.** Organische elektronische Vorrichtung nach einem der vorhergehenden Ansprüche 1 bis 8, wobei

- die Lochtransportverbindung der Formel (I) ein substituiertes oder unsubstituiertes aromatisches anelliertes Ringsystem mit mindestens ≥ 2 bis ≤ 6, vorzugsweise ≥ 3 bis ≤ 5 oder 4 anellierten aromatischen Ringen, die aus der Gruppe umfassend substituierte oder unsubstituierte nichtheteroaromatische Ringe, substituierte oder unsubstituierte 5-gliedrige Heteroringe, substituierte oder unsubstituierte 6-gliedrige Ringe und/oder substituierte oder unsubstituierte ungesättigte 5- bis 7-gliedrige Ringe eines Heterocyclus ausgewählt sind, umfasst; oder
- die Lochtransportverbindung der Formel (I) ein unsubstituiertes aromatisches anelliertes Ringsystem mit mindestens ≥ 2 bis ≤ 6, vorzugsweise ≥ 3 bis ≤ 5 oder 4 anellierten aromatischen Ringen, die aus der Gruppe umfassend unsubstituierte nichtheteroaromatische Ringe, unsubstituierte 5-gliedrige Heteroringe, unsubstituierte 6-gliedrige Ringe und/oder unsubstituierte ungesättigte 5- bis 7-gliedrige Ringe eines Heterocyclus ausgewählt sind, umfasst.

**10.** Organische elektronische Vorrichtung nach einem der vorhergehenden Ansprüche 1 bis 9, wobei die Lochtransportverbindung der Formel (I) mindestens ≥ 1 bis ≤ 6, vorzugsweise ≥ 2 bis ≤ 5 oder weiter bevorzugt 3 oder 4 der substituierten oder unsubstituierten aromatischen anellierten Ringsysteme umfasst mit:

- mindestens einem ungesättigten 5-gliedrigen Ring und/oder
- mindestens einem ungesättigten 6-gliedrigen Ring und/oder
- mindestens einem ungesättigten 7-gliedrigen Ring;

wobei vorzugsweise mindestens ein ungesättigter 5- und/oder mindestens ein ungesättigter 7-gliedriger Ring mindestens 1 bis 3 Heteroatom(e), vorzugsweise 1 Heteroatom, umfasst.

**11.** Organische elektronische Vorrichtung nach einem der vorhergehenden Ansprüche 1 bis 10, wobei die Lochtransportverbindung der Formel (I) umfasst:

- mindestens ≥ 6 bis ≤ 12, vorzugsweise ≥ 7 bis ≤ 11, weiter bevorzugt ≥ 8 bis ≤ 10 oder 9 aromatische Ringe und/oder
- mindestens ≥ 4 bis ≤ 11, vorzugsweise ≥ 5 bis ≤ 10, weiter bevorzugt ≥ 6 bis ≤ 9 oder zusätzlich bevorzugt 7 oder 8 nichtheteroaromatische Ringe, wobei es sich bei den nichtheteroaromatischen Ringen vorzugsweise um aromatische $C_6$-Ringe handelt; und/oder
- mindestens ≥ 1 bis ≤ 4, vorzugsweise 2 oder 3, aromatische(n) 5-gliedrige(n) Ring(e), vorzugsweise heteroaromatische(n) 5-gliedrige(n) Ring(e); und/oder
- mindestens 1 oder 2 ungesättigte(n) 5- bis 7-gliedrige(n) Ring(e) eines Heterocyclus, vorzugsweise mindestens 1 oder 2 ungesättigte(n) 7-gliedrige(n) Ring(e) eines Heterocyclus;
- mindestens ≥ 6 bis ≤ 12, vorzugsweise ≥ 7 bis ≤ 11, weiter bevorzugt ≥ 8 bis ≤ 10 oder 9 aromatische Ringe, wobei davon

  mindestens ≥ 4 bis ≤ 11, vorzugsweise ≥ 5 bis ≤ 10, weiter bevorzugt ≥ 6 bis ≤ 9 oder zusätzlich bevorzugt 7 oder 8 nichtheteroaromatische Ringe sind und
  mindestens ≥ 1 bis ≤ 4, vorzugsweise 2 oder 3 aromatische(r) Ring(e) (ein) heteroaromatische(r) Ring(e) ist/sind, wobei die Gesamtzahl von nichtheteroaromatischen Ringen und heteroaromatischen Ringen insgesamt 12 aromatische Ringe nicht überschreitet; und/oder

- mindestens ≥ 6 bis ≤ 12, vorzugsweise ≥ 7 bis ≤ 11, weiter bevorzugt ≥ 8 bis ≤ 10 oder 9 aromatische Ringe, wobei davon

  mindestens ≥ 4 bis ≤ 11, vorzugsweise ≥ 5 bis ≤ 10, weiter bevorzugt ≥ 6 bis ≤ 9 oder zusätzlich bevorzugt 7 oder 8 nichtheteroaromatische Ringe sind und
  mindestens ≥ 1 bis ≤ 4, vorzugsweise 2 oder 3 aromatische(r) Ring(e) (ein) heteroaromatische(r) Ring(e) ist/sind, wobei die Gesamtzahl von nichtheteroaromatischen Ringen und heteroaromatischen Ringen insgesamt 12 aromatische Ringe nicht überschreitet; und
  die Lochtransportverbindung oder die Lochtransportverbindung gemäß Formel (I) mindestens ≥ 1 bis ≤ 4, vorzugsweise 2 oder 3 aromatische(n) 5-gliedrige(n) Ring(e), vorzugsweise heteroaromatische(n) 5-gliedrige(n) Ring(e), umfasst und/oder
  die Lochtransportverbindung oder die Lochtransportverbindung gemäß Formel (I) mindestens 1 oder 2

ungesättigte(n) 5- bis 7-gliedrige(n) Ring(e) eines Heterocyclus, vorzugsweise mindestens 1 oder 2 ungesättigte(n) 7-gliedrige(n) Ring(e) eines Heterocyclus, umfasst.

**12.** Organische elektronische Vorrichtung nach einem der vorhergehenden Ansprüche 1 bis 11, wobei für Formel (I):

- $Ar^3$ aus D1 bis D17, vorzugsweise D1 bis D6 und D16, ausgewählt ist:

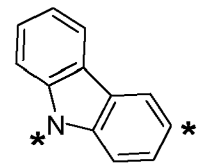 (D1), 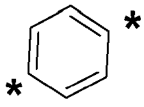 (D2), 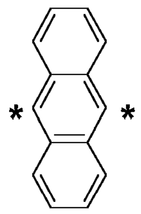 (D3), 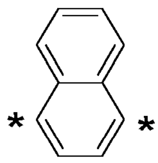 (D4), 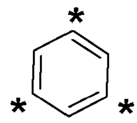 (D5), 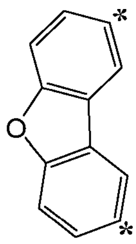 (D6);

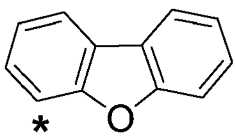 (D7), 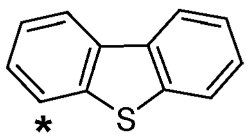 (D8), 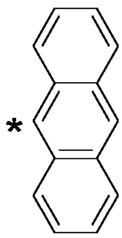 (D9), 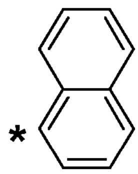 (D10);

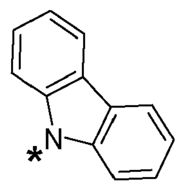 (D11), 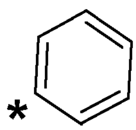 (D12), 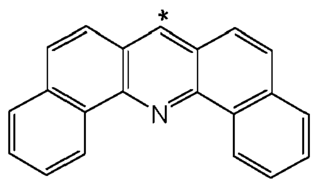 (D13), 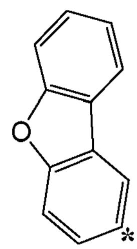 (D14)

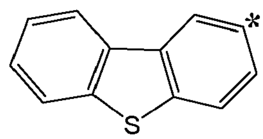 (D15), 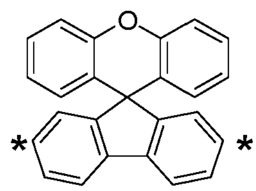 (D16), 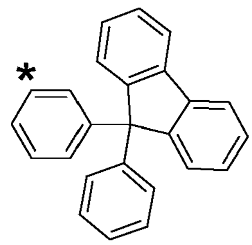 (D17);

$Ar^1$ aus D7 bis D15 und D17 ausgewählt ist, wenn m > 0 und k > 0, oder aus D7 bis D15 und D17 ausgewählt ist, wenn k > 0 und m = 0, oder aus D1 bis D6 ausgewählt ist, wenn k > 1;
$Ar^2$ aus D1 bis D6 ausgewählt ist, wenn m > 0 und k > 0; oder aus D7 bis D15 und D17 ausgewählt ist, wenn m > 0 und k = 0;
$Ar^4$ aus D1 bis D6 ausgewählt ist, wenn q > 0, oder aus D1 bis D6 ausgewählt ist, wenn q = 0 und r > 0; oder aus D7 bis D15 und D17 ausgewählt ist, wenn q und r = 0;
$Ar^5$ aus D1 bis D6 ausgewählt ist, wenn q > 0 und r > 0, oder aus D7 bis D15 und D17 ausgewählt ist, wenn q > 0 und r = 0;
$Ar^6$ aus D7 bis D15 und D17 ausgewählt ist, wenn r > 0, q > 0, oder aus D7 bis D15 und D17 ausgewählt ist, wenn r > 0, q = 0, oder aus D1 bis D6 ausgewählt ist, wenn r > 1.

**13.** Organische elektronische Vorrichtung nach einem der vorhergehenden Ansprüche 1 bis 12, wobei die Lochtransportverbindung gemäß Formel (I) aus F1 bis F13 ausgewählt ist:

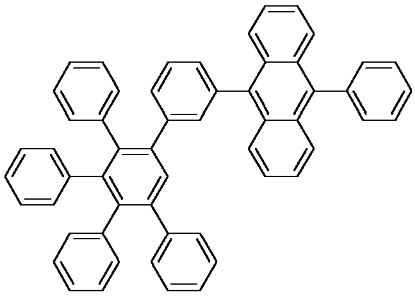
(F1),

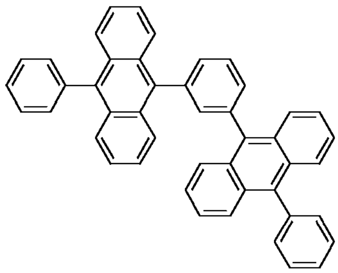
(F2),

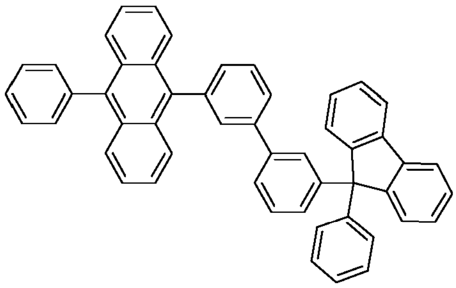
(F3),

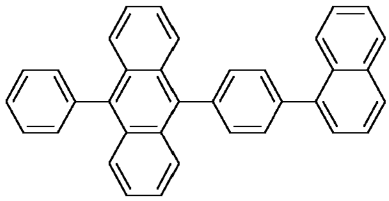
(F4),

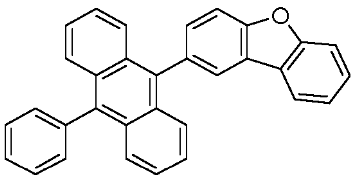
(F5),

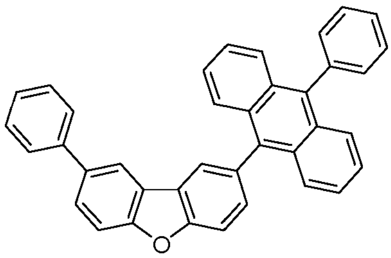
(F6),

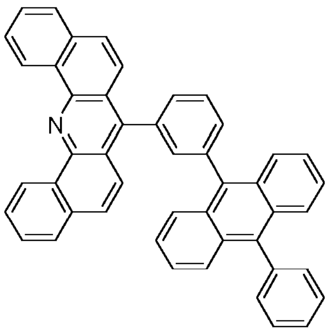
(F7),

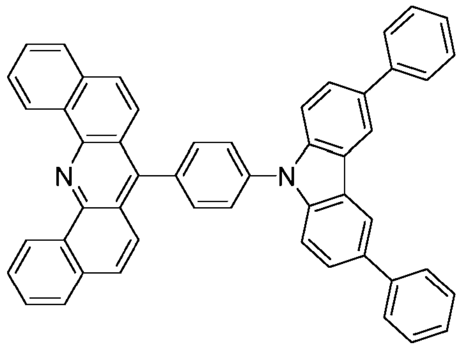
(F8),

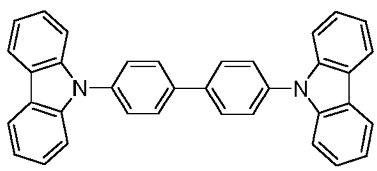
(F9),

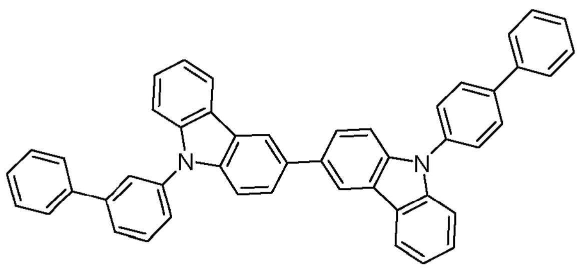
(F10),

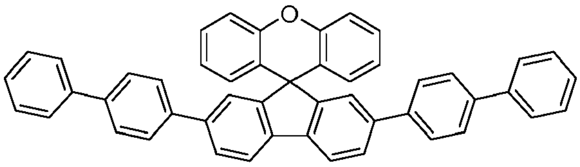
(F11),

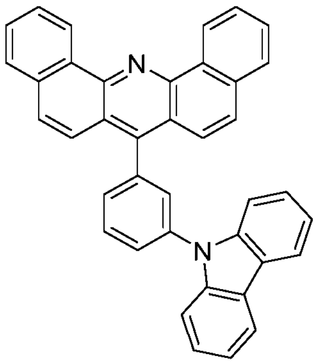
(F12),

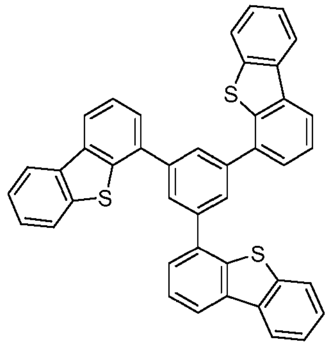
(F13).

**14.** Organische elektronische Vorrichtung nach einem der vorhergehenden Ansprüche 1 bis 13, wobei n für eine ganze Zahl von 1 bis 4, vorzugsweise 1 bis 3, auch bevorzugt 2 oder 3, steht.

**15.** Organische elektronische Vorrichtung nach einem der vorhergehenden Ansprüche 1 bis 14, wobei der Metallkomplex aus den folgenden Formeln (IIa) bis (IId) ausgewählt sein kann:

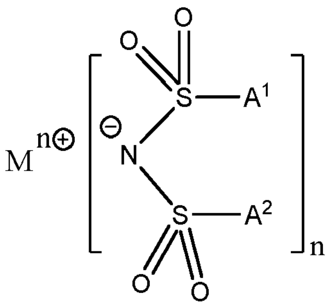
(IIa),

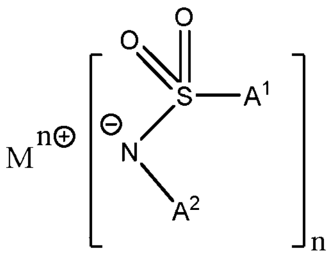
(IIb),

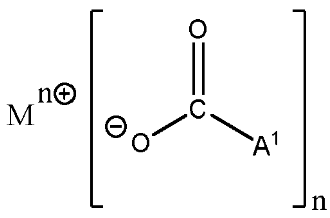
(IIc),

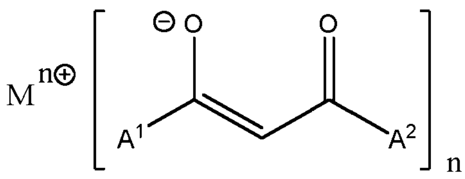
(IId),

wobei

M für ein Metallion steht;
n für die Wertigkeit von M steht;
$A^1$ und $A^2$ unabhängig aus substituiertem oder unsubstituiertem $C_1$- bis $C_{12}$-Alkyl, substituiertem oder unsubstituiertem $C_6$- bis $C_{12}$-Aryl, substituiertem oder unsubstituiertem $C_3$- bis $C_{12}$-Heteroaryl ausgewählt sind; wobei die Substituenten von $A^1$ und $A^2$ unabhängig aus D, $C^6$-Aryl, $C_3$- bis $C_9$-Heteroaryl, $C_1$- bis $C_6$-Alkyl, $C_1$- bis $C_6$-Alkoxy, verzweigtem $C_3$- bis $C_6$-Alkyl, cyclischem $C_3$-bis $C_6$-Alkyl, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkyl, teilweise oder perdeuteriertem $C_1$- bis $C_6$-Alkoxy, $COR^1$, $COOR^1$, Halogen, F oder CN ausgewählt sind,

wobei $R^1$ aus $C_6$-Aryl, $C_3$- bis $C_9$-Heteroaryl, $C_1$- bis $C_6$-Alkyl, $C_1$- bis $C_6$-Alkoxy, verzweigtem $C_3$- bis $C_6$-Alkyl, cyclischem $C_3$- bis $C_6$-Alkyl, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkyl, teilweise oder perdeuteriertem $C_1$- bis $C_6$-Alkoxy ausgewählt ist.

**16.** Organische elektronische Vorrichtung nach Anspruch 15, wobei mindestens eines von $A^1$ und $A^2$ einen Substituenten umfasst, wobei mindestens einer der Substituenten von $A^1$ und $A^2$ unabhängig aus $C_3$- bis $C_9$-Heteroaryl, $C_1$- bis $C_6$-Alkoxy, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkoxy, $COR^1$, $COOR^1$, Halogen, F oder CN ausgewählt ist; vorzugsweise mindestens eines von $A^1$ und $A^2$ mindestens zwei Substituenten umfasst, wobei die Substituenten an $A^1$ und $A^2$ unabhängig aus $C_3$- bis $C_9$-Heteroaryl, $C_1$- bis $C_6$-Alkoxy, verzweigtem $C_3$- bis $C_6$-Alkoxy, cyclischem $C_3$- bis $C_6$-Alkoxy, teilweise oder perfluoriertem $C_1$- bis $C_{16}$-Alkyl, teilweise oder perfluoriertem $C_1$- bis $C_{16}$-Alkoxy, teilweise oder perdeuteriertem $C_1$- bis $C_6$-Alkoxy, $COR^1$, $COOR^1$, Halogen, F oder CN ausgewählt sind; und weiter bevorzugt $A^1$ und $A^2$ mindestens einen Substituenten umfassen, der unabhängig aus Halogen, F, $CF_3$, $C_2F_5$, $C_3F_7$, $C_4F_9$, $OCF_3$, $OC_2F_5$ oder CN ausgewählt ist; und zusätzlich bevorzugt $A^1$ und $A^2$ mindestens zwei Substituenten umfassen, die unabhängig aus Halogen, F, $CF_3$, $C_2F_5$, $C_3F_7$, $C_4F_9$, $OCF_3$, $OC_2F_5$ oder CN ausgewählt sind.

**17.** Organische elektronische Vorrichtung nach einem der vorhergehenden Ansprüche 1 bis 16, wobei L unabhängig aus G1 bis G62 ausgewählt ist:

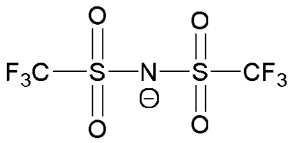 , 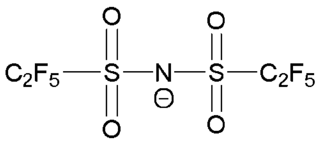 , 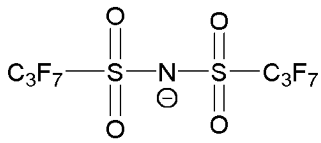 ,

(G1) (G2) (G3)

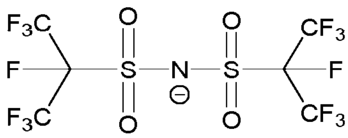 , 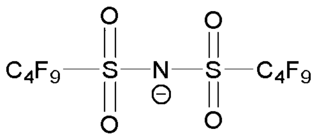 , 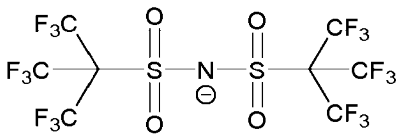 ,

(G4) (G5) (G6)

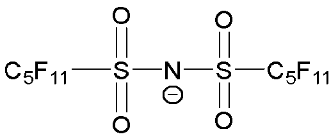 , 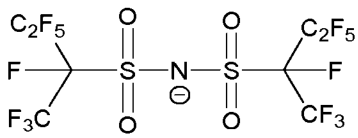 , 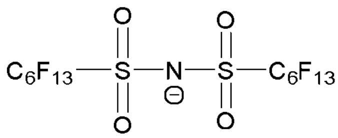 ,

(G7) (G8) (G9)

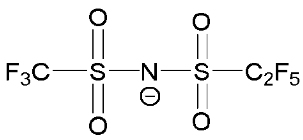 , 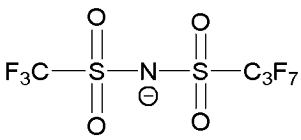 , 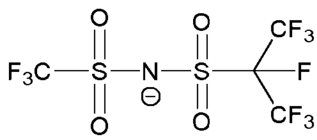 ,

(G10) (G11) (G12)

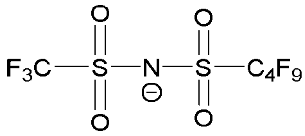,
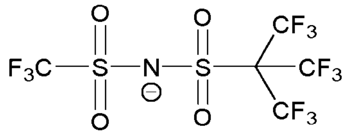,
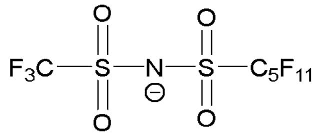,

(G13) (G14) (G15)

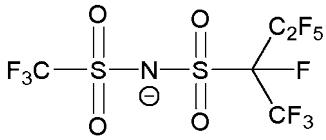,
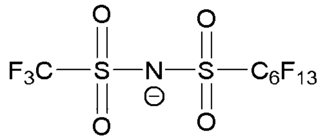,

(G16) (G17)

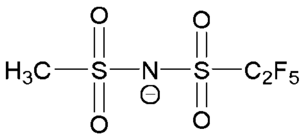,
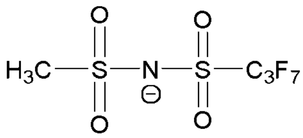,
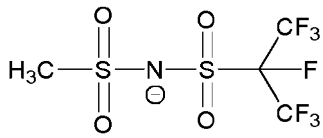,

(G18) (G19) (G20)

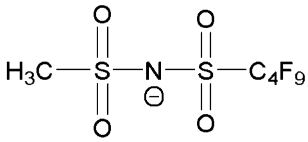,
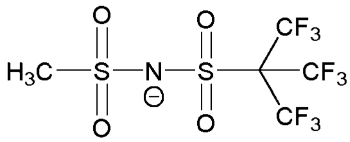,
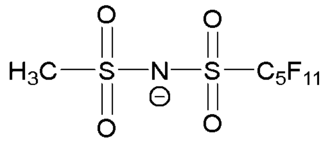,

(G21) (G22) (G23)

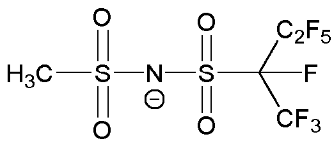,
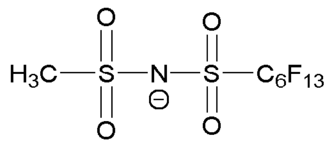,

(G24) (G25)

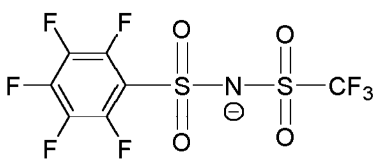,
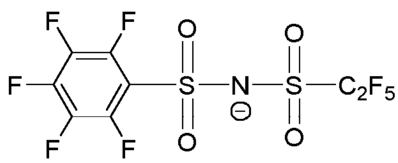,

(G26) (G27)

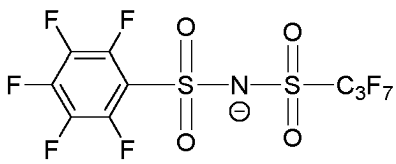,

(G28)

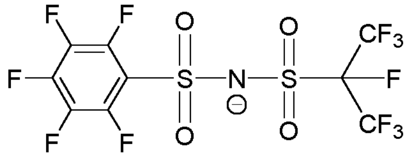,
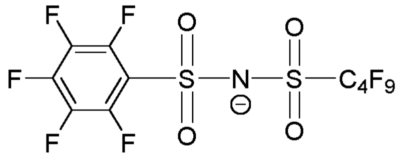,

(G29) (G30)

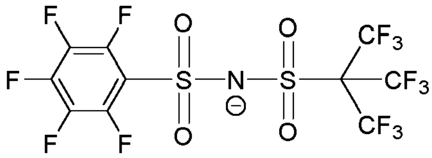,
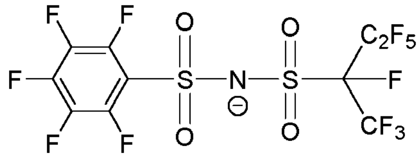,

(G31) (G32)

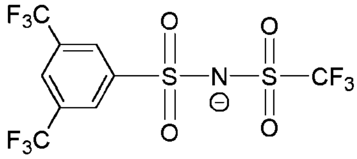,
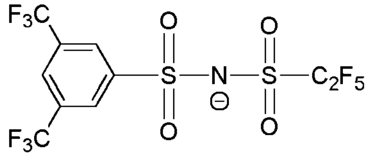,
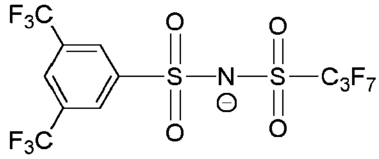,

(G33) (G34) (G35)

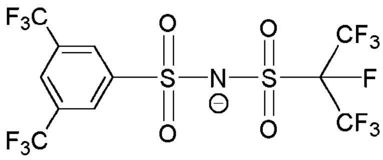,
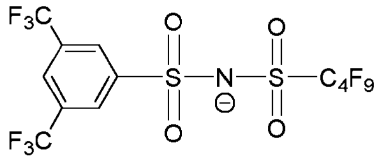,

(G36) (G37)

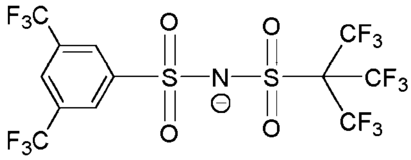,

(G38)

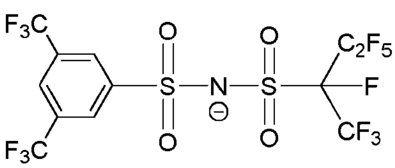,
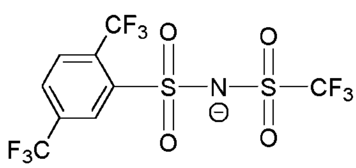,

(G39) (G40)

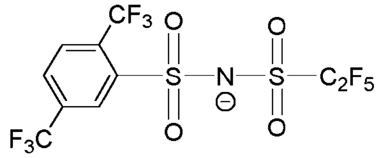
,

(G41)

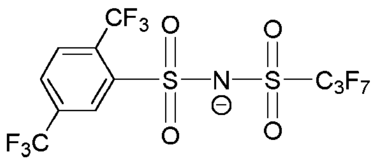
,
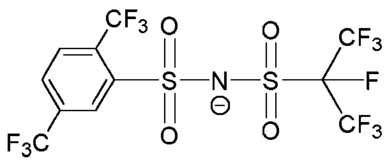
,

(G42) (G43)

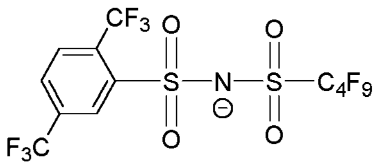
,
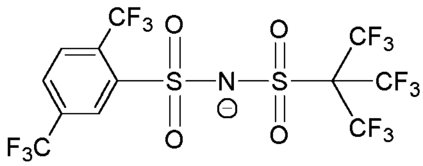

(G44) (G45)

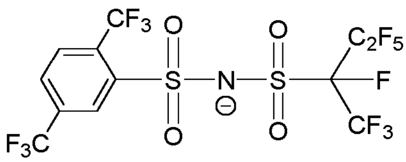
,
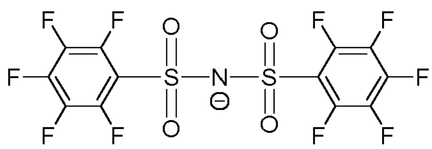

(G46) (G47)

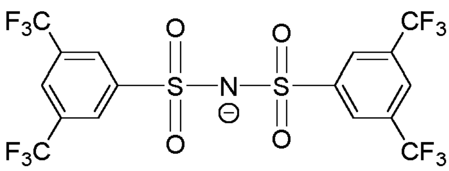
,
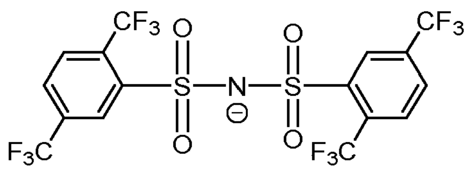

(G48) (G49)

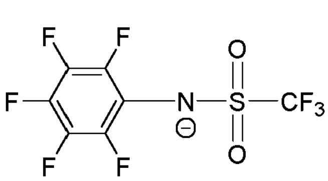
,
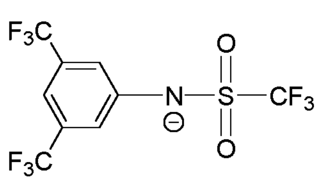
,
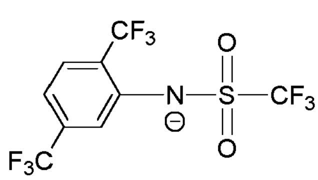
,

(G50) (G51) (G52)

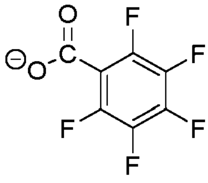, 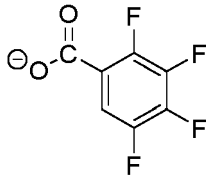, 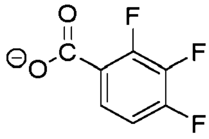, 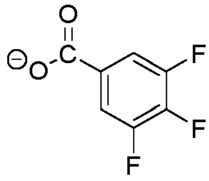,

(G53) (G54) (G55) (G56)

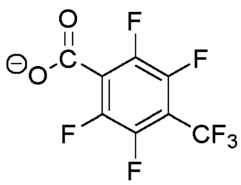 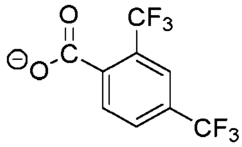, 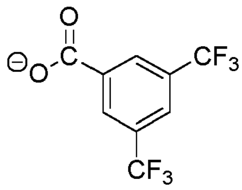,

(G57) (G58) (G59)

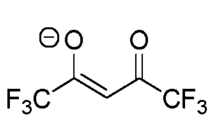, 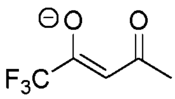, 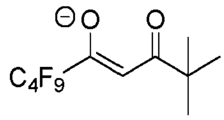

(G60) (G61) (G62).

**18.** Organische elektronische Vorrichtung nach einem der vorhergehenden Ansprüche 1 bis 17, wobei die organische elektronische Vorrichtung ferner mindestens eine photoaktive Schicht umfasst, wobei die photoaktive Schicht zwischen der Lochinjektionsschicht und der Kathodenschicht angeordnet ist.

**19.** Organische elektronische Vorrichtung nach einem der Ansprüche 1 bis 18, wobei es sich bei der mindestens einen photoaktiven Schicht um eine Emissionsschicht handelt.

**20.** Organische elektronische Vorrichtung nach einem der vorhergehenden Ansprüche 1 bis 19, wobei es sich bei der elektronischen Vorrichtung um eine lichtemittierende Vorrichtung, einen Dünnschichttransistor, eine Anzeigevorrichtung oder eine Photovoltaikzelle und vorzugsweise um eine lichtemittierende Vorrichtung und/oder eine Anzeigevorrichtung handelt.

## Revendications

**1.** Dispositif électronique organique comprenant une couche d'anode, une couche de cathode et une couche d'injection de trous, dans lequel la couche d'injection de trous est disposée entre la couche d'anode et la couche de cathode et dans lequel la couche d'injection de trous comprend un composé de transport de trous et un complexe métallique, dans lequel

- le composé de transport de trous a la formule (I) :

$$(Ar^1)_k\text{-}(Ar^2)_m\text{-}Ar^3\text{-}(Ar^4)_p\text{-}(Ar^5)_q\text{-}(Ar^6)_r \qquad (I),$$

k, m, q, r étant indépendamment les uns des autres 0, 1 ou 2,
p étant 1, 2 ou 3,

$$2 \leq k+m+q+r+p \leq 11,$$

$Ar^1$ à $Ar^6$ étant indépendamment choisis parmi un cycle insaturé substitué ou non substitué à 5 à 7 chaînons d'un hétérocycle, un $C_6$ à $C_{30}$ aryle substitué ou non substitué, un $C_3$ à $C_{30}$ hétéroaryle substitué ou non substitué, un fluorène substitué ou non substitué, ou un système cyclique condensé comprenant 2 à 6 cycles

substitués ou non substitués à 5 à 7 chaînons et les cycles étant choisis dans le groupe comprenant (i) un cycle insaturé à 5 à 7 chaînons d'un hétérocycle, (ii) un cycle à 5 à 6 chaînons d'un hétérocycle aromatique, (iii) un cycle insaturé à 5 à 7 chaînons d'un non-hétérocycle, (iv) un cycle à 6 chaînons d'un non-hétérocycle aromatique ;
les substituants étant choisis dans le groupe H, D, $C_1$ à $C_{12}$ alkyle, $C_6$ à $C_{18}$ aryle non substitué, $C_3$ à $C_{18}$ hétéroaryle non substitué, un système cyclique condensé comprenant 2 à 6 cycles non substitués à 5 à 7 chaînons et les cycles étant choisis dans le groupe comprenant un cycle insaturé à 5 à 7 chaînons d'un hétérocycle, un cycle à 5 à 6 chaînons d'un hétérocycle aromatique, un cycle insaturé à 5 à 7 chaînons d'un non-hétérocycle, et un cycle à 6 chaînons d'un non-hétérocycle aromatique ; et

- le complexe métallique ayant la formule (II) :

$$M^{n\oplus}(L^{\ominus})_n \qquad (II),$$

M étant un ion métallique,
n étant la valence de M,
L étant un ligand comprenant au moins deux atomes de carbone,
n étant un entier de 1 à 4 ;
la couche d'injection de trous étant agencée en contact direct avec la couche d'anode ; et la couche d'injection de trous comprenant une première sous-couche constituée par le complexe métallique de formule (II) et une deuxième sous-couche constituée par le composé de transport de trous de formule (I), la première sous-couche étant agencée directement de manière adjacente à la couche d'anode et la deuxième sous-couche étant agencée directement adjacente à la première sous-couche ;
le dispositif électronique organique comprenant en outre une couche de transport de trous, la couche de transport de trous étant agencée entre la couche d'injection de trous et l'au moins une couche photoactive ou au moins une couche d'émission.

**2.** Dispositif électronique organique selon la revendication 1, le niveau HOMO du composé de transport de trous étant plus éloigné du niveau de vide que le niveau HOMO de la N4,N4'''-di(naphtalén-1-yl)-N4,N4'''-diphényl-[1,1':4',1":4",1'''-quaterphényl]-4,4'''-diamine lorsqu'il est déterminé dans les mêmes conditions.

**3.** Dispositif électronique organique selon les revendications 1 ou 2, le composé de transport de trous selon la formule (I) ayant un poids moléculaire Mw de ≥ 400 et ≤ 2 000 g/mole, de préférence un poids moléculaire Mw de ≥ 450 et ≤ 1 500 g/mole, en outre de manière préférée un poids moléculaire Mw de ≥ 500 et ≤ 1 000 g/mole, de plus de manière préférée un poids moléculaire Mw de ≥ 550 et ≤ 900 g/mole, de manière également préférée un poids moléculaire Mw de ≥ 600 et ≤ 800 g/mole.

**4.** Dispositif électronique organique selon l'une quelconque des revendications précédentes 1 à 3, M étant choisi parmi un ion métallique dans lequel le métal correspondant a une valeur d'électronégativité selon Allen inférieure à 2,4, de préférence M étant choisi parmi un métal alcalin, alcalino-terreux, des terres rares ou de transition, en outre de manière préférée M étant choisi parmi un métal ayant une masse atomique ≥ 24 Da, de plus de manière préférée M étant choisi parmi un métal ayant une masse atomique ≥ 24 Da et M ayant un nombre d'oxydation ≥ 2.

**5.** Dispositif électronique organique selon l'une quelconque des revendications précédentes 1 à 4, le complexe métallique ayant un poids moléculaire Mw de ≥ 287 et ≤ 2 000 g/mole, de préférence un poids moléculaire Mw de ≥ 400 et ≤ 1 500 g/mole, en outre de manière préférée un poids moléculaire Mw de ≥ 580 et ≤ 1 500 g/mole, de plus de manière préférée un poids moléculaire Mw de ≥ 580 et ≤ 1 400 g/mole.

**6.** Dispositif électronique organique selon l'une quelconque des revendications précédentes 1 à 5, L étant choisi dans un groupe comprenant

- au moins trois atomes de carbone, en variante au moins quatre atomes de carbone, et/ou
- au moins deux atomes d'oxygène ou un atome d'oxygène et un atome d'azote, deux à quatre atomes d'oxygène, deux à quatre atomes d'oxygène et zéro à deux atomes d'azote, et/ou
- au moins un ou plusieurs groupes choisis parmi halogène, F, CN, $C_1$ à $C_6$ alkyle substitué ou non substitué, $C_1$ à $C_6$ alcoxy substitué ou non substitué, en variante au moins deux groupes choisis parmi halogène, F, CN, $C_1$ à $C_6$

alkyle substitué ou non substitué, $C_1$ à $C_6$ alcoxy substitué ou non substitué, au moins un ou plusieurs groupes choisis parmi halogène, F, CN, $C_1$ à $C_6$ alkyle substitué, $C_1$ à $C_6$ alcoxy substitué, en variante au moins deux groupes choisis parmi halogène, F, CN, $C_1$ à $C_6$ alkyle perfluoré, $C_1$ à $C_6$ alcoxy perfluoré, un ou plusieurs groupes choisis parmi $C_1$ à $C_6$ alkyle substitué ou non substitué, $C_6$ à $C_{12}$ aryle substitué ou non substitué, et/ou $C_3$ à $C_{12}$ hétéroaryle substitué ou non substitué,

les substituants étant choisis parmi D, $C_6$ aryle, $C_3$ à $C_9$ hétéroaryle, $C_1$ à $C_6$ alkyle, $C_1$ à $C_6$ alcoxy, $C_3$ à $C_6$ alkyle ramifié, $C_3$ à $C_6$ alkyle cyclique, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alkyle partiellement ou perdeutéré, $C_1$ à $C_6$ alcoxy partiellement ou perdeutéré, $COR^6$, $COOR^6$, halogène, F ou CN ;
$R^6$ étant choisi parmi $C_6$ aryle, $C_3$ à $C_9$ hétéroaryle, $C_1$ à $C_6$ alkyle, $C_1$ à $C_6$ alcoxy, $C_3$ à $C_6$ alkyle ramifié, $C_3$ à $C_6$ alkyle cyclique, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alkyle partiellement ou perdeutéré, $C_1$ à $C_6$ alcoxy partiellement ou perdeutéré.

**7.** Dispositif électronique organique selon l'une quelconque des revendications précédentes 1 à 6, le complexe métallique selon la formule (II) étant non émissif.

**8.** Dispositif électronique organique selon l'une quelconque des revendications précédentes 1 à 7, le composé de transport de trous de formule (I) comprenant au moins $\geq 1$ à $\leq 6$ systèmes cycliques aromatiques condensés substitués ou non substitués comprenant des cycles hétéroaromatiques et éventuellement au moins $\geq 1$ à $\leq 3$ cycles insaturés substitués ou non substitués à 5 à 7 chaînons d'un hétérocycle, de préférence $\geq 2$ à $\leq 5$ systèmes cycliques aromatiques condensés substitués ou non substitués comprenant des cycles hétéroaromatiques et éventuellement au moins $\geq 1$ à $\leq 3$ cycles insaturés substitués ou non substitués à 5 à 7 chaînons d'un hétérocycle, en outre de manière préférée 3 ou 4 systèmes cycliques aromatiques condensés substitués ou non substitués comprenant des cycles hétéroaromatiques et éventuellement au moins $\geq 1$ à $\leq 3$ cycles insaturés substitués ou non substitués à 5 à 7 chaînons d'un hétérocycle, et de plus de manière préférée les systèmes cycliques aromatiques condensés comprenant des cycles hétéroaromatiques étant non substitués et éventuellement au moins $\geq 1$ à $\leq 3$ cycles insaturés non substitués à 5 à 7 chaînons d'un hétérocycle.

**9.** Dispositif électronique organique selon l'une quelconque des revendications précédentes 1 à 8,

- le composé de transport de trous de formule (I) comprenant un système cyclique aromatique condensé substitué ou non substitué comportant au moins $\geq 2$ à $\leq 6$, de préférence $\geq 3$ à $\leq 5$, ou 4 cycles aromatiques condensés choisis dans le groupe comprenant des cycles non hétéroaromatiques substitués ou non substitués, des cycles hétéro substitués ou non substitués à 5 chaînons, des cycles substitués ou non substitués à 6 chaînons et/ou un cycle insaturé substitué ou non substitué à 5 à 7 chaînons d'un hétérocycle ; ou
- le composé de transport de trous de formule (I) comprenant un système cyclique aromatique condensé non substitué comportant au moins $\geq 2$ à $\leq 6$, de préférence $\geq 3$ à $\leq 5$, ou 4 cycles aromatiques condensés choisis dans le groupe comprenant des cycles non hétéroaromatiques substitués, des cycles hétéro non substitués à 5 chaînons, des cycles non substitués à 6 chaînons et/ou un cycle insaturé non substitué à 5 à 7 chaînons d'un hétérocycle.

**10.** Dispositif électronique organique selon l'une quelconque des revendications précédentes 1 à 9, dans lequel le composé de transport de trous de formule (I) comprend au moins $\geq 1$ à $\leq 6$, de préférence $\geq 2$ à $\leq 5$, ou en outre préférablement 3 ou 4 parmi les systèmes cycliques condensés aromatiques substitués ou non substitués comportant :

- au moins un cycle insaturé à 5 chaînons, et/ou
- au moins un cycle insaturé à 6 chaînons, et/ou
- au moins un cycle insaturé à 7 chaînons ; de préférence au moins un cycle insaturé à 5 chaînons et/ou au moins un cycle insaturé à 7 chaînons comprenant au moins 1 à 3 hétéroatomes, de préférence 1.

**11.** Dispositif électronique organique selon l'une quelconque des revendications précédentes 1 à 10, le composé de transport de trous de formule (I) comprenant :

- au moins $\geq 6$ à $\leq 12$, de préférence $\geq 7$ à $\leq 11$, en outre de manière préférée $\geq 8$ à $\leq 10$ ou 9 cycles aromatiques ; et/ou

- au moins ≥ 4 à ≤ 11, de préférence ≥ 5 à ≤ 10, en outre de manière préférée ≥ 6 à ≤ 9 ou de plus de manière préférée 7 ou 8 cycles non hétéroaromatiques, de préférence les cycles non hétéroaromatiques étant des cycles aromatiques en $C_6$ ; et/ou
- au moins ≥ 1 à ≤ 4, de préférence 2 ou 3 cycles aromatiques à 5 chaînons, de préférence des cycles hétéroaromatiques à 5 chaînons ; et/ou
- au moins 1 ou 2 cycles insaturés à 5 à 7 chaînons d'un hétérocycle, de préférence au moins 1 ou 2 cycles insaturés à 7 chaînons d'un hétérocycle ;
- au moins ≥ 6 à ≤ 12, de préférence ≥ 7 à ≤ 11, en outre de manière préférée ≥ 8 à ≤ 10 ou 9 cycles aromatiques, parmi lesquels

  au moins ≥ 4 à ≤ 11, de préférence ≥ 5 à ≤ 10, en outre de manière préférée ≥ 6 à ≤ 9 ou de plus de manière préférée 7 ou 8 étant des cycles non hétéroaromatiques, et
  au moins ≥ 1 à ≤ 4, de préférence 2 ou 3 cycles aromatiques étant des cycles hétéroaromatiques, le nombre total de cycles non hétéroaromatiques et de cycles hétéroaromatiques ne dépassant pas 12 cycles aromatiques ; et/ou

- au moins ≥ 6 à ≤ 12, de préférence ≥ 7 à ≤ 11, en outre de manière préférée ≥ 8 à ≤ 10 ou 9 cycles aromatiques, parmi lesquels

  au moins ≥ 4 à ≤ 11, de préférence ≥ 5 à ≤ 10, en outre de manière préférée ≥ 6 à ≤ 9 ou de plus de manière préférée 7 ou 8 étant des cycles non hétéroaromatiques, et
  au moins ≥ 1 à ≤ 4, de préférence 2 ou 3 cycles aromatiques étant des cycles hétéroaromatiques, le nombre total de cycles non hétéroaromatiques et de cycles hétéroaromatiques ne dépassant pas 12 cycles aromatiques ; et
  le composé de transport de trous ou le composé de transport de trous selon la formule I comprenant au moins ≥ 1 à ≤ 4, de préférence 2 ou 3 cycles aromatiques à 5 chaînons, de préférence des cycles hétéroaromatiques à 5 chaînons, et/ou
  le composé de transport de trous ou le composé de transport de trous selon la formule (I) comprenant au moins 1 ou 2 cycles insaturés à 5 à 7 chaînons d'un hétérocycle, de préférence au moins 1 ou 2 cycles insaturés à 7 chaînons d'un hétérocycle.

**12.** Dispositif électronique organique selon l'une quelconque des revendications précédentes 1 à 11, pour la formule (I) :

- $Ar^3$ étant choisi parmi D1 à D17, de préférence D1 à D6 et D16 :

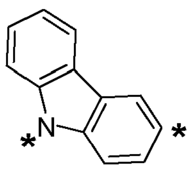 (D1), 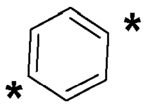 (D2), 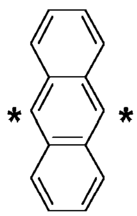 (D3), 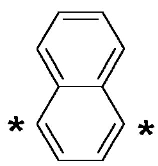 (D4), 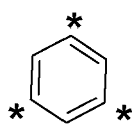 (D5), 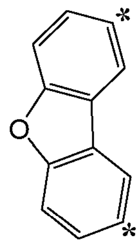 (D6);

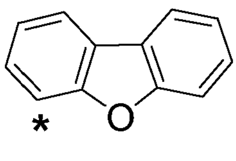 (D7), 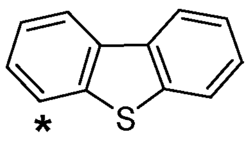 (D8), 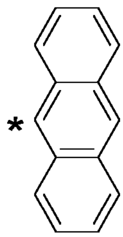 (D9), 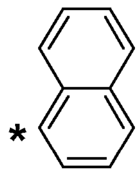 (D10);

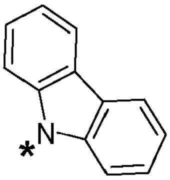 (D11), 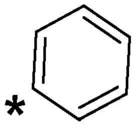 (D12), 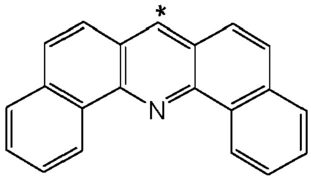 (D13), 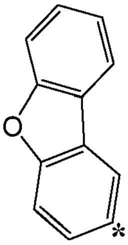 (D14)

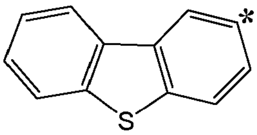 (D15), 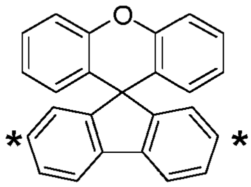 (D16), 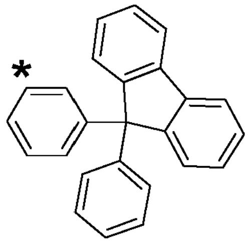 (D17);

$Ar^1$ étant choisi parmi D7 à D15 et D17, si m > 0 et k > 0, ou étant choisi parmi D7 à D15 et D17, si k > 0 et m = 0, ou étant choisi parmi D1 à D6, si k > 1 ;
$Ar^2$ étant choisi parmi D1 à D6, si m > 0 et k > 0 ; ou étant choisi parmi D7 à D15 et D17, si m > 0 et k = 0 ;
$Ar^4$ étant choisi parmi D1 à D6, si q > 0, ou étant choisi parmi D1 à D6, si q = 0 et r > 0 ; ou étant choisi parmi D7 à D15 et D17, si q et r = 0 ;
$Ar^5$ étant choisi parmi D1 à D6, si q > 0 et r > 0, ou étant choisi parmi D7 à D15 et D17, si q > 0 et r = 0 ;
$Ar^6$ étant choisi parmi D7 à D15 et D17, si r > 0, q > 0, ou étant choisi parmi D7 à D15 et D17, si r > 0, q = 0, ou étant choisi parmi D1 à D6, si r > 1.

**13.** Dispositif électronique organique selon l'une quelconque des revendications précédentes 1 à 12, le composé de transport de trous selon la formule (I) étant choisi parmi F1 à F13.

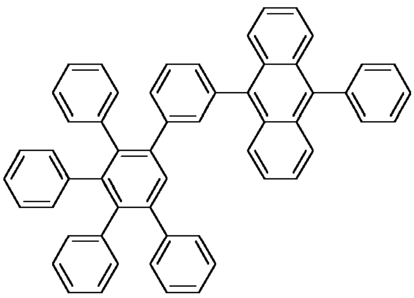 (F1), 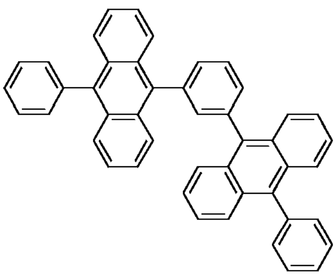 (F2),

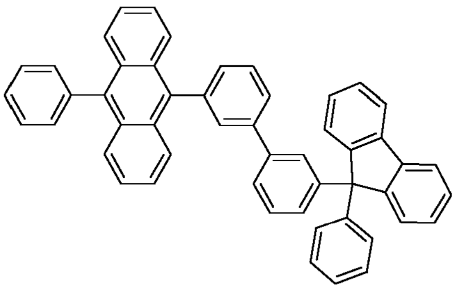 (F3), 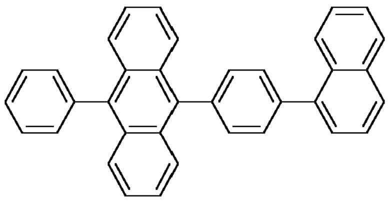 (F4),

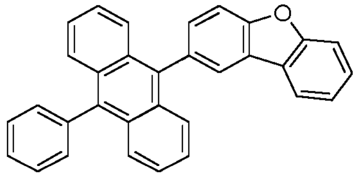 (F5), 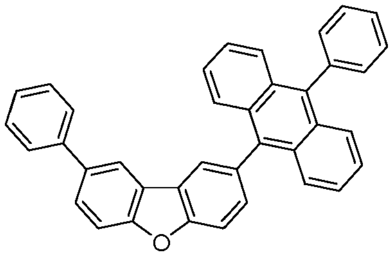 (F6),

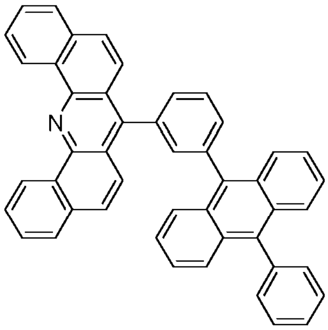 (F7), 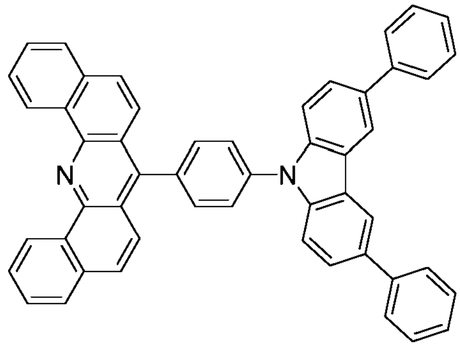 (F8),

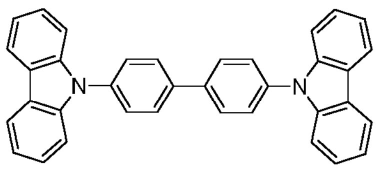 (F9), 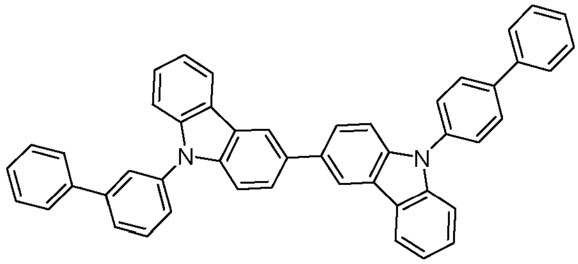 (F10),

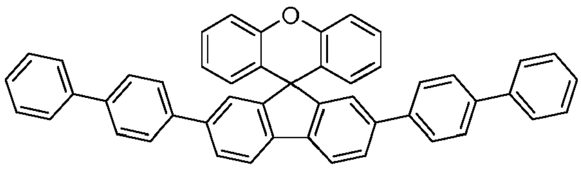 (F11),

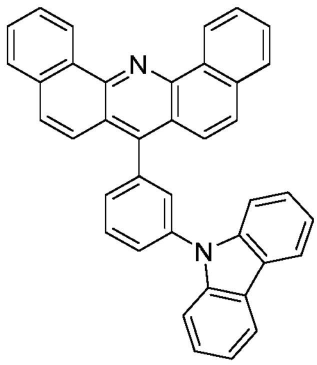 (F12), 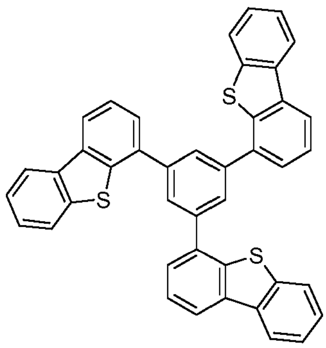 (F13).

**14.** Dispositif électronique organique selon l'une quelconque des revendications précédentes 1 à 13, n étant un entier de 1 à 4, de préférence 1 à 3, de manière également préférée 2 ou 3.

**15.** Dispositif électronique organique selon l'une quelconque des revendications précédentes 1 à 14, le complexe métallique pouvant être choisi parmi les formules (IIa) à (IId) suivantes :

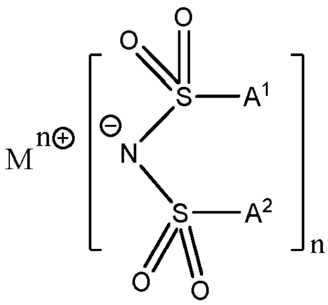 (IIa), 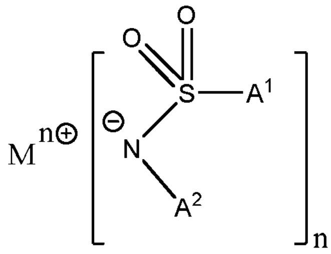 (IIb),

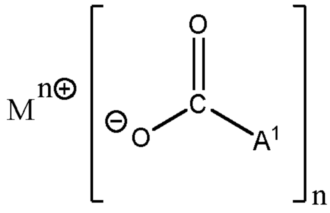 (IIc), 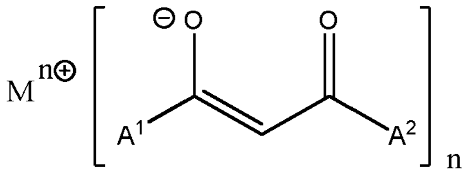 (IId),

M étant un ion métallique ;
n étant la valence de M ;
$A^1$ et $A^2$ étant indépendamment choisis parmi $C_1$ à $C_{12}$ alkyle substitué ou non substitué, $C_6$ à $C_{12}$ aryle substitué ou non substitué, $C_3$ à $C_{12}$ hétéroaryle substitué ou non substitué ;
les substituants de $A^1$ et $A^2$ étant indépendamment choisis parmi D, $C_6$ aryle, $C_3$ à $C_9$ hétéroaryle, $C_1$ à $C_6$ alkyle, $C_1$ à $C_6$ alcoxy, $C_3$ à $C_6$ alkyle ramifié, $C_3$ à $C_6$ alkyle cyclique, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alkyle partiellement ou perdeutéré, $C_1$ à $C_6$ alcoxy partiellement ou perdeutéré, $COR^1$, $COOR^1$, halogène, F ou CN,
$R^1$ étant choisi parmi $C_6$ aryle, $C_3$ à $C_9$ hétéroaryle, $C_1$ à $C_6$ alkyle, $C_1$ à $C_6$ alcoxy, $C_3$ à $C_6$ alkyle ramifié, $C_3$ à $C_6$ alkyle cyclique, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alkyle partiellement ou perdeutéré, $C_1$ à $C_6$ alcoxy partiellement ou perdeutéré.

**16.** Dispositif électronique organique selon la revendication 15, au moins l'un parmi $A^1$ et $A^2$ comprenant un substituant, au moins l'un des substituants de $A^1$ et $A^2$ étant indépendamment choisi parmi $C_3$ à $C_9$ hétéroaryle, $C_1$ à $C_6$ alcoxy, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alcoxy partiellement ou perdeutéré, $COR^1$, $COOR^1$, halogène, F ou CN ; de préférence au moins l'un parmi $A^1$ et $A^2$ comprenant au moins deux substituants, les substituants sur $A^1$ et $A^2$ étant indépendamment choisis parmi $C_3$ à $C_9$ hétéroaryle, $C_1$ à $C_6$ alcoxy, $C_3$ à $C_6$ alcoxy ramifié, $C_3$ à $C_6$ alcoxy cyclique, $C_1$ à $C_{16}$ alkyle partiellement ou perfluoré, $C_1$ à $C_{16}$ alcoxy partiellement ou perfluoré, $C_1$ à $C_6$ alcoxy partiellement ou perdeutéré, $COR^1$, $COOR^1$, halogène, F ou CN ; et en outre de manière préférée $A^1$ et $A^2$ comprenant au moins un substituant indépendamment choisi parmi halogène, F, $CF_3$, $C_2F_5$, $C_3F_7$, $C_4F_9$, $OCF_3$, $OC_2F_5$, ou CN ; et de plus de manière préférée $A^1$ et $A^2$ comprenant au moins deux substituants indépendamment choisis parmi halogène, F, $CF_3$, $C_2F_5$, $C_3F_7$, $C_4F_9$, $OCF_3$, $OC_2F_5$ ou CN.

**17.** Dispositif électronique organique selon l'une quelconque des revendications précédentes 1 à 16, L étant indépendamment choisi parmi G1 à G62.

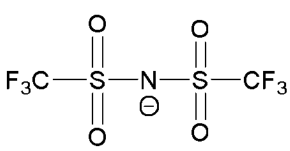 ,
(G1)

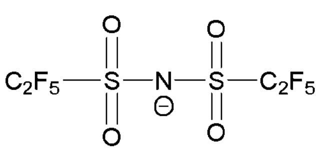 ,
(G2)

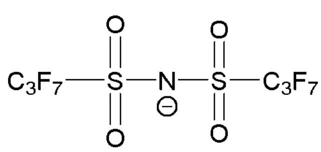 ,
(G3)

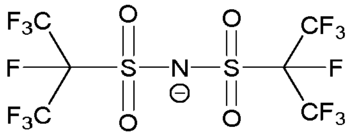
,
(G4)

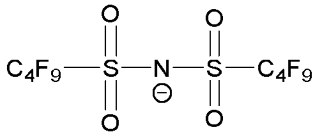
,
(G5)

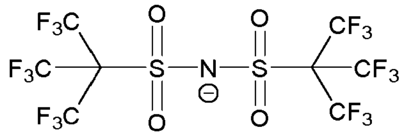
,
(G6)

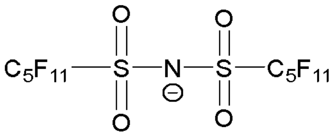
,
(G7)

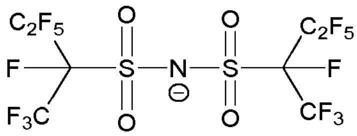
,
(G8)

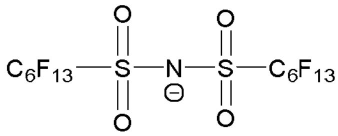
,
(G9)

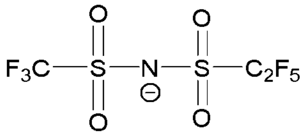
,
(G10)

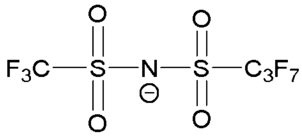
,
(G11)

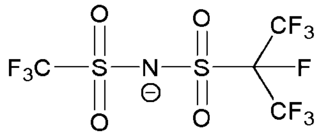
,
(G12)

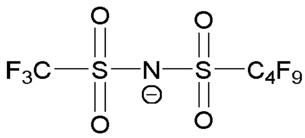
,
(G13)

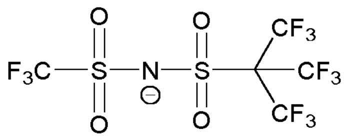
,
(G14)

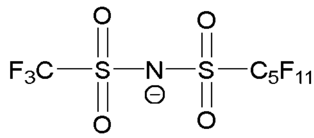
,
(G15)

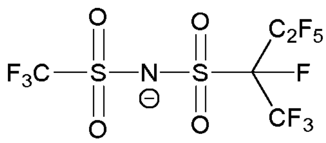
,
(G16)

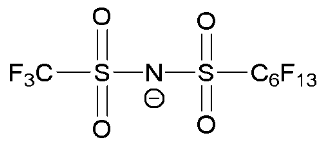
,
(G17)

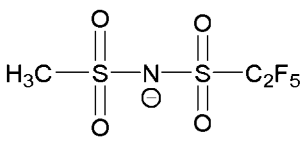
,
(G18)

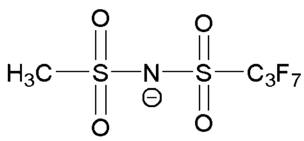
,
(G19)

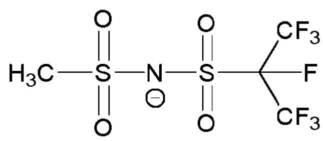
,
(G20)

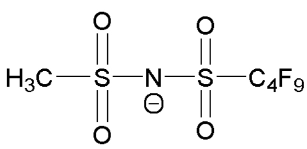
,
(G21)

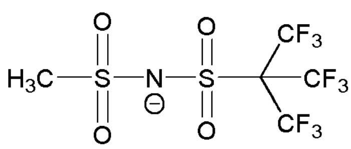
,
(G22)

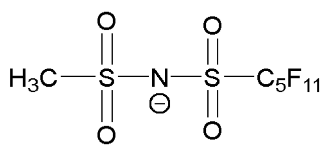
,
(G23)

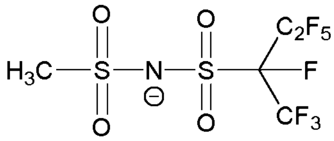,

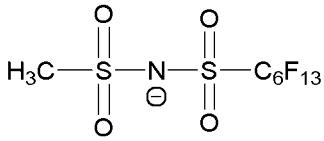,

(G24) (G25)

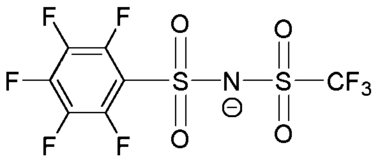,

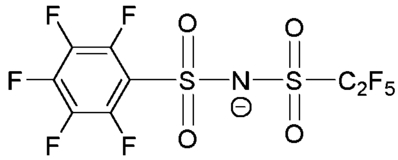,

(G26) (G27)

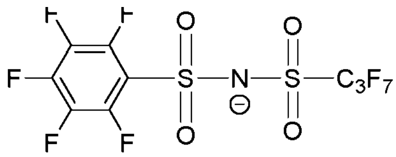,

(G28)

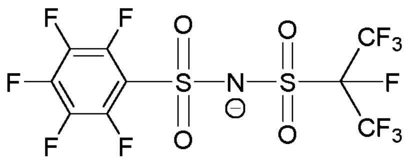,

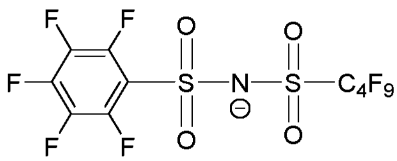,

(G29) (G30)

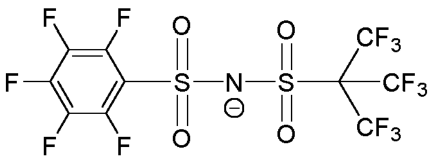,

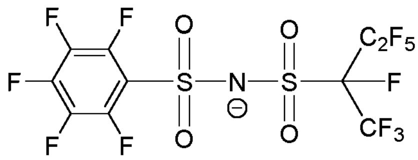,

(G31) (G32)

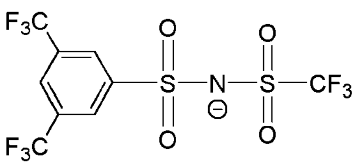,

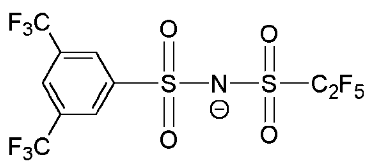,

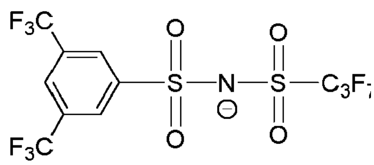

(G33) (G34) (G35)

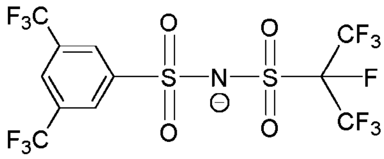, 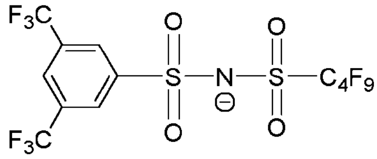,

(G36) (G37)

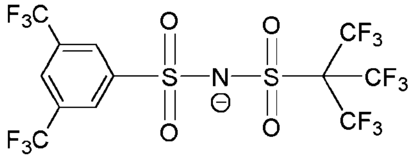,

(G38)

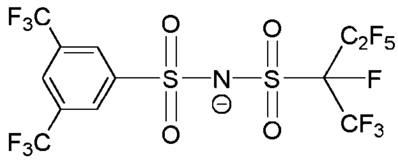, 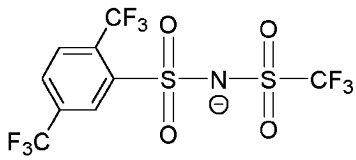,

(G39) (G40)

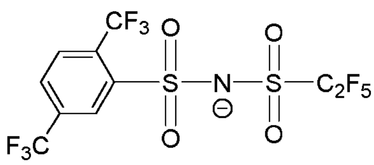,

(G41)

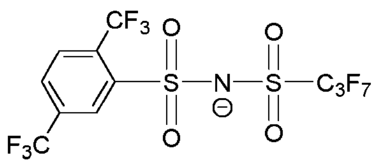, 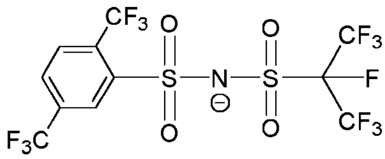,

(G42) (G43)

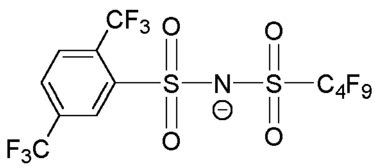, 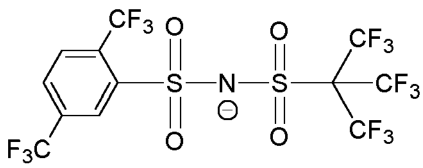

(G44) (G45)

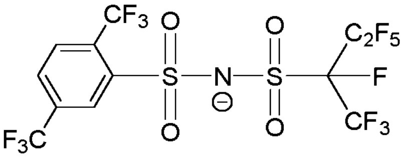 , 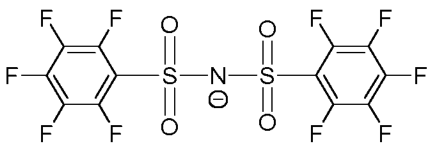

(G46) (G47)

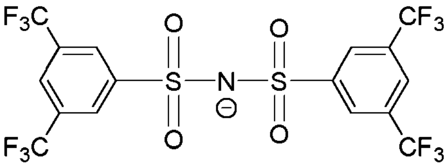 , 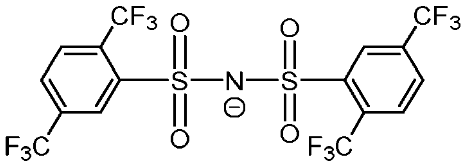

(G48) (G49)

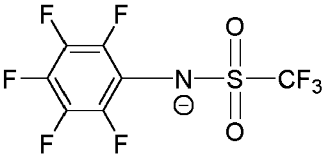 , 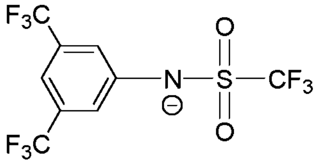 , 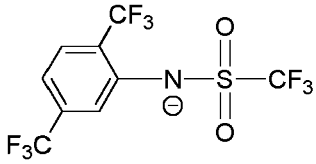 ,

(G50) (G51) (G52)

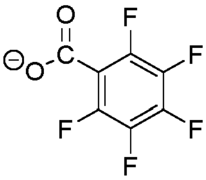 , 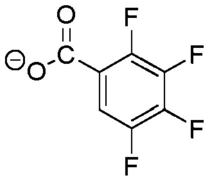 , 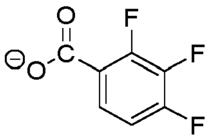 , 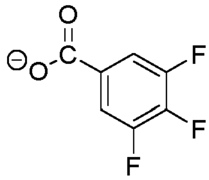 ,

(G53) (G54) (G55) (G56)

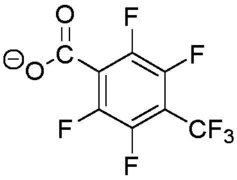 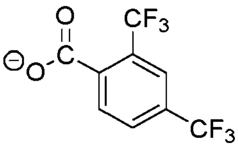 , 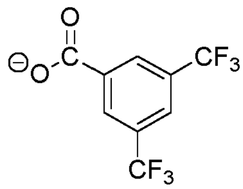 ,

(G57) (G58) (G59)

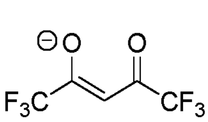 , 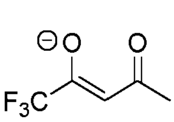 , 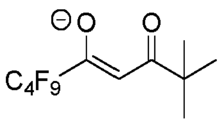

(G60) (G61) (G62).

**18.** Dispositif électronique organique selon l'une quelconque des revendications précédentes 1 à 17, le dispositif électronique organique comprenant en outre au moins une couche photoactive, la couche photoactive étant agencée entre la couche d'injection de trous et la couche de cathode.

**19.** Dispositif électronique organique selon l'une quelconque des revendications précédentes 1 à 18, l'au moins une couche photoactive étant une couche d'émission.

**20.** Dispositif électronique organique selon l'une quelconque des revendications précédentes 1 à 19, le dispositif électronique étant un dispositif émetteur de lumière, un transistor en film mince, un dispositif d'affichage ou une cellule photovoltaïque, et de préférence un dispositif émetteur de lumière et/ou un dispositif d'affichage.

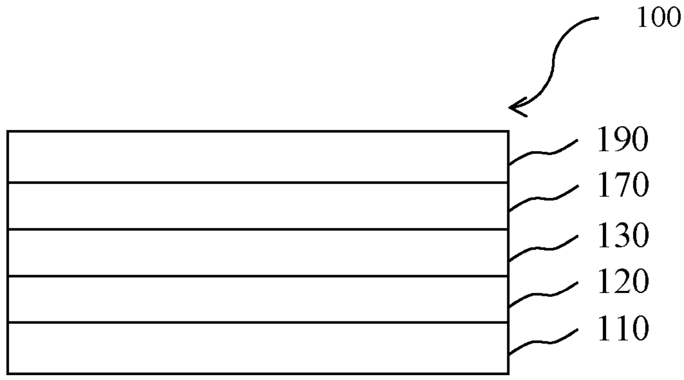


Fig.1

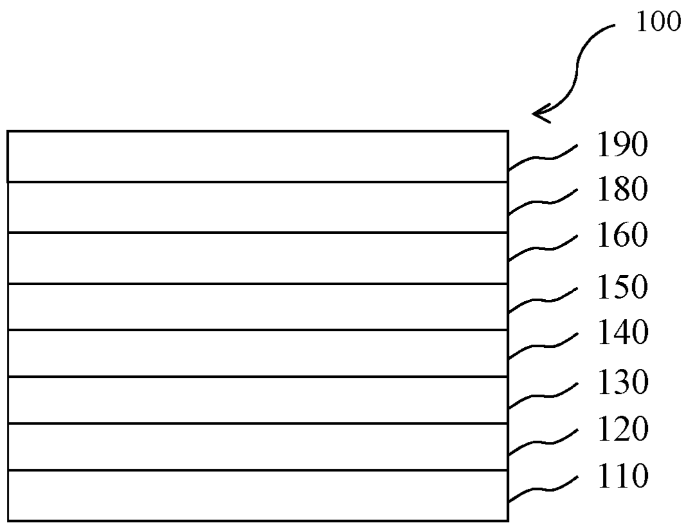


Fig.2

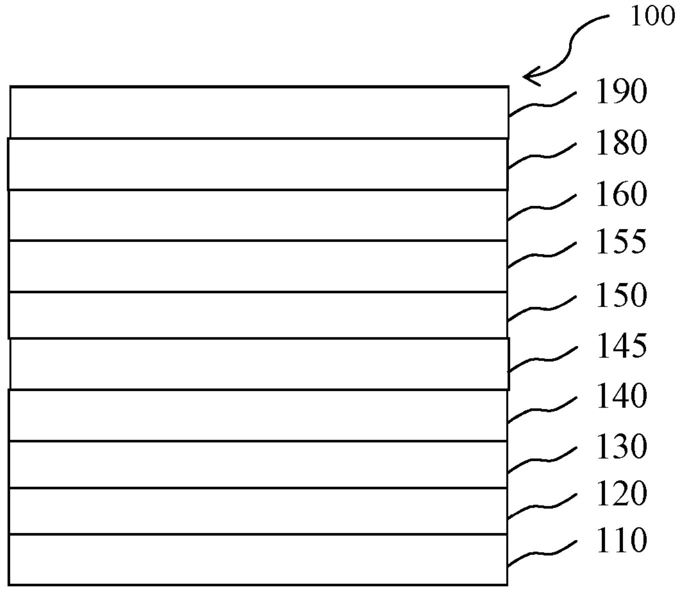


Fig.3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2018240995 A1
- WO 2017178473 A1
- WO 2017029370 A1
- DE 102008051737 A1
- DE 102006054524 A1
- WO 2008154914 A1
- WO 2017029370 A
- WO 2017029366 A
- WO 2017102861 A


### Non-patent literature cited in the description


- **CHAO CAI et al.** High-efficiency red, green and blue phosphorescent homojunction organic light-emitting diodes based on bipolar host materials. *ORGANIC ELECTRONICS*, 01 May 2011, vol. 12 (5), ISSN 1566-1199, 843-850
- Charge Carrier Transporting Molecular Materials and Their Applications in Devices. **YASUHIKO SHIROTA** ; **HIROSHI KAGEYAMA**. CHEMICAL REVIEWS. AMERICAN CHEMICAL SOCIETY, 01 April 2007, vol. 107, 953-1010
- Major Classes of Organic Small Molecules for Electronics and Optoelectronics. **MENG XIANLE et al.** Introduction to Organic Electronic and Optoelectronic Materials and Devices. CRC Press, 01 January 2017, 166-169
- *CHEMICAL ABSTRACTS*, 139255-16-6
- *CHEMICAL ABSTRACTS*, 650609-47-5
- **ALLEN, LELAND C.** Electronegativity is the average one-electron energy of the valence-shell electrons in ground-state free atoms. *Journal of the American Chemical Society*, 1989, vol. 111 (25), 9003-9014
- *CHEMICAL ABSTRACTS*, 1198399-61-9